(19) Europäisches Patentamt
European Patent Office
Office européen des brevets

(11) EP 0 686 308 B1

(12) **EUROPEAN PATENT SPECIFICATION**

(45) Date of publication and mention
of the grant of the patent:
**16.01.2002 Bulletin 2002/03**

(51) Int Cl.7: **H01L 29/772**, H01L 29/10

(21) Application number: **94909764.6**

(22) Date of filing: **14.02.1994**

(86) International application number:
**PCT/US94/01931**

(87) International publication number:
**WO 94/19830 (01.09.1994 Gazette 1994/20)**

(54) **HIGH SATURATION CURRENT, LOW LEAKAGE CURRENT FERMI THRESHOLD FIELD EFFECT TRANSISTOR**

FERMI-SCHWELLENSPANNUNGS-FELDEFFEKTTRANSISTOR MIT HOHEM SÄTTIGUNGSSTROM UND NIEDRIGEM LECKSTROM

TRANSISTOR A EFFET DE CHAMP A SEUIL DE FERMI, A COURANT DE SATURATION ELEVE ET A COURANT DE FUITE FAIBLE

(84) Designated Contracting States:
**DE FR GB IE IT NL**

(30) Priority: **23.02.1993 US 37636**
**21.04.1993 US 50852**
**05.01.1994 US 177847**

(43) Date of publication of application:
**13.12.1995 Bulletin 1995/50**

(73) Proprietor: **THUNDERBIRD TECHNOLOGIES, INC.**
**Research Triangle Park, NC 27709-3739 (US)**

(72) Inventors:
• **VINAL, Albert, W.**
**Cary, NC 27511 (US)**
• **DENNEN, Michael, W.**
**Raleigh, NC 27615 (US)**

(74) Representative: **Warren, Keith Stanley et al**
**BARON & WARREN 18 South End Kensington**
**London W8 5BU (GB)**

(56) References cited:
EP-A- 0 137 564          EP-A- 0 234 152
EP-A- 0 422 901          WO-A-93/15524
DE-A- 3 138 747          US-A- 4 931 850
US-A- 4 984 043          US-A- 5 194 923

• PATENT ABSTRACTS OF JAPAN vol. 13, no. 280 (E-779)27 June 1989 & JP,A,01 067 967 (HITACHI LTD) 14 March 1989
• PATENT ABSTRACTS OF JAPAN vol. 16, no. 521 (E-1285)27 October 1992 & JP,A,04 196 170 (FUJITSU LTD) 15 July 1992
• TECHNICAL DIGEST OF THE 1974 INTERNATIONAL ELECTRON DEVICES MEETING DECEMBER 9, 10, AND 11, 1974 WASHINGTON, D.C. pages 541 - 545 W. SANSEN ET AL 'MODEL AND LINEAR APPLICATIONS OF THE JIGFET (Junction and Insulated Gate Field-Effect Transistor)'

**Description**

Field of the Invention

This invention relates to field effect transistor devices and more particularly to integrated circuit field effect transistors which are capable of producing high currents and low leakage currents.

Background of the Invention

Field effect transistors (FET) have become the dominant active device for very large scale integration (VLSI) and ultra large scale integration (ULSI) applications, such as logic devices, memory devices and microprocessors, because the integrated circuit FET is by nature a high impedance, high density, low power device. Much research and development activity has focused on improving the speed and integration density of FETs, and on lowering the power consumption thereof.

A high speed, high performance field effect transistor is described in U.S.-A-4,984,043 and 4,990,974. These patents describe a metal oxide semiconductor field effect transistor (MOSFET) which operates in the enhancement mode without requiring inversion, by setting the device's threshold voltage to twice the Fermi potential of the semiconductor material. As is well known to those having skill in the art, Fermi potential is defined as that potential for which an energy state in a semiconductor material has a probability of one-half of being occupied by an electron. As described in the above mentioned patents, when the threshold voltage is set to twice the Fermi potential, the dependence of the threshold voltage on oxide thickness, channel length, drain voltage and substrate doping is substantially eliminated. Moreover, when the threshold voltage is set to twice the Fermi potential, the vertical electric field at the substrate face between the oxide and channel is minimized and is, in fact, substantially zero. Carrier mobility in the channel is thereby maximized, leading to a high speed device with greatly reduced hot electron effects. Device performance is substantially independent of device dimensions.

Notwithstanding the vast improvement of the Fermi threshold FET compared to known FET devices, there was a need to lower the capacitance of the Fermi-FET device. Accordingly, in U.S.-A-5,194,923, and 5,369,295, a Fermi-FET device is described which allows conduction carriers to flow within the channel at a predetermined depth in the substrate below the gate, without requiring an inversion layer to be created at the surface of the semiconductor in order to support carrier conduction. Accordingly, the average depth of the channel charge requires inclusion of the permittivity of the substrate as part of the gate capacitance. Gate capacitance is thereby substantially reduced.

As described in the aforesaid patents, the low capacitance Fermi-FET is preferably implemented using a Fermi-tub region having a predetermined depth and a conductivity type opposite the substrate conductivity type and the same conductivity type as the drain and source. The Fermi-tub extends downward from the substrate surface by a predetermined depth, and the drain and source diffusions are formed in the Fermi-tub within the tub boundaries. The Fermi-tub forms a unijunction transistor, in which the source, drain, channel and Fermi-tub are all doped the same conductivity type, but at different doping concentrations. A low capacitance Fermi-FET is thereby provided. The low capacitance Fermi-FET including the Fermi-tub will be referred to herein as a "low capacitance Fermi-FET" or a "Tub-FET".

German patent specification DE 3 138 747 A1 describes a depletion-mode FET having a depletion region between the source region and drain region, which depletion region is of the same conductivity type as the latter, and additional semiconductor regions between the source region and the drain region, which additional regions are of the same conductivity type as the latter and form a common, flat p-n junction with the substrate.

US patent 4 931 850 describes a punch-through free, and hot carrier free non saturation characteristic insulated gate type static induction transistor. It basically comprises high concentration source and drain regions of one conductivity type formed in a low concentration channel region of the same conductivity type, and a region of the opposite conductivity type is formed to surround the low concentration channel region.

Notwithstanding the vast improvement of the Fermi-FET and the low capacitance Fermi-FET compared to known FET devices, there is a continuing need to increase the saturation current per unit channel width which is produced by the Fermi-FET device. Higher current Fermi-FET devices will allow even greater integration density, and/ or much higher speeds for logic devices, memory devices, microprocessors and other integrated circuit devices. However, saturation current must not be obtained at the expense of high leakage current. High leakage current dramatically increases the idle power consumption of the device. Finally, as portable and laptop computers proliferate, it is desirable to lower the threshold voltage of a Fermi-FET transistor, without adversely impacting operation thereof. Lower threshold voltage devices are better able to operate with 3 volt or lower power supplies, which are increasingly being used for portable and other energy conscious applications.

It is an object of the invention to provide a Fermi-FET which is capable of producing very high current per unit channel width. It is another object to provide a Fermi-FET which is capable of producing very high current per unit channel width, with very low leakage current.

The present invention consists in a Fermi threshold field effect transistor which operates in the enhancement mode, comprising:

a semiconductor substrate of first conductivity type; spaced apart source and drain regions of a second conductivity type in said substrate at a surface thereof;

a source injector region of said second conductivity. type adjacent said source region and facing said drain region;

a gate insulating layer on the substrate at said substrate surface between the spaced apart source and drain regions;

source, drain and gate electrodes contacting the source and drain regions and the gate insulating layer, respectively; and

a channel of said second conductivity type at said substrate surface between the source and drain regions for allowing carriers of said second conductivity type to flow from said source region to said drain region, said channel having a first predetermined depth from said substrate surface selected to produce zero static electric field perpendicular to said substrate surface at said first predetermined depth upon application of the threshold voltage of the field effect transistor to the gate electrode; characterised by

a tub region of second conductivity type in said substrate at said substrate surface and containing the source and drain regions and the channel;

said tub region being doped at a relatively low doping concentration, said source region being doped at a relatively higher doping concentration and said source injector region being doped at an intermediate doping concentration between that of said tub region and said source region; and

said tub region extending a second predetermined depth from said channel and at least the sum of said first and second predetermined depths being such as to allow the carriers of said second conductivity type to flow from the source region to the drain region in the channel without creating an inversion layer in the tub region, upon application of voltage to the gate electrode beyond the threshold voltage of the field effect transistor.

The source and drain regions may be doped the second conductivity type at a predetermined concentration facing the channel which is sufficiently high to maximize the saturation current of the Fermi-FET. It has been found that stored free charge at the source drain-channel interface limits the amount of saturation current of the Fermi-FET. Accordingly, a predetermined minimum doping concentration of the source and drain facing the channel is provided to maximize the saturation current of the field effect transistor. Doping beyond this predetermined concentration will not significantly increase the saturation current of the field effect transistor. The predetermined concentration $N_{do_{min}}$ of the source and/or drain which maximizes the saturation current is given by:

$$N_{do_{min}} = \frac{1}{2\,e_s \phi_x q} \left[ \frac{e_s e_i L_o (V_{g_{max}} - V_t)}{Y_f (2\,e_s T_{ox} + \delta e_i)} \right]^2$$

Where:

$E_g$ = Permittivity of substrate
$\phi_x$ = Flat band voltage between source/drain diffusion doping and channel doping
$q$ = $1.6 \times 10^{-19}$ coulomb
$e_i$ = Permittivity of the gate insulator
$L_o$ = Channel length
$V_{g_{max}}$ = Maximum gate voltage anticipated
$V_t$ = Threshold voltage
$Y_f$ = Depth of the Fermi-channel adjacent the source and drain regions
$T_{ox}$ = Insulator thickness
$\delta$ = Flow depth of excess carriers in the channel

In order to supply the high saturation current described above, the substrate doping concentration is greater than the tub doping concentration, preferably by a factor of at least four, to minimize substrate doping concentration from effecting the criteria required for tub depth and doping to achieve zero perpendicular field across the Fermi-channel.

A Fermi-FET according to the present invention may provide high saturation currents without adversely increasing the leakage current of the Fermi-FET. For example, a Fermi-FET having a gate insulator thickness of less than 120 Angstroms and a channel length of less than about 1 micron can provide a P-channel saturation current of at least 4 amperes per centimeter and an N-channel saturation current of at least 7 amperes per centimeter, with a leakage current of less than 10 picoamperes per micron using power supplies of between 0 and 5 volts. This performance cannot be achieved by a conventional MOSFET of surface channel or buried channel type, wherein significant static electric field is produced in the channel perpendicular to the substrate surface.

The threshold voltage of a Fermi-FET may be lowered from twice the Fermi potential of the substrate, while still maintaining zero static electric field in the channel perpendicular to the substrate, by maintaining a predetermined channel depth, preferably about 600 Angstroms, and increasing the doping concentration of the channel to lower the threshold voltage to below twice the Fermi potential. The channel doping may be lowered to produce a desired threshold voltage according to the following relationship:

$$\Delta V_T = -qN_{ch}Y_f\left(\frac{Y_f}{2e_s} + \frac{T_{ox}}{e_i}\right)$$

Where:

$\Delta V_T$ =     Change in threshold voltage from twice the Fermi potential of the substrate
$q$ =     $1.6 \times 10^{-19}$ coulomb
$T_{ox}$ =     oxide insulator thickness
$N_{ch}$ =     Impurity concentration in the channel
$Y_f$ =     Depth of the Fermi-channel adjacent the source and drain regions
$e_s$ =     Permittivity of substrate
$e_i$ =     Permittivity of the gate insulator

The channel concentration should be maintained at less than about $5 \times 10^{16}$ so as to prevent carrier mobility from dropping and thereby lowering saturation current.

The above described aspects may be used in combination in order to obtain a Fermi-FET with independently controlled saturation current and threshold voltage. In particular, for a given channel depth, preferably on the order of 600 Angstroms, the source/drain doping concentration may be varied to independently control the maximum saturation current of the device, while the channel doping concentration may be varied to independently control the threshold voltage of the device. Thus, independent control of saturation current and threshold voltage in a Fermi-FET may be obtained.

As described above, a high current Fermi-FET is capable of producing a drain saturation current of at least 4 amperes per centimeter of channel width (P-channel) and 7 amperes per centimeter of channel width (N-channel) at a leakage current of less than 10 picoamperes per micron of channel width for channel lengths less than 1 micron and gate insulating layer thicknesses of less than about 120 Angstroms. These values cannot be achieved in a conventional MOSFET which includes electric fields which are oriented perpendicular to the channel carrier flow direction. A detailed comparison of a Fermi-FET and a conventional MOSFET has revealed that saturation velocity is a vector quantity which is governed by the electric field parallel to the substrate, in the carrier flow direction, and also the electric field which is perpendicular to the substrate and perpendicular to the carrier flow direction. Since the Fermi-FET eliminates the vertical (perpendicular) component, saturation current is maximized compared to a conventional MOSFET. In a conventional MOSFET, saturation current can be increased, but at the expense of unacceptably high leakage current. Only the Fermi-FET can produce a Fermi-FET transistor with high saturation current and acceptably low leakage current.

According to the present invention, the injector region is doped at a doping level which is intermediate to the relatively low doping concentration of the Fermi-tub and the relatively high doping concentration of the source. The injector region controls the depth of the carriers injected into the channel and enhances injection of carriers in the channel at a predetermined depth below the gate.

Preferably, the source injector region is a source injector tub region which surrounds the source region. In other words, the source injector tub region is formed within the Fermi-tub region, and the source is preferably formed within the source injector tub region. Similarly, a drain injector tub region may also be formed within the Fermi-tub region and the drain region is preferably formed within the drain injector tub. The source region and drain regions may also extend deeper into the substrate than the respective source injector tub region and drain injector tub region. The source injector tub region and drain injector tub region are of the same conductivity type as the source, drain and Fermi-tub, and are preferably doped at a concentration which is intermediate to that of the Fermi-tub and the source and drain regions.

According to another feature of the invention, lower pinch-off voltage and increased saturation current are obtained by providing a gate sidewall spacer which extends from adjacent the source injector region to adjacent the gate electrode of the Fermi-FET. The gate sidewall spacer preferably comprises an insulator having permittivity which is greater than the permittivity of the gate insulating layer. For example, in typical field effect transistor devices, where the gate insulator is silicon dioxide, the gate sidewall spacer is preferably silicon nitride. The gate sidewall spacer also preferably extends from adjacent the drain injector region to adjacent the gate electrode. The gate sidewall spacer typically surrounds the gate electrode on the sidewall thereof.

The gate electrode of a Fermi-FET preferably includes a polycrystalline silicon (polysilicon) layer on the gate insulating layer, and a conductor layer such as metal on the polysilicon layer. The polysilicon layer is preferably of opposite conductivity type from the source, drain and tub regions of the Fermi-FET. The gate sidewall spacer extends from the sidewall of the polysilicon layer onto the source and drain injection tubs. The gate sidewall spacer lowers the pinch-off voltage of the device and increases the saturation current of the device.

The source and drain injector regions are used in the Tub-FET structure to provide a high current Fermi-FET device. The source and drain injector regions are preferably used in combination with the gate sidewall spacer to provide a high current device with low pinch-off voltage.

When short channel FETs, for example FETs with channel length of about 0.5μm or less, are fabricated, bottom leakage current increases as a result of the drain field terminating in the source depletion region, to cause drain induced injection. According to yet another feature of the invention, bottom leakage current is reduced by extending the source and drain injector regions to the depth of the Fermi-tub. Alternatively, a bottom leakage control region of the same conductivity type as the substrate may be provided.

The bottom leakage control region is doped at a high concentration relative to the substrate and extends across the substrate from between an extension of the facing ends of the source and drain regions or source and drain injector regions, and extends to both sides of the Fermi-tub/substrate junction. High current, short channel devices with low pinch-off voltage and low leakage current are thereby provided.

It will be understood by those having skill in the art that the bottom leakage control region or extended injector regions may also be used in Tub-FETs having channel length which is greater than about 0.5μm. The bottom leakage current control region can also be used in a Tub-FET which does not include injector regions.

The Fermi-tub depth is also preferably bounded between a maximum tub depth and a minimum tub depth. In particular, the Fermi-tub depth is sufficiently deep to allow complete depletion of the Fermi-tub region by the substrate-tub junction at the threshold voltage of the field effect transistor, but is also sufficiently shallow to allow a closed inversion injection barrier between the source region and the drain region below the threshold voltage of the Fermi-FET. High saturation current and low leakage current are thereby produced simultaneously.

In one particular embodiment, a field effect transistor according to the present invention includes a semiconductor substrate of first conductivity type which is doped at a first doping concentration $N_{sub}$, has a permittivity $e_s$ and a Fermi-potential $e_f$ at temperature T° Kelvin. A Fermi-tub region of second conductivity type is formed in the substrate at a surface thereof, and is doped at a second doping concentration $N_{tub}$ which a factor $\alpha$ times $N_{sub}$. Spaced apart source and drain regions of second conductivity type are formed in the Fermi-tub region at the substrate surface. A gate insulating layer is formed on the substrate at the substrate surface between the spaced apart source and drain regions. Source, drain and gate electrodes electrically contact the source and drain regions and the gate insulating layer, respectively.

The Fermi-tub region extends into the substrate a predetermined depth from the substrate surface, where the predetermined depth is greater than $(2e_s\emptyset_s N_{sub}/qN_{tub}(N_{tub}+N_{sub}))^{1/2}$ and is less than $(2e_s V_t/qN_{tub})^{1/2}$, where q is $1.6 \times 10^{-19}$ coulombs, $V_t$ is the threshold voltage of the Fermi-FET, $\emptyset_s$ is $2\emptyset_f + (KT/q) 1 n\alpha$, and K is $1.38 \times 10^{-23}$ Joules/°Kelvin. By confirming Fermi-tub to between this minimum and maximum depth, a high saturation current, low leakage current Fermi-FET is provided.

Brief Description of the Drawings

Figure 1 illustrates a cross-sectional view of an N-channel high current Fermi-FET according to the present invention.

Figures 2A-2C graphically illustrate preferred doping profiles and geometries for the high current Fermi-FET of Figure 1 having a 0.8μm channel.

Figure 3 illustrates an enlarged cross-sectional view of a portion of the high current Fermi-FET of Figure 1.

Figures 4A and 4B graphically illustrate simulated drain saturation current for N-channel and P-channel Fermi-FETs respectively, as a function of channel length and gate insulating layer thickness.

Figure 4C graphically illustrates simulated gate capacitance versus gate insulating layer thickness for a Fermi-FET.

Figure 5A graphically illustrates simulated transistor drain current characteristics of a conventional 0.8μm N-channel MOSFET.

Figures 5B and 5C graphically illustrate simulated transistor drain current characteristics of a 0.8μm N-channel high current Fermi-FET.

Figures 6A and 6B graphically illustrate simulated bottom current and sub threshold leakage behaviour for N-channel and P-channel high current Fermi-FETs respectively.

Figure 7 graphically illustrates simulated worst case comparisons of drain current versus drain bias for different sidewall spacer structures in a high current Fermi-FET.

Figures 8A-8C illustrate enlarged crosssections of the sidewall spacer structures which are graphically illustrated in Figure 7.

Figure 9A illustrates a cross-sectional view of an embodiment according to the invention of a short channel low leakage current Fermi-FET.

Figure 9B illustrates a cross-sectional view of another embodiment of a short channel low leakage current Fermi-FET.

Figures 10A and 10B graphically illustrate preferred doping profiles and geometries for designing a 0.5μm channel low leakage current Fermi-FET of Figure 9A.

Figures 10C and 10D graphically illustrate preferred doping profiles and geometries for designing a 0.5μm channel low leakage current Fermi-FET of Figure 93.

Figure 11 graphically illustrates basic sub-threshold voltage-current behavior of a field effect transistor.

Figures 12A and 12B are enlarged cross-sectional views of a field effect transistor illustrating drain induced injection.

Figure 13 illustrates a cross-sectional view of an N-channel, hiqh current, low leakage current Fermi-FET.

Figure 14 graphically illustrates accumulated free charge which is stored in the source and/or drain diffusion injection area facing the channel in the transistor of Figure 13.

Figure 15 graphically illustrates an equivalent volume of excess carriers that is free to be accumulated into the channel of the transistor of Figure 13.

Figures 16A-16B graphically illustrate a gate capacitance factor as a function of source/drain diffusion concentration for various channel lengths.

Figure 17 graphically illustrates an electric field diagram for the transistor of Figure 13 at threshold.

Figure 18 graphically illustrates lowering of threshold voltage by increasing the doping concentration in the channel of the transistor of Figure 13.

Figure 19 graphically illustrates saturation velocity in a field effect transistor as a vector quantity.

Figures 20A and 20B graphically illustrate maximum lateral velocity for electrons and holes, respectively.

Figures 21A and 21B illustrate the cosine factor for the conditions of Figures 20A and 20B respectively.

Figure 22A illustrates a cross-sectional view of an N-channel MOS device with lightly doped diffusions.

Figure 22B is a perpendicular electric field diagram for the device of Figure 22A.

Figure 23A is a cross-sectional view of a buried channel MOS device with lightly doped diffusions.

Figure 23B is a perpendicular electric field diagram for the device of Figure 23A.

Figure 24 graphically illustrates a perpendicular electric field diagram for the Fermi-FET transistor of Figure 13.

Figures 25A-25C graphically illustrate NMOS and N-Fermi-FET drain saturation current as a function of gate function and channel length.

Figures 26A-26C graphically illustrate PMOS and P-Fermi-FET drain saturation current as a function of gate function and channel length.

Figure 27 illustrates a cross-sectional view of an N-channel, high current, low leakage current, Fermi-FET.

Figure 28 illustrates an enlarged cross-sectional view of a portion of the Fermi-FET of Figure 27.

Figure 29 graphically illustrates the total undepleted reservoir of distributed charge adjacent the source region of the Fermi-FET of Figure 27.

Figure 30 graphically illustrates saturation current as a function of doping gradient region thickness for the Fermi-FET of Figure 27.

Figure 31 graphically illustrates saturation current as a function of source/drain doping concentration for the Fermi-FET of Figure 27.

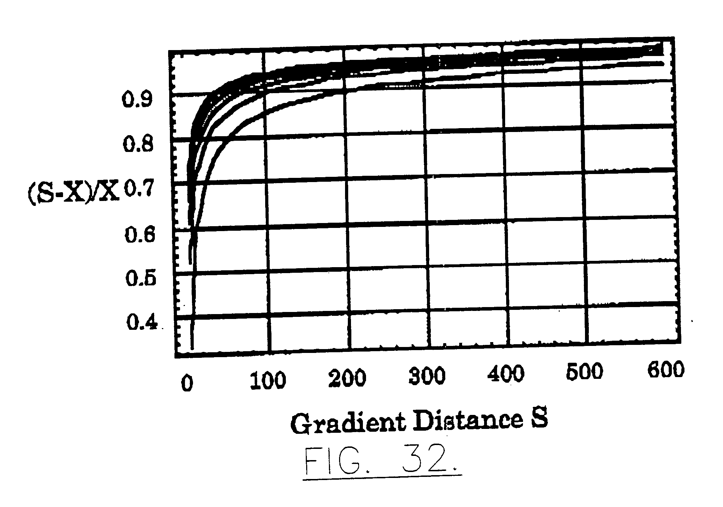

Figure 32 graphically illustrates doping gradient region distance versus source/drain diffusion depth for the Fermi-FET of Figure 27.

Figures 33A and 33B illustrate a cross-sectional view of a portion of the Fermi-FET of Figure 1 and a corresponding electric field diagram, respectively.

Figure 34A graphically illustrates a simulation of a completely enclosed inversion region.

Figure 34B graphically illustrates a simulation of a failure of an inversion injection barrier to close.

Figure 35 graphically illustrates maximum and minimum values of Fermi-tub depth.

Figure 36 graphically illustrates Fermi-channel depth as a function of Fermi-tub doping concentration and substrate concentration.

Figure 37 graphically illustrates threshold voltage as a function of tub doping concentration and polysilicon gate concentration.

Detailed Description of Preferred Embodiments

In the drawings, the thickness of layers and regions are exaggerated for clarity. Like numbers refer to like elements throughout.

Before describing the high saturation current, low leakage current Fermi threshold field effect transistor of the present invention, the Fermi threshold field effect transistor with reduced gate and diffusion capacitance of US-A-5194923 and 5369295 (also referenced as the "low capacitance Fermi-FET" or the "Tub-FET") will first be described. A more complete description may be found in these patent specifications.

After describing the low capacitance Fermi-FET, a Fermi-FET including the injector regions, gate sidewall spacer regions, and bottom leakage control region will then be described.

Other Fermi-FET devices useful for understanding the present invention will also be described and will include an explanation of the control of the saturation current by controlling doping of the source/drain diffusions facing the channel, the control of threshold voltage and a theoretical comparison between a conventional MOSFET and a Fermi-FET in which it will be shown that a conventional MOSFET cannot produce the desired combination of high saturation current and low leakage current of the Fermi-FET. Then, the bounded tub Fermi-FET according to the present invention will be described.

**Fermi-FET With Reduced Gate and Diffusion Capacitance**

The following summarizes the low capacitance Fermi-FET including the Fermi-tub. Additional details may be found in US-A-5 194 923 and 5 369 295.

Conventional MOSFET devices require an inversion layer to be created at the surface of the semiconductor in order to support carrier conduction. The depth of the inversion layer is typically 100Å or less. Under these circumstances gate capacitance is essentially the permittivity of the gate insulator layer divided by its thickness. In other words, the channel charge is so close to the surface that effects of the dielectric properties of the substrate are insignificant in determining gate capacitance.

Gate capacitance can be lowered if conduction carriers are confined within a channel region below the gate, where the average depth of the channel charge requires inclusion of the permittivity of the substrate to calculate gate capacitance. In general, the gate capacitance of the low capacitance Fermi-FET is described by the following equation:

$$C_g = \frac{1}{\frac{Y_f}{\beta e_s} + \frac{T_{ox}}{e_i}} \qquad (1)$$

Where $Y_f$ is the depth of the conduction channel called the Fermi channel, $e_s$ is the permittivity of the substrate, and $\beta$ is the factor that determines the average depth of the charge flowing within the Fermi channel below the surface. $\beta$ depends on the depth dependant profile of carriers injected from the source into the channel. For the low capacitance Fermi-FET, $\beta \approx 2$. $T_{ox}$ is the thickness of the gate oxide layer and $e_i$ is its permittivity.

The low capacitance Fermi-FET includes a Fermi-tub region of predetermined depth, having conductivity type opposite the substrate conductivity type and the same conductivity type as the drain and source regions. The Fermi-tub extends downward from the substrate surface by a predetermined depth, and the drain and source diffusions are formed in the Fermi-tub region within the Fermi-tub boundaries. The preferred Fermi-tub depth is the sum of the Fermi channel depth $Y_f$ and depletion depth $Y_o$. A Fermi channel region with predetermined depth $Y_f$ and width Z, extends between the source and drain diffusions. The conductivity of the Fermi channel is controlled by the voltage applied to the gate electrode.

The gate capacitance is primarily determined by the depth of the Fermi channel and the carrier distribution in the Fermi channel, and is relatively independent of the thickness of the gate oxide layer. The diffusion capacitance is inversely dependant on the difference between [the sum of the depth of the Fermi-tub and the depletion depth $Y_o$ in the substrate] and the depth of the diffusions $X_d$. The diffusion depth is preferably the same depth as the Fermi channel. For deeper configurations, diffusion depth is less than the depth of the Fermi-tub, $Y_{Tub}$. The dopant concentration for the Fermi-tub region is preferably chosen to allow the depth of the Fermi channel to be greater than three times the depth of an inversion layer within a MOSFET.

Accordingly, the low capacitance Fermi-FET includes a semiconductor substrate of first conductivity type having a first surface, a Fermi-tub region of second conductivity type in the substrate at the first surface, spaced apart source and drain regions of the second conductivity type in the Fermi-tub region at the first surface, and a channel of the second conductivity type in the Fermi-tub region at the first surface between the spaced apart source and drain regions. The channel extends a first predetermined depth ($Y_f$) from the first surface and the tub extends a second predetermined depth ($Y_o$) from the channel. A gate insulating layer is provided on the substrate at the first surface between the spaced apart source and drain regions. Source, drain and gate electrodes are provided for electrically contacting the source and drain regions and the gate insulating layer respectively.

At least the first and second predetermined depths are selected to produce zero static electric field perpendicular to the first surface at the first depth, upon application of the threshold voltage of the field effect transistor to the gate electrode. The first and second predetermined depths are also selected to allow carriers of the second conductivity type to flow from the source to the drain in the channel, extending from the first predetermined depth toward the first surface upon application of the voltage to the gate electrode beyond the threshold voltage of the field effect transistor. The carriers flow from the source to the drain region beneath the first surface without creating an inversion layer in the Fermi-tub region. The first and second predetermined depths are also selected to produce a voltage at the substrate surface, to achieve a value twice the Fermi potential of the substrate adjacent the gate insulating layer. The sum of the voltages between the substrate contact and the substrate and between the polysilicon gate and the gate electrode are essentially zero.

When the substrate is doped at a doping density $N_s$, has an intrinsic carrier concentration $N_i$ at temperature T degrees Kelvin and a permittivity $e_s$, and the field effect transistor includes a substrate contact for electrically contacting the substrate, and the channel extends a first predetermined depth $Y_f$ from the surface of the substrate and the Fermi-tub region extends a second predetermined depth $Y_o$ from the channel, and the Fermi-tub region is doped at a doping density which is a factor $\alpha$ times $N_s$, and the gate electrode includes a polysilicon layer of the first conductivity type and which is doped at a doping density $N_p$, the first predetermined depth ($Y_f$) is equal to:

$$Y_f = \sqrt{\frac{2e_s}{qN_s\alpha}\frac{KT}{q}\ln\left(\frac{N_p}{N_s}\right)} \, , \qquad (2)$$

where q is $1.6\times10^{-19}$ coulombs and K is $1.38\times10^{-23}$ Joules/°Kelvin. The second predetermined depth ($Y_o$) is equal to:

$$Y_o = \sqrt{\frac{2e_s\phi_s}{qN_s\alpha(\alpha+1)}}, \qquad (3)$$

where $\phi_s$ is equal to $2\phi_f + KT/q \ln\alpha$, and $\phi_f$ is the Fermi potential of the semiconductor substrate.

### High Current Fermi-FET Structure

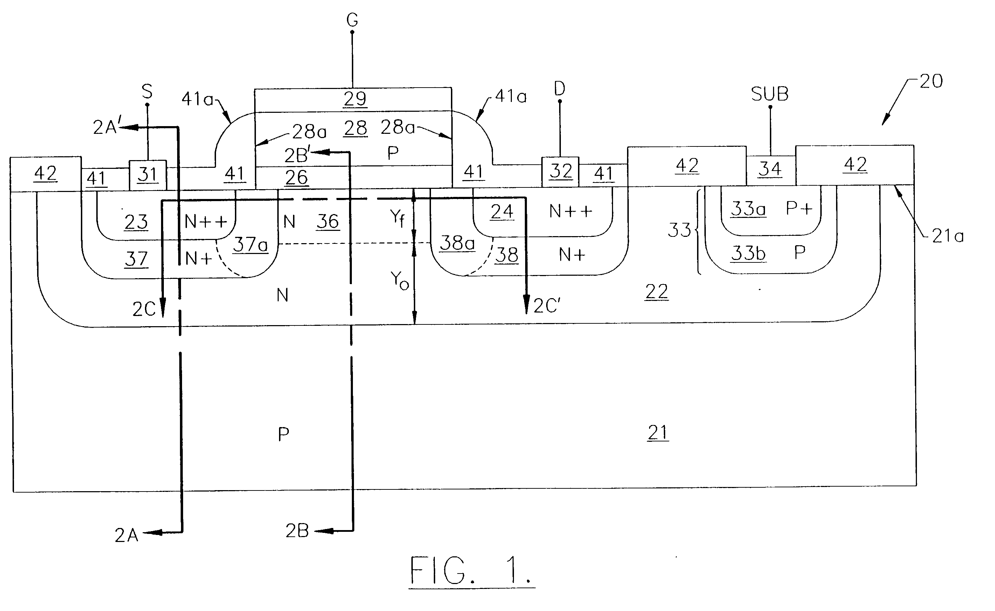

Referring now to Figure 1, an N-channel high current Fermi-FET according to the invention is illustrated. It will be understood by those having skill in the art that a P-channel Fermi-FET may be obtained by reversing the conductivities of the N and P regions.

As illustrated in Figure 1, high current Fermi-FET **20** is fabricated in a semiconductor substrate **21** having first conductivity type, here P-type, and including a substrate surface **21a**. A Fermi-tub region **22** of second conductivity type, here N-type, is formed in the substrate **21** at the surface **21a**. Spaced apart source and drain regions **23** and **24,** respectively, of the second conductivity type, here N-type, are formed in the Fermi-tub region **22** at the surface **21a**. It will be understood by those having skill in the art that the source and drain regions may also be formed in a trench in the surface **21a.**

A gate insulating layer **26** is formed on the substrate **21** at the surface **21a** between the spaced apart source and drain regions **23** and **24,** respectively. As is well known to those having skill in the art, the gate insulating layer is typically silicon dioxide. However, silicon nitride and other insulators may be used.

A gate electrode is formed on gate insulating layer **26,** opposite the substrate **21**. The gate electrode preferably includes a polycrystalline silicon (polysilicon) gate electrode layer **28** of first conductivity type, here P-type. A conductor gate electrode layer, typically a metal gate electrode layer **29,** is formed on polysilicon gate electrode **28** opposite gate insulating layer **26.** Source electrode **31** and drain electrode **32,** typically metal, are also formed on source region **23** and drain region **24,** respectively.

A substrate contact **33** of first conductivity type, here P-type, is also formed in substrate **21,** either inside Fermi-tub **22** as shown or outside tub **22.** As shown, substrate contact **33** is doped first conductivity type, here P-type, and may include a relatively heavily doped region **33a** and a relatively lightly doped region **33b.** A substrate electrode **34** establishes electrical contact to the substrate.

The structure heretofore described with respect to Figure 1 corresponds to the low capacitance Fermi-FET structure of US-A-5194923 and 5369295. As already described in these patent specifications, a channel **36** is created between the source and drain regions **23** and **24.** The depth of the channel from the surface **21a,** designated at $Y_f$ in Figure 1, and the depth from the bottom of the channel to the bottom of the Fermi-tub **22,** designated as $Y_0$ in Figure 1, along with the doping levels of the substrate **21,** tub region **22,** and polysilicon gate electrode **28** are selected to provide a high performance, low capacitance field effect transistor using the relationships of Equations (2) and (3) above.

Still referring to Figure 1, according to the present invention, a source injector region **37a** of second conductivity type, here N-type, is provided adjacent the source region **23** and facing the drain region. As will be described below, the source injector region provides a high current, Fermi-FET by controlling the depth at which carriers are injected into channel **36.** The source injector region **37a** may only extend between the source region **23** and the drain region **24.** The source injector region preferably surrounds source region **23** to form a source injector tub region **37,** as illustrated in Figure 1. Source region **23** may be fully surrounded by the source injector tub region **37,** on the side and bottom surface. Alternatively, source region **23** may be surrounded by the source injector tub region **37** on the side, but may protrude through the source injector tub region **37** at the bottom. Still alternatively, source injector region **37a** may extend into substrate **21,** to the junction between Fermi-tub **22** and substrate **21.** A drain injector region **38a,** preferably a drain injector tub region **38** surrounding drain region **24,** is also preferably provided.

Source injector region **37a** and drain injector region **38a** or source injector tub region **37** and drain injector tub region **38,** are doped the second conductivity type, here N-type, at a doping level which is intermediate the relatively low doping level of Fermi-tub **22** and the relatively high doping level of source **23** and drain **24.** Accordingly, as illustrated in Figure 1, Fermi-tub **22** is designated as being N, source and drain injector tub regions **37, 38** are designated as N+ and source and drain regions **23, 24** are designated as N++. A unijunction transistor is thereby formed.

The high current Fermi-FET of the present invention provides drive currents that are up to about four times that of state of the art FETs. Gate capacitance is about half that of a conventional FET device. The doping concentration of the source injector tub region **37** controls the depth of carriers injected into the channel region **36,** typically to about 1000Å. The source injector tub region **37** doping concentration is typically 2E18, and preferably has a depth at least as great as the desired maximum depth of injected majority carriers. Alternatively, it may extend as deep as the Fermi-tub region **22** to minimize subthreshold leakage current, as will be described below. It will be shown that the carrier concentration injected into the channel **36** cannot exceed the doping concentration of the source injector region **37a** facing the drain. The width of the portion of source injector region **37a** facing the drain is typically in the range of 0.05-0.15μm. The doping concentration of the source and drain regions **23** and **24** respectively, is typically 1E19 or greater. The depth $(Y_f+Y_0)$ of the Fermi-tub **22** is approximately 2200Å with a doping concentration of approximately 1.8E16.

As illustrated in Figure 1, the high current Fermi-FET **20** also includes a gate sidewall spacer **41** on the substrate surface **21a,** which extends from adjacent the source injector region **37a** to adjacent the polysilicon gate electrode **28.** Gate sidewall spacer **41** also preferably extends from adjacent the drain injector region **38a** to adjacent the polysilicon gate electrode **28.** In particular, as shown in Figure 1, gate sidewall spacer **41** extends from the polysilicon gate electrode sidewall **28a** and overlies the source and drain injector regions **37a** and **38a** respectively. Preferably the gate sidewall spacer **41** surrounds the polysilicon gate electrode **28.** Also preferably, and as will be discussed in detail below, the gate insulating layer **26** extends onto the source injector region **37a** and the drain injector region **38a** at the substrate face **21a** and the gate sidewall spacer **41** also extends onto the source injector region **37** and drain injector region **38.**

The gate sidewall spacer **41** lowers the pinch-off voltage of the Fermi-FET **20** and increases its saturation current in a manner in which will be described in detail below. Preferably, the gate sidewall spacer is an insulator having a permittivity which is greater than the permittivity of the gate insulating layer **26.** Thus, for example, if the gate insulating layer **26** is silicon dioxide, the gate sidewall spacer is preferably silicon nitride. If the gate insulating layer **26** is silicon nitride, the gate sidewall spacer is preferably an insulator which has permittivity greater than silicon nitride.

As shown in Figure 1, the gate sidewall spacer **41** may also extend onto source and drain regions **23** and **24** respectively, and the source and drain electrodes **31** and **32** respectively may be formed in the extension of the gate sidewall spacer region. Conventional field oxide or other insulator **42** regions separate the source, drain and substrate contacts. It will also be understood by those having skill in the art that although the outer surface **41a** of gate sidewall spacer **41** is illustrated as being curved in cross section, other shapes may be used, such as a linear outer surface to produce a triangular cross section or orthogonal outer surfaces to produce a rectangular cross section.

**Design of 0.8μm High Current Fermi-FET**

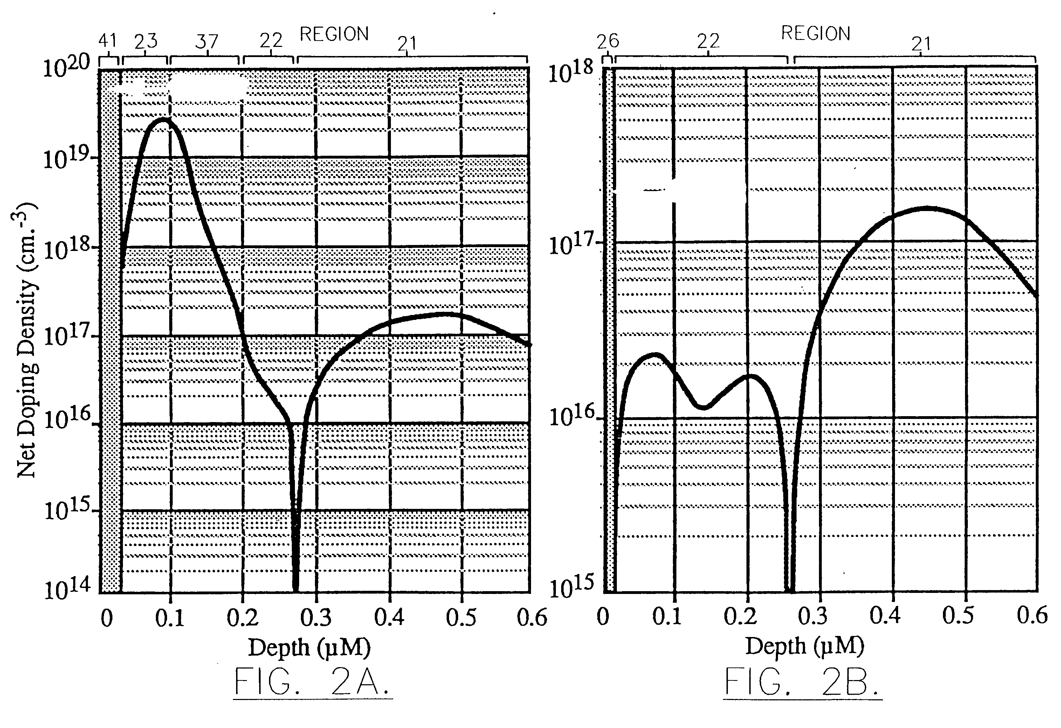

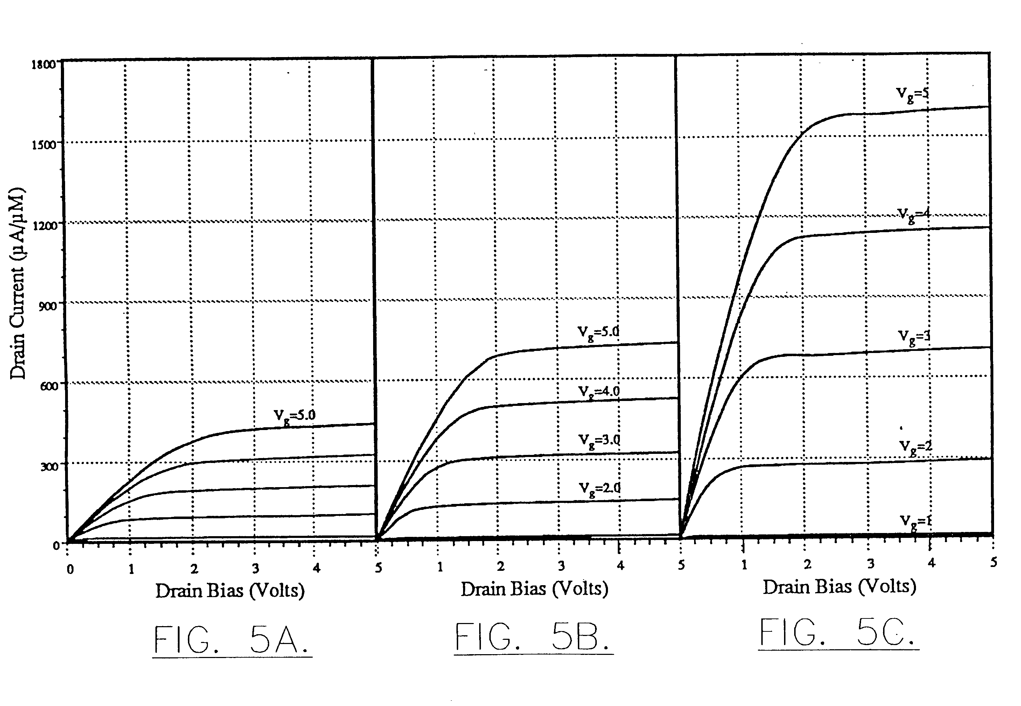

Referring now to Figures 2A-2C, preferred doping profiles and geometries for designing a 0.8μm channel high current Fermi-FET as illustrated in Figure 1 will now be described. It will be understood by those having skill in the art that both N and P channel FETs are fabricated in a similar fashion. Figures 2A-2C are simulation results which graphically illustrate N-channel high current Fermi-FET doping profiles to produce a 0.8μm channel length device leading to the drain current properties illustrated in Figures 5B and 5C. It is well known to those having skill in the art how to achieve these doping profiles, using many well known techniques.

In the examples of Figures 2A-2C, the P-type doping concentration of the polysilicon gate electrode **28** is 2E19 for either P- or N-channel FETs. The $SiO_2$ gate insulating layer **26** is 140Å thick. The thickness of the polysilicon gate electrode **28** is 3000Å. The height of the gate sidewall spacer **41** is also 3000Å, and the gate sidewall spacer **41** is fabricated of silicon nitride. The width of the source injector tub region portion **37a** facing the drain is about 0.1μm and the gate insulating layer **26** overlaps this region by about 0.05μm.

Referring now to Figure 2A, a vertical doping profile along the line **2A-2A'** of Figure 1, perpendicular to the face **21a** and centered about the source **23** is described. The region to which the profile applies is also labeled at the top of the horizontal axis of Figure 2A. As shown, the gate sidewall spacer region **41** has a thickness of about 140Å and the source region **23** has a depth of about 2000Å from the face **21a.** Source injector tub region **37** has a depth of about 2000Å from face **21a** and Fermi-tub **22** has a depth ($Y_f+Y_0$) of 2200Å from the face **21a.** The thickness of substrate **21** is about 1μm. The source injector tub **37** doping concentration is about 2E18 and the source region **23** doping is about 2.5E19.

Figure 2B is a doping profile taken along line **2B-2B'** in Figure 1. As shown in Figure 2B, the Fermi-tub **22** has been implanted using a double implantation process which produces a double hump. However, it will be understood by those having skill in the art that multiple implants or other techniques may be used to produce a more uniform doping profile for the Fermi-tub if desired. The Fermi-tub **22** depth is shown to be about 2200Å with an average concentration in the flat region of 1.8E16. The effective humpback substrate doping concentration is about 1E17.

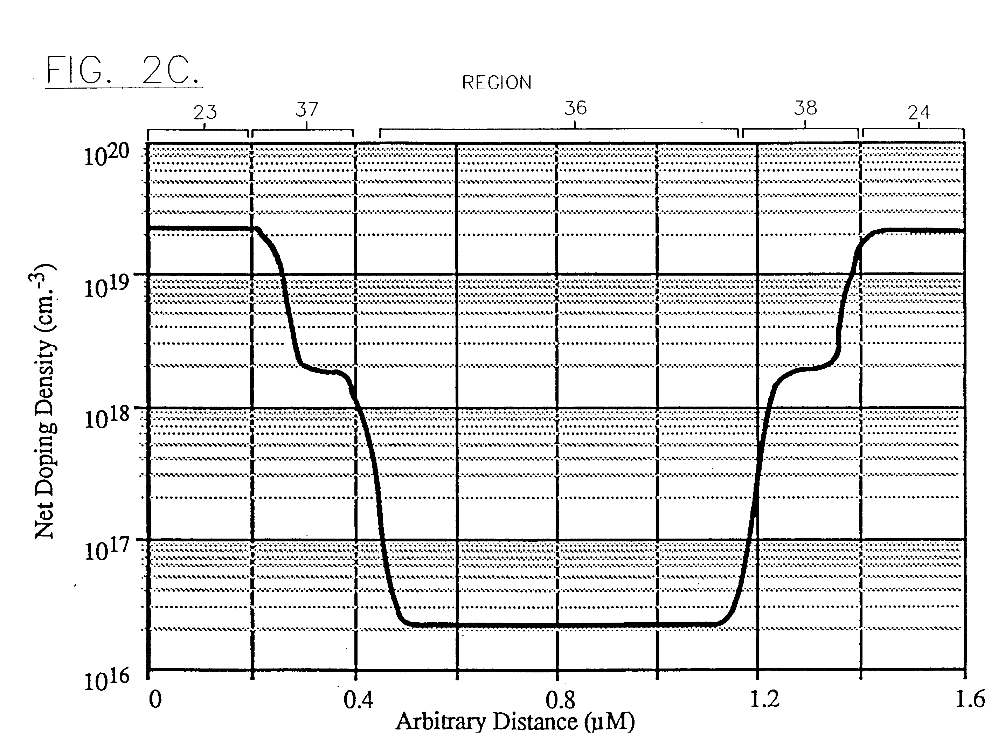

Figure 2C illustrates a doping profile along lines **2C-2C'** of Figure 1. In other words, it is a doping profile from the middle of source region **23** through source injector region **37a** through channel **36** and through drain injector region **38a** and to the middle of drain **24.** These regions are denoted in the Figure 2C as well.

**Operation of the Injector and Gate Sidewall Spacer Regions**

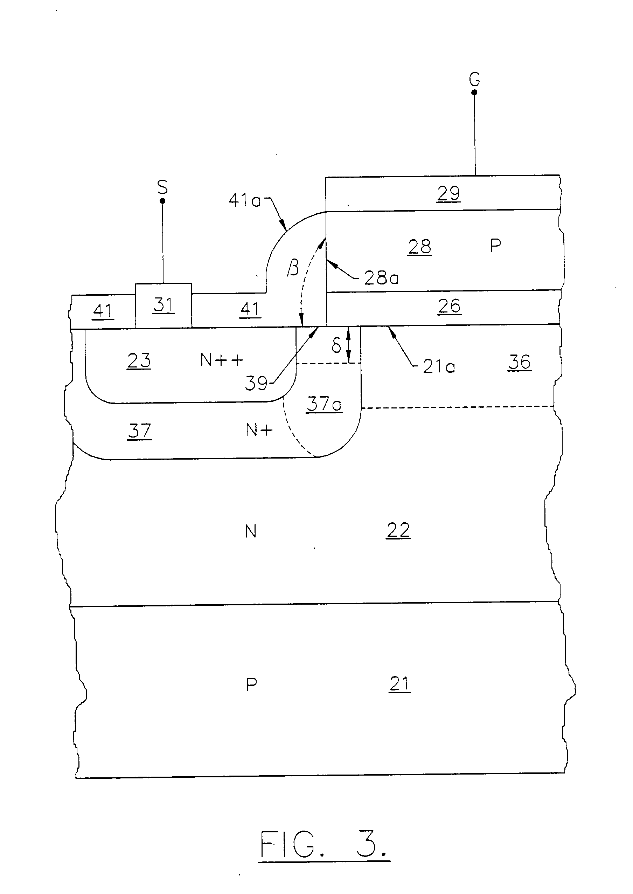

Referring now to Figure 3, an enlarged cross section of the area between source **23** and polysilicon gate electrode **28** is illustrated, in order to explain the operation of source injector region **37a** and gate sidewall spacer region **41.** When gate voltage exceeds source voltage, an electric field $E_{ii}$ terminates at interface **39** between the injector region **37a** and the spacer **41.** This field $E_{ii}$ is produced by the potential difference between the polysilicon gate electrode **28** and the surface of the injector region **37a** at interface **39.** This electric field creates charge accumulation within depth δ at the surface of the injector **37a,** as illustrated in Figure 3. From boundary conditions at the injector-insulator interface **39** and use of the divergence theorem, the following conditions prevail:

$$e_s E_s = e_{ii} E_{iin} \qquad (4)$$

where $e_s$ is the permittivity of the substrate **21,** $E_s$ is the electric field in injector **37a** at interface **39,** $e_{ii}$ is the permittivity of the spacer region **41** and $E_{iin}$ is the electric field in spacer region **41** at the interface **39.**

Therefore, the electric field at the surface of the silicon $E_s$ is expressed in terms of the different permittivities at the interface and the electric field in the injector insulator, $E_{iin}$:

$$E_s = \frac{e_{iin}}{e_s} E_{iin} \qquad (5)$$

When the source **23** is at ground potential and the polysilicon gate electrode **28** is at gate voltage $V_g$ above ground (N-channel), the injector insulator field $E_{iin}$ is expressed as the difference between gate and injector surface potential $\phi_s$ divided by the effective spacer region insulator thickness $\beta T_{in}$, where $V_t$ is the threshold voltage:

$$E_{iin} = \frac{(V_g - V_t) - \phi_s}{\beta T_{iin}} \tag{6}$$

Fringe field factor $\beta$ is generally greater than one and is due to the length of the fringe field path from the sidewall **28a** of the polysilicon gate electrode **28** and the interface **39,** as illustrated in Figure 3. For long channel devices $\beta$ approaches 1.0. For short channel devices $\beta > 1.0$. The difference is due to the depth of the charge accumulation layer in the polysilicon gate electrode layer **28** above the insulator interface. For short channel devices this depth increases tending to increase fringe factor $\beta$.

The gate sidewall spacer **41** may be the same material as the gate insulating layer **26.** However in general the permittivity $e_{ii}$ of the sidewall spacer **41** should be higher than the permittivity $e_{gi}$ of the gate insulating layer **26.** Preferably the ratio $e_{ii}/e_{gi}$ should be at least equal to fringe factor $\beta$. If $\beta = 1$, the increased permittivity acts to lower subthreshold leakage current. A good choice of materials is silicon dioxide ($SiO_2$) for the gate insulator **26** and silicon nitride ($Si_3N_4$) for the gate sidewall spacer **41.**

Based on Equations (5) and (6) the surface electric field $E_s$ is:

$$E_s = \frac{e_{ii}}{e_s} \left( \frac{(V_g - V_t) - \phi_s}{\beta T_{in}} \right) = \frac{q}{e_s} \int_O^{\delta} N_{ac}(y)\, dy \tag{7}$$

where $\delta$ is the depth of the accumulation region, q is the electron charge, and $N_{ac}(y)$ is the depth dependent concentration of the accumulation charge at the surface of the injector.

Since Fermi-FET conduction depends on accumulation rather than inversion, a similar expression can be written for the equivalent total accumulation of majority carriers under the gate electrode with low drain voltage. The actual flow depth $\delta$ of this charge is controlled by the injection profile. The expression is:

$$E_{si} = \frac{e_{ii}}{e_s} \left( \frac{(V_g - V_t) - \phi_s}{T_{gin}} \right) = \frac{q}{e_s} \int_O^{\delta} N_{gac}(y)\, dy \tag{8}$$

A fundamental relationship between surface potential $\phi_s$ and surface field $E_s$ will now be derived. The total charge in the channel region **36** when drain voltage is close to zero, is:

$$Q = Z\, L_o\, q \int_O^{\delta} N_{ch}(y)\, dy \tag{9}$$

Where $N_{ch}(y)$ is the volume density of channel charge measured in the vertical direction, and $\delta$ is the depth of flow charge at the source end of the channel. Using the divergence theorem, the vertical electrical field intensity $E_s$ in silicon at the insulator-silicon interface **39** at the source end of the channel is:

$$E_s = \frac{q}{e_s} \int_0^{\delta} N_{ch}(y)\, dy \tag{10}$$

Comparing Equations (9) and (10), surface field $E_s$ is independent of charge distribution within the depth direction of the channel and only depends on total charge per unit gate area Q*. Thus:

$$E_s = \frac{Q}{Z L_o e_s} = \frac{Q^*}{e_s} \qquad (11)$$

The surface potential at the source end of the channel due to this same channel charge distribution is now determined. Using Poisson's equation, surface potential $\phi_s$ under the injector insulator at the source end of the channel is:

$$\phi_s = \frac{q}{e_s} \int_0^\delta \int_0^y N_{ch}(y)\, dy\, dy \qquad (12)$$

It will be shown subsequently that gate induced injection of excess charge into a Fermi channel region at the source - channel interface is quite uniform in flow depth depending on the character of the source injector region **37a.** Under these circumstances it is reasonable to assume $N_{ch}(y) = N_{do}$ within flow depth $\delta$. For this condition Equation (12) reduces to:

$$\phi_s = \frac{\delta(q\delta N_{do})}{2e_s} \qquad (13)$$

Therefore, from Equation (9), the condition, $N_{ch}(y) = N_{do}$, leads to the following fundamental relationship between surface potential $\phi_s$ and surface field $E_s$:

$$\phi_s = \frac{\delta}{2} E_s \qquad (14)$$

Stated in words, surface potential near the source end of the channel is the product of half the flow channel depth $\delta$ and surface field $E_s$.

Equation (14) is substituted into Equation (8) and solved for surface field $E_s$ to obtain:

$$\frac{V_g - V_t}{e_s\left(\dfrac{T_{gin}}{e_{gin}} + \dfrac{\delta}{2e_s}\right)} = \frac{q}{e_s} \int_0^\delta N_{ac}(y)\, dy \qquad (15)$$

Factor $\delta$ in (15) corresponds to effective flow depth of carriers in the Tub-FET channel, as shown in Figure 3.

Since effective gate capacitance $C_g^*, F/cm^2$ is given by:

$$C_g^* = \frac{1}{\left(\dfrac{T_{gin}}{e_{gin}} + \dfrac{\delta}{2e_s}\right)} \qquad (16)$$

Equation (15) can be used to predict drain saturation current and its dependence on structure:

$$I_{sat} = ZVq\int_0^\delta N_{gac}(y)\,dy = C_g^* ZV(V_g - V_t) \qquad (17)$$

Stated in words, saturation current depends on the product of effective gate capacitance $C_g^*$, channel width Z, carrier velocity V, and gate drive voltage $V_g$-$V_t$. Channel length $L_o$ does not appear directly in Equation (17). To reveal the role of channel length, an expression for carrier velocity V in Equation (17) is developed. Equation (17) is rewritten in terms of the product of carrier mobility $\mu$ and lateral field $E_1$:

$$I_{satn} = C_g^* ZV(V_g\text{-}V_t) = C_g^* Z\mu_n E_1 (V_g\text{-}V_t) \qquad (18)$$

For electrons:

$$\mu_n = \frac{\mu_{no}}{\sqrt{1+\left(\frac{E_1}{E_c}\right)^2}} \qquad (19a)$$

$$E_1 = \frac{V_p}{L} = \frac{V_g\text{-}V_t}{2L_o} \qquad (19b)$$

$$E_c = \frac{V_{sat}}{\mu_{no}} \qquad (19c)$$

$$\frac{E_1}{E_c} = \frac{(V_g\text{-}V_t)\mu_{no}}{2L_o V_{sat}} \qquad (19d)$$

Substituting Equations (19a)-(19d) into Equation (17) a fundamental solution for drain saturation current is obtained:

$$I_{satn} = \frac{C_g^* Z(V_g\text{-}V_t)^2 \mu_{no}}{2L_o\sqrt{1+\left(\frac{(V_g\text{-}V_t)\mu_{no}}{2L_o V_{sat}}\right)^2}} \qquad (20)$$

where Cg* is given by Equation (16).

A similar expression for a P-Channel device is given by:

$$I_{satp} = \frac{C_g^* Z(V_g - V_t)^2 \mu_{po}}{2L_o\left[1+\dfrac{(V_g - V_t)\mu_{po}}{2L_o V_{sat}}\right]} \qquad (21)$$

For short N-channel devices and large gate drive, saturation current reduces to a simple equation independent of channel length and carrier mobility:

$$I_{sat} = C_g^* Z_{sat}(V_g\text{-}V_t) \qquad (22)$$

Accordingly, channel length $L_o$ below about one micron, plays only a minor role in determining drain saturation current of the Fermi-FET. The most fundamental control of saturation current is injector and insulator thickness, their relative permittivities, and effective flow depth $\delta$. The injector tub doping concentration and depth are chosen such that flow depth $\delta$ is adjusted to be greater than 200Å.

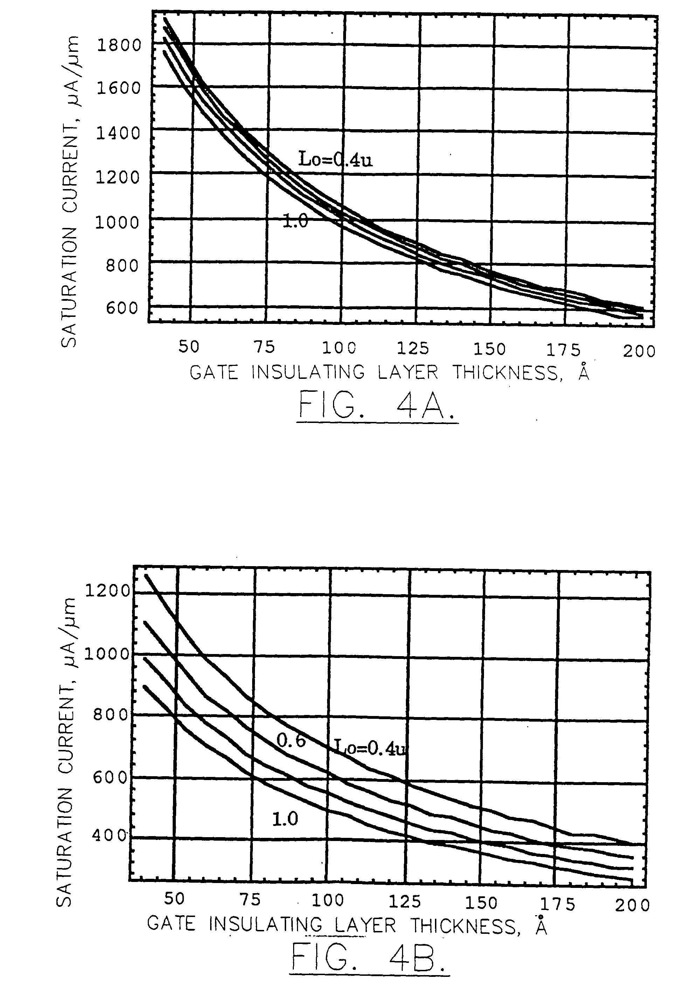

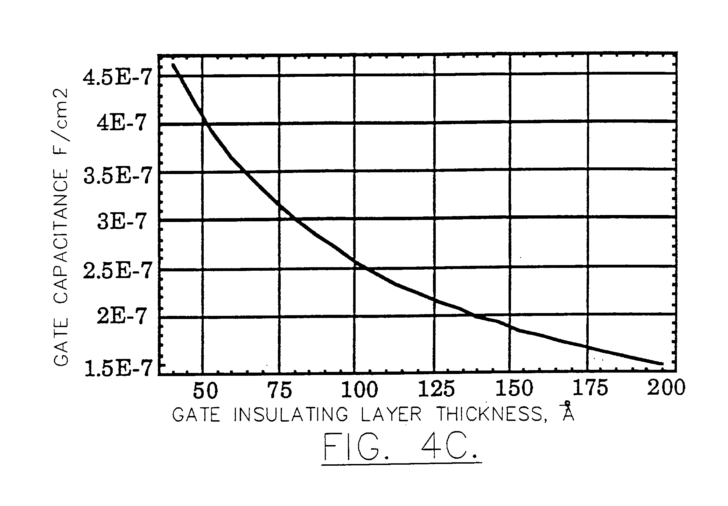

Figures 4A and 4B are plots of simulated drain saturation current for N and P-channel Tub-FET's as a function of channel length $L_o$ and gate insulating layer thickness $T_{gin}$. Note the relative insensitivity to N-channel length compared to insulator thickness. P-channel devices are more sensitive to channel length due to lateral field effects on hole velocity. Figure 4C is a plot of simulated gate capacitance versus gate insulating layer thickness for $\delta$ = 200Å.

When the following equation is satisfied in the design of a Tub-FET, the lowest pinch-off voltage with maximum saturation current and the least subthreshold bottom current are obtained for a given injector tub depth. This equation relates the permittivity of the injector **37,** spacer **41** and gate insulator **26:**

$$\frac{e_{ii}}{e_s}\left(\frac{(V_g - V_t)}{\beta\, T_{iin}}\right) \geq \frac{e_{gi}}{e_s}\left(\frac{(V_g - V_t)}{T_{gin}}\right) \qquad (23)$$

From Equation (18) the following is also one of the Tub-FET design considerations:

$$\frac{e_{ii}}{e_{gi}} \geq \frac{\beta\, T_{iin}}{T_{gin}} \qquad (24)$$

If $T_{iin} = T_{gin}$ then

$$\frac{e_{ii}}{e_{gi}} \geq \beta \qquad (25)$$

For practical high current Fermi-FET designs, one can use silicon nitride ($Si_3N_4$) for the gate sidewall spacer **41** and silicon dioxide ($SiO_2$) for the gate insulator **26.** The permittivity of silicon nitride is 7E-13 F/cm, and silicon dioxide is 3.45E-13 F/cm. The ratio is greater than $\beta$=1.5. It will be shown subsequently that very high drive current Fermi-FET's, 1.6 ma/micron N-channel and 0.8ma/micron P-channel devices, preferably use a 100Å silicon nitride gate insulator. Unlike silicon dioxide insulators, silicon nitride insulators have high field strength, 1E7 V/cm, and therefore can be thin while maintaining high gate breakdown voltage while improving insulation integrity with time. For Fermi-FET devices that use a nitride gate insulator, the spacer and injector insulator can be nitride, but an injector and side-wall insulator material with twice the permittivity is preferred. It will also be understood by those having skill in the art that gate sidewall spacer **41** need not extend directly onto face **21a,** but that a thin insulating layer, of a material other than that of the sidewall spacer **41,** may be formed at interface **39** between injector **37** and sidewall spacer **41.**

Figures 5B and Figure 5C are simulations of the drain current performance of 0.8 micron N-Channel high current Fermi-FET devices. Figure 5A is a similar simulation for a state of the art 0.8 micron MOS N-Channel device. Figure 5A depicts 5 Volt MOS technology with a 150Å $SiO_2$ gate insulator. Figure 5B is a simulation of high current Fermi-FET performance with a 140Å $SiO_2$ gate insulator. Figure 5C is a simulation of high current Fermi-FET performed with a 100Å silicon nitride gate insulator. In both cases, the drain current and pinch-off properties of high current Fermi-FET devices are far superior to MOS or buried channel technology. Similar dramatic improvement occurs for P-channel high current Fermi-FET devices compared to MOS or buried channel technology. P-channel saturation current is typically half N-channel saturation current, and pinch-off voltage is about twice the N-channel value.

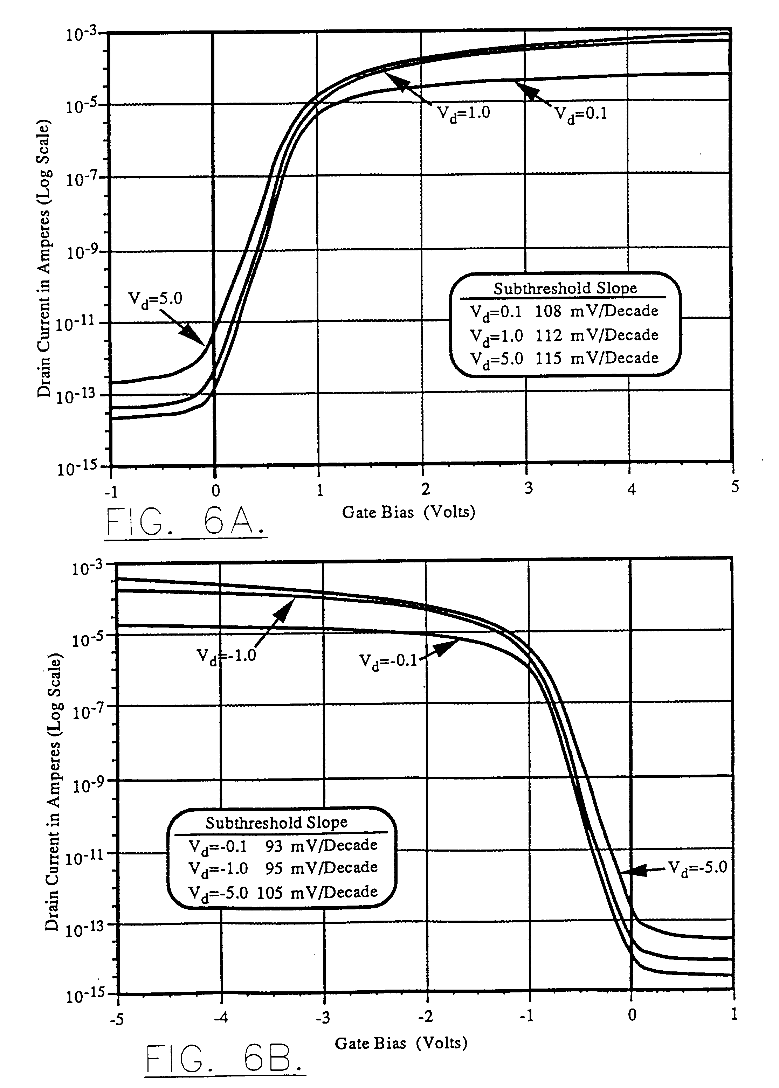

Typical bottom current and sub-threshold leakage behavior for the high current Fermi-FET devices of Figures 5B and 4C, are illustrated in Figures 6A and 6B. N-Channel high current Fermi-FET behavior is shown in Figure 6A, and P-channel behavior in Figure 6B. These figures illustrate N-channel current for an 0.8µm transistor per µm width, and P-channel current for an 0.8µm transistor per µm width, respectively. Bottom current is typically 2E-13 A/µm at 5 Volt drain bias at room temperature. This can be lowered to 2E-15 A/µm using the short channel techniques described below.

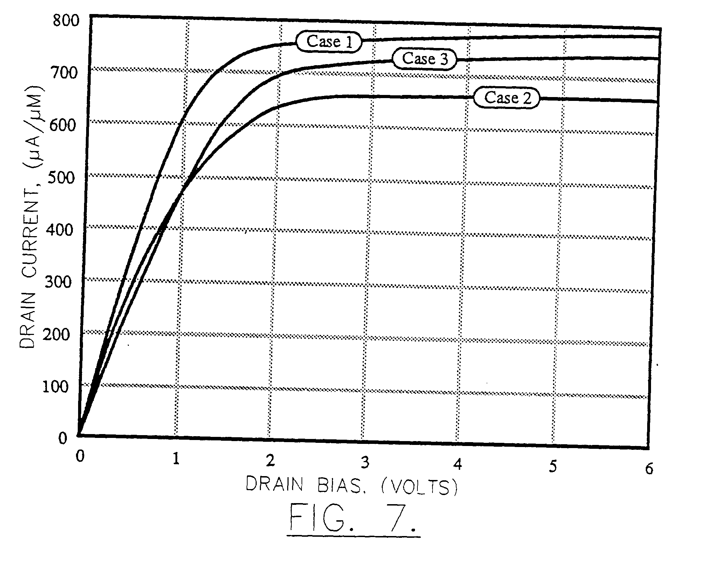

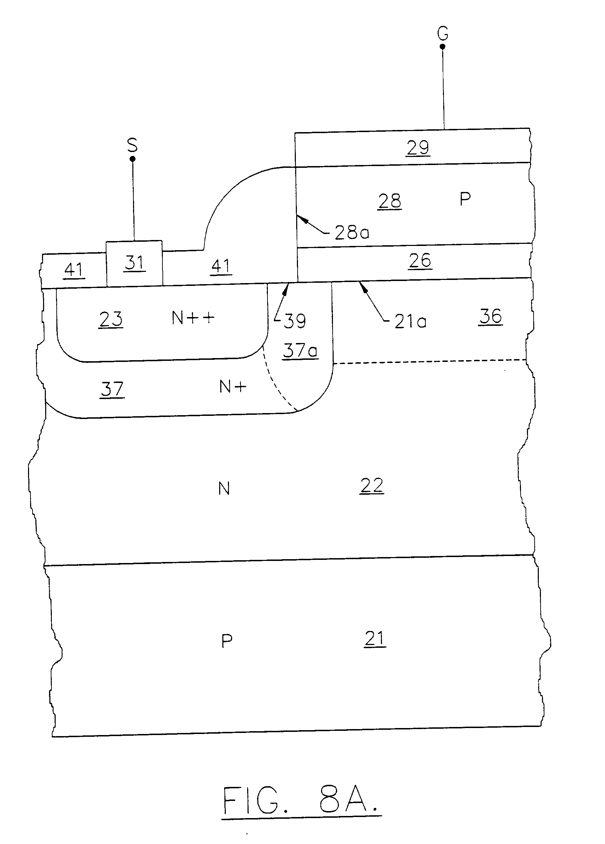

Figure 7 illustrates a worst case simulated comparison plot of 5 Volt N-channel high current Fermi-FET drain current with different side-wall spacer structures **41** (Figure 1). In all plots, the $SiO_2$ gate insulator **28** thickness is 132Å. The different structures are illustrated in Figures 8A-8C.

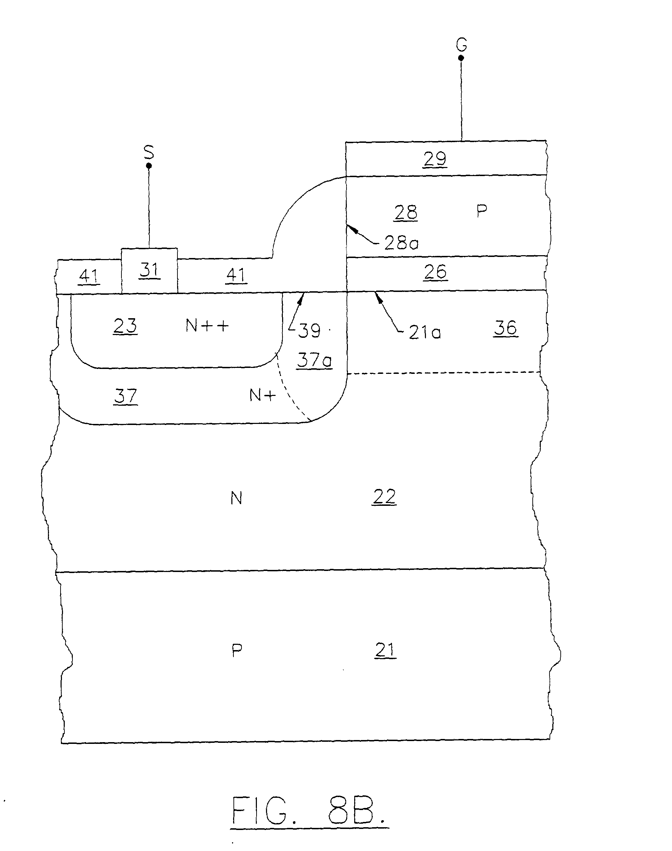

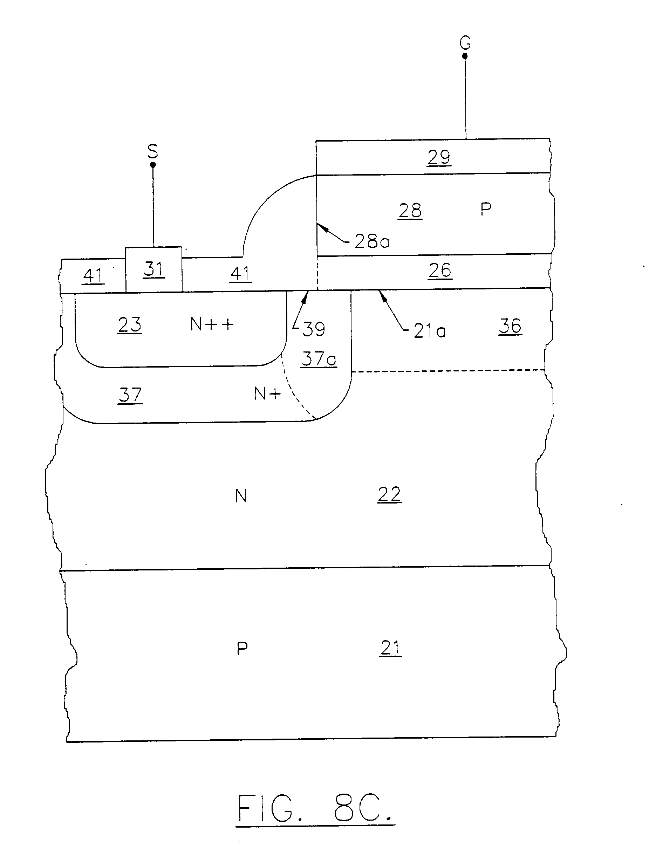

Figure 8A illustrates Case 1 where the gate sidewall spacer **41** is silicon nitride, while the gate insulator **26** is silicon dioxide. The gate insulator **26** is also shown to slightly overlap the tip of the injector **37a** at interface **39.** Case 2, Figure 8B, illustrates the gate sidewall spacer **41** as silicon nitride and the gate insulator **26** as silicon dioxide. In this case, the gate insulator **26** does not overlap the source injector region **37a** at interface **39**, but is contiguous with its edge. Case 3, Figure 8C, illustrates both gate sidewall spacer **41** and gate insulator **26**, of silicon dioxide. This structure is also constructed such that the edge of the polysilicon gate **28** slightly overlaps the source injector region **37a** at interface **39**. In all cases, the effective channel length was 0.71µm.

As shown in Figure 7, Case 1 produces the greatest drain saturation current with the least pinch-off voltage. It has also been found that Case 1 yields the lowest sub-threshold bottom current for any drain voltage. Case 1 also satisfies the conditions specified by Equations (24) and (25). Accordingly, Case 1 is preferred, so that the gate insulating region **26** extends partially over source injector region **37a** at interface **39**, and the gate sidewall spacer region 41 has greater permittivity than gate insulating region **26**.

Low Leakage Current Fermi Threshold Field Effect Transistor

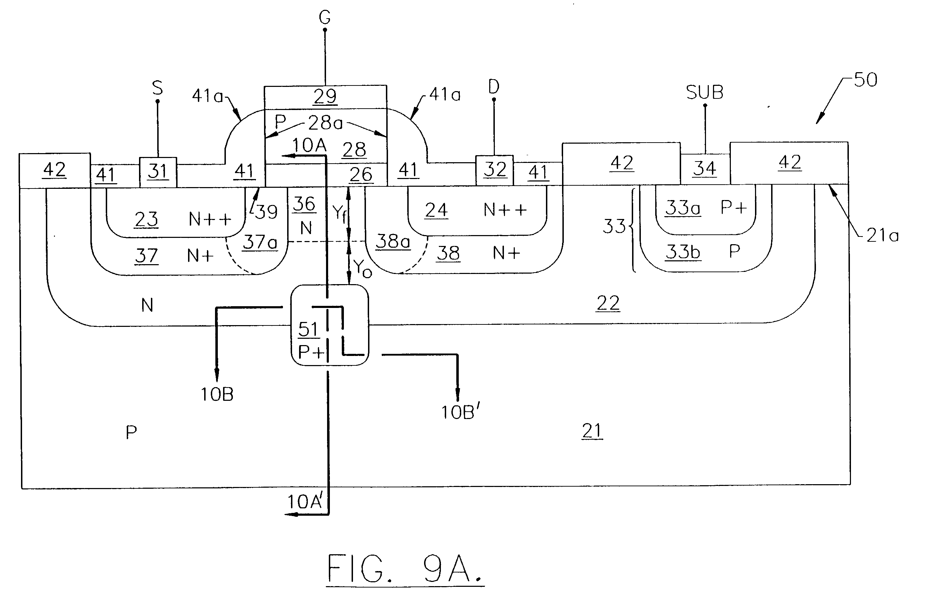

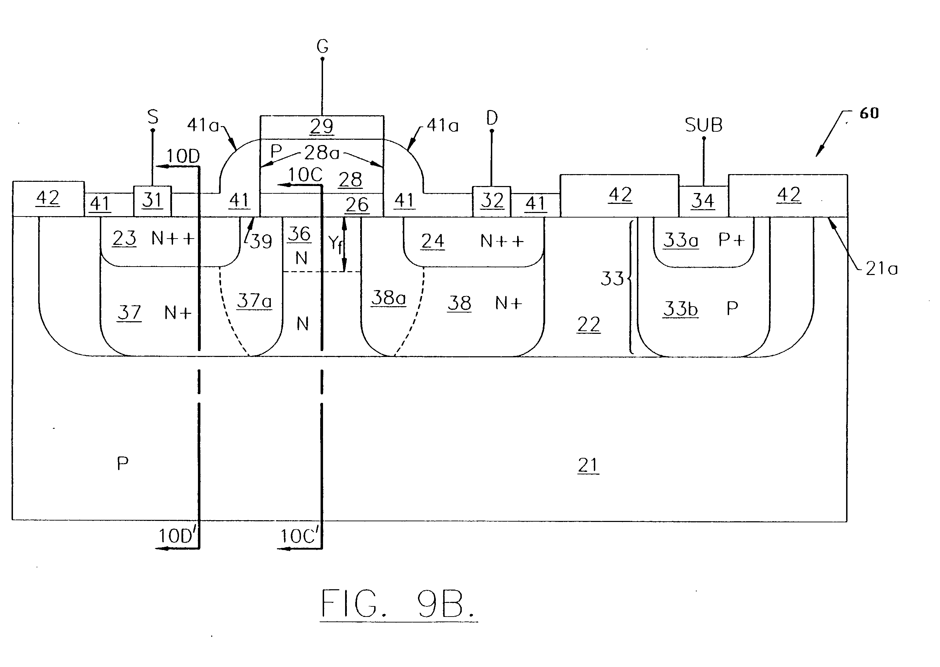

Referring now to Figures 9A and 9B, Fermi-FETs which have short channels yet produce low leakage current according to the present invention, will now be described. These devices will hereinafter be referred to as "low leakage current Fermi-FETs". The low leakage current Fermi-FET **50** of Figure 9A includes a bottom leakage current control region **51** of first conductivity type, here P conductivity type, and doped at a high concentration relative to the substrate **21** Accordingly, it is designated as P+ in Figure 9A. The low leakage current Fermi-FET **60** of Figure 9B includes extended source and drain injector regions **37a, 38a,** which preferably extend to the depth of the Fermi-tub **22.**

Referring now to Figure 9A, bottom leakage current control region **51** extends across the substrate **21** from between an extension of the facing ends of the source and drain regions **23** and **24**, and extends into the substrate from above the depth of the Fermi-tub **22** to below the depth of the Fermi-tub. Preferably, it is located below, and in alignment with the Fermi-channel **36.** For consistency with the equations previously described, the depth from the Fermi-channel **36** to the top of the bottom current leakage current control region **51** has been labelled $Y_o$. The remainder of the Fermi-FET transistor of Figure 9A is identical with that described in Figure 1, except that a shorter channel is illustrated. It will be understood by those having skill in the art that the gate sidewall spacer region **41** may be omitted to provide a low leakage current low capacitance, short channel Fermi-FET without the high current properties of the device of Figure 9A.

The bottom leakage current control region **51** minimizes drain induced injection in short channel Fermi field effect transistors, i.e. those field effect transistors having a channel length of approximately 0.5 µm or less, while maintaining low diffusion depletion capacitance. For example, at 5 volts, leakage current of 3E-13A or less may be maintained.

The bottom leakage current control region may be designed using Equation (2) where $Y_0$ is the depth from the channel to the top of the bottom leakage control region as shown in Figure 9. Factor $\alpha$ is the ratio between the P+ doping of the bottom leakage current control region **51** and the N doping of the Fermi-tub **22.** Preferably $\alpha$ is set to about 0.15 within the bottom leakage control region, i.e. below the gate **28.** Below the source and drain regions **23** and **24**, $\alpha$ is set to about 1.0 to minimize diffusion depletion capacitance. In other words, the doping concentrations of substrate **21** and Fermi-tub **22** are about equal in the regions below the source and drain. Accordingly, for the design parameters described above, and for a channel width of 0.5 micron, the doping concentration in the bottom leakage control region **51** is approximately 5E17 and is deep enough to support partial depletion at the tub-junction region given 5 volt drain or source diffusion potential.

Referring now to Figure 9B, an alternative design for bottom leakage control extends the depth of source injector region **37a** and drain injector region **38a,** preferably to the depth of the Fermi-tub ($Y_f + Y_o$). As shown in Figure 9B, the depth of the entire source injector tub **37** and drain injector tub **38** may be extended, preferably to the depth of the Fermi-tub. The separation distance between the bottom of the injector tubs **37** and **38** and the bottom of the Fermi-tub **22** is preferably less than half the channel length and preferably approaches zero. Under these conditions, injector tubs **37** and **38** have doping concentration of about 1.5E18/cm$^3$. The depth of substrate contact region **33b** also preferably is extended to approach the Fermi-tub depth. The remainder of the Fermi-FET transistor **60** of Figure 9B is identical with that described in Figure 1, except that a shorter channel is illustrated.

**Design of 0.5µm Low Leakage Current Fermi-FET**

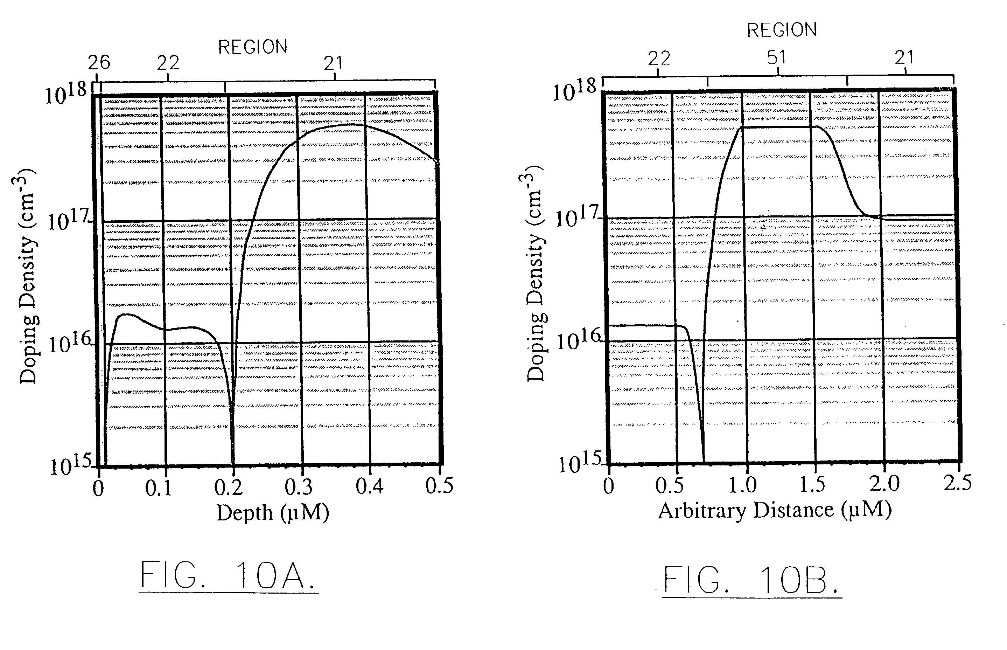

Referring now to Figures 10A-10B, preferred doping profiles and geometries for designing a 0.5µm channel low leakage current Fermi-FET as illustrated in Figure 9A will now be described. It will be understood by those having skill in the art that both N and P channel FETs are fabricated in a similar fashion. All geometries and doping profiles are identical to those described in Figures 2A-2C, except that the length of channel region **36**, between facing surfaces of injector regions **37a** and **38a,** is 0.5µm rather than 0.8µm, and the bottom leakage control current control region **51** is added as already described. It is well known to those having skill in the art how to achieve these doping profiles, using many well known techniques.

Figure 10A illustrates a vertical doping profile along line **10A-10A'** of Figure 9A and centered about the channel **36.** The region to which the profile applies is also labelled at the top of the horizontal axis of Figure 10A. As shown, bottom current leakage current control region **51** extends from 1950Å to 4000Å in depth from the top face **21a** of substrate **21**. Accordingly, it is centered about the interface between Fermi-Tub **22** and substrate **21**. Doping concentration is 5E17. In contrast with Figures 2A-2C, the substrate **21** is doped at 1E17.

Figure 10B illustrates a doping profile along line **10B-10B'** of Figure 9A. As shown, bottom leakage current control region **51** extends horizontally between source injector region **37a** and drain injection region **38a** for about the same length as the channel length, i.e. about 0.5μm.

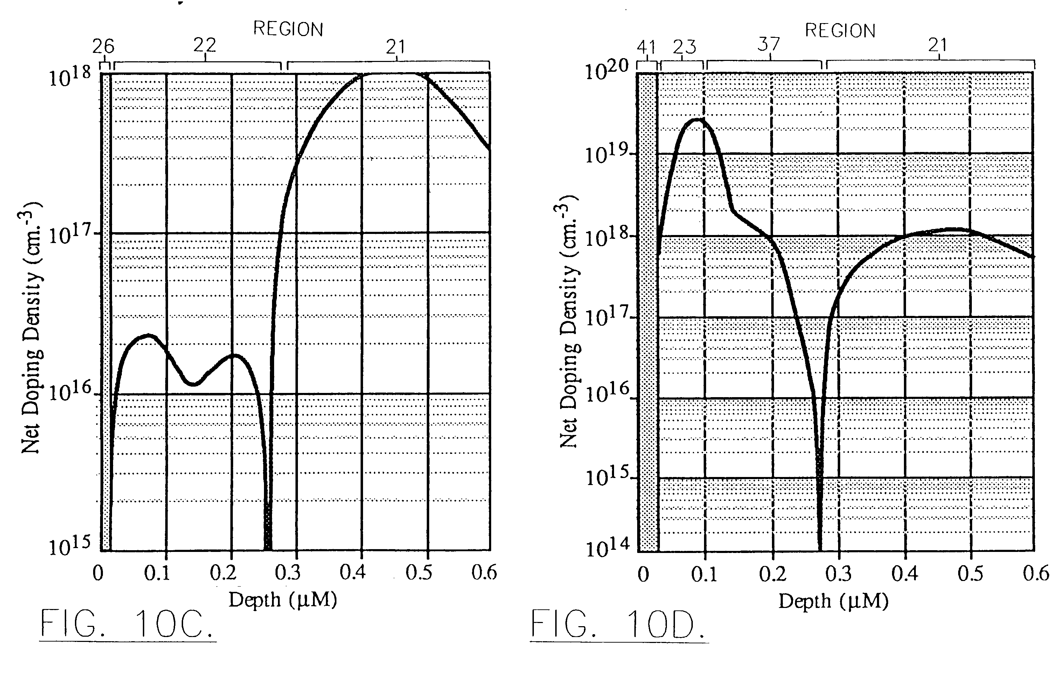

Referring now to Figures 10C-10D, preferred doping profiles and geometries for designing a 0.5μm channel low leakage current Fermi-FET as illustrated in Figure 9B will now be described. It will be understood by those having skill in the art that both N and P channel FETs are fabricated in a similar fashion. All geometries and doping profiles are identical to those described in Figures 2A-2C except that the depths of source injector region **37**, drain injector region **38** and substrate contact **33b** have been extended to the tub depth of about 2000Å, and the length of channel region **36,** between facing surfaces of injector regions **37a** and **38a,** is 0.5μm rather than 0.8μm.

Figure 10C illustrates a vertical doping profile along line **10C-10C'** of Figure 9B and centered about the channel **36.** As shown, substrate concentration is about 1E18. Figure 10D illustrates a doping profile along line **10D-10D'** of Figure 9B. As shown, the source injector tub **37** extends to the depth of the Fermi-tub.

### Operation of the Bottom Leakage Current Control Region

The operational theory of the bottom leakage current control region **51** of Figure 9A, and the deep injection regions of Figure 9B, to lower leakage current in short channel devices, will now be described. Subthreshold considerations will first be described to define the terms which apply to bottom leakage current. A discussion of how injector tub depth influences bottom leakage current will then be provided as well as a discussion of drain induced injection and drain field threshold lowering.

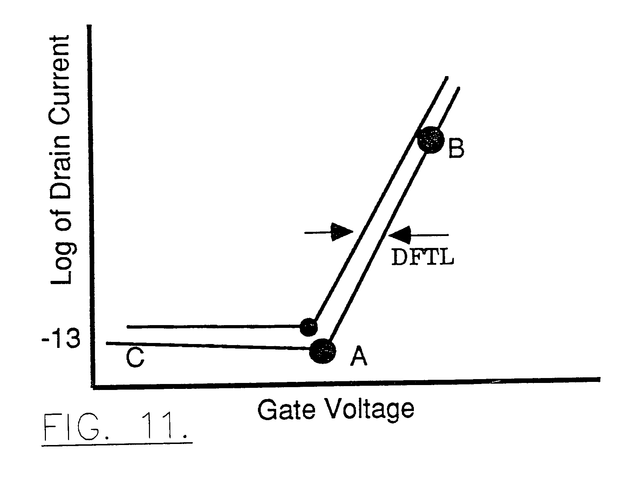

In solving the equations that describe the sub-threshold behavior of the Fermi-FET, some new definitions are needed. Figure 11 graphically illustrates basic behavior. There are four primary features of sub-threshold current behavior. These behavior regions are labeled A, B, and C and $D_{FTL}$ in Figure 11. Point A defines "sub-threshold threshold, $V_{stt}$. Point B defines normal conduction threshold. Point C defines "bottom leakage current" as influenced by drain voltage. Finally, the arrows for $D_{FTL}$ defines "drain field threshold lowering". Sub-threshold threshold occurs when the injecting gate field is zero.

Referring again to Figures 9A and 9B, bottom leakage current dependence on drain voltage is a result of a drain field component that terminates on the source injector diffusion **37a** facing the channel **36**. This source terminated drain field causes carrier injection into the channel **36**. This sub-threshold effect is called "drain induced injection", DII.

DII is a characteristic property of majority carrier Fermi-FET and buried channel field effect devices. Below threshold, the majority carrier channel **36** and Fermi-tub region **22** do not contain charge sites that prevent the drain field from extending across the channel region. As a consequence, the drain field can terminate in the source depletion region facing the channel and cause injection.

In contrast, minority carrier MOS devices require the substrate region to intercede between the source and drain. Drain field is therefore terminated by ionizing the substrate region adjacent the drain diffusion facing the channel. If the substrate region is completely depleted between the source and drain diffusions, the well known punch-through phenomenon occurs leading to abrupt and high injection current.

In summary, MOS device design is troubled by punch-through and threshold problems. Buried channel devices are troubled by both punch-through and DII. However, Fermi-FET devices are troubled only by DII conditions, which can be substantially reduced by the bottom leakage current control region or by increasing the depth of the injector regions **37** and **38**. The significant current and speed advantages of the Fermi-FET compared to MOS and buried channel devices far outweigh the design constraints needed to control DII in the former as opposed to eliminating punch-through and threshold troubles in the latter. Both problems become more significant as channel length is shortened.

The following analysis describes the impact of injector depth $Y_d$ on diverting drain field contour lines in majority carrier Fermi-FET devices. The bottom leakage current control region **51** of Figure 9A or the deep injector tubs of Figure 9B virtually eliminate DII.

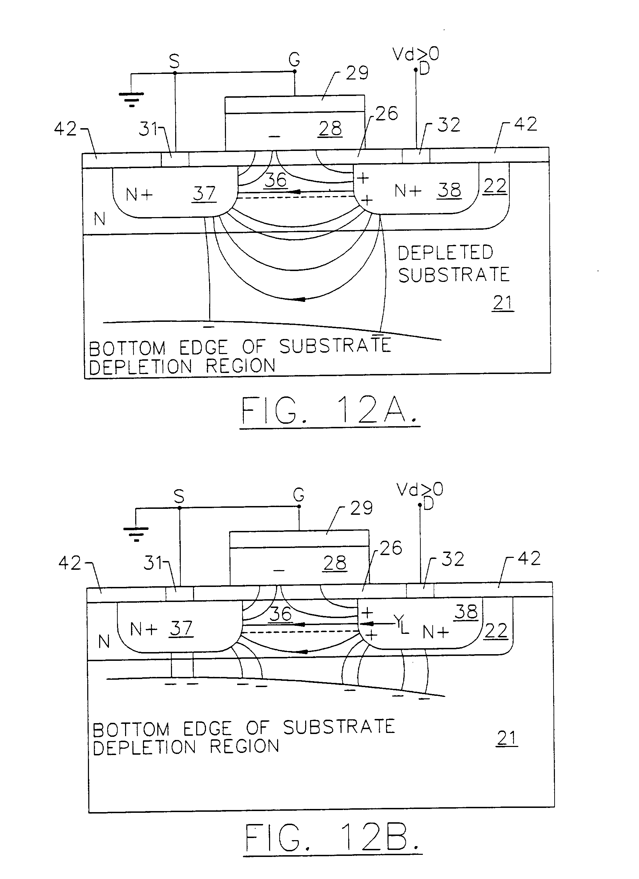

Figure 12A illustrates field contour lines that occur when Drain Induced Injection becomes a problem in a low capacitance Fermi-FET, including a Fermi-tub **22** and injectors **37**, **38** and no sidewall spacer **41**. Specifically, the bottom corner region of the injector tubs contribute to excessive DII due to field crowding there. Figure 12B illustrates proper corrective measures that minimize the effect, by moving the bottom edge of the substrate depletion region **21** closer to the bottom of the source and drain injector tubs **37**, **38**. The bottom current leakage control region **51** of Figure 9A also accomplishes this result.

There exists some depth $Y_L$ at the drain injector **38** facing the channel **36** at which the contour integral of the drain electric field terminating on poly gate surface **28** equals the contour integral of the drain field terminating in the substrate region **21**. At that point, drain field can terminate at the source **23**, facing the channel region. There is an injector tub depth that minimizes the number of field lines that can terminate on the source injector **37**. This requirement suggests that $\alpha$ be less than 1. Typically, $\alpha<Lo/2$. When designing Fermi-FET devices, Equation (31) derived below, should be considered. Predicted depth $Y_L$ should not exceed the depth of the injector, otherwise considerable bottom leakage current will flow from the bottom and corners of the diffusions in the sub-threshold regime. Equation (32) derived below, produces minimum bottom current.

Equation (32) also predicts the basic design criteria for the original Fermi-FET as defined by U.S. Patents 4,990,974 and 4,984,043. Specifically, when $Y_{tub} = Y_o$ and $Y_o=Y_p$, then $\alpha=1$ and $Y_L=Y_o$. In other words, for that case, the diffusion depth $Y_d$ should be the same as the Fermi channel depth $Y_o$. $Y_p$ is the depletion depth in the substrate region.

Equation (32) will now be derived. Let $R_1$ be an effective radius for the field lines that terminate on the polysilicon gate electrode **28**. Let $R_2$ be an effective radius for the field lines that terminate in the substrate region **21**. Let $E_d$ be the drain field along these field lines. The electric field between diffusions is nearly uniform in the sub threshold region as compared to the electric field that terminates in the substrate region below the diffusions.

$$\frac{\pi}{2}R_1 E_{sd}+T_{ox}E_{sd}\frac{e_s}{e_i}=V_d+V_{pj} \tag{26}$$

$$\frac{\pi}{2}R_2 E_{sd}=V_d+V_w \tag{27}$$

$$R_2=Y_{tub}+Y_p-Y_L \tag{28}$$

$$R_1=Y_L \tag{29}$$

Using Equations (26)-(29) the following expression is obtained:

$$E_d\left[\frac{\pi}{2}\left(R_1-R_2\right)+\frac{e_s}{e_i}T_{ox}\right]+V_w-V_{pj}=0 \tag{30}$$

where $V_w$ = well potential KT/q ln(N^/Ns), and $V_{pj}$ = polysilicon gate electrode junction potential KT/q ln(N^/N_{poly}) If $V_w=V_{pj}$, then:

$$Y_L\geq\frac{Y_{tub}+Y_p-\frac{2e_s}{\pi e_i}T_{ox}}{2} \tag{31}$$

Equation (31) is independent of field strength $E_d$. Substrate depletion depth $Y_p$ should be small by design.

Punch-through is a serious problem for short channel MOS and buried channel devices. High substrate doping is required to minimize the effect. In all FET structures, a second drain induced phenomenon occurs: "drain field threshold lowering", DFTL. Simply explained, DFTL is the result of insulator potential developed near the source end of the channel as a result of the electric field produced by drain voltage that is terminated by the gate when gate voltage is below drain voltage. This drain induced insulator potential is always in a direction to reduce threshold voltage. Punch-through is eliminated by the low capacitance Fermi-FET, however DFTL remains. An expression for the change in threshold voltage $\Delta Vt$ due to DFTL is given below and only applies when drain voltage is greater than gate voltage:

$$\Delta V_t = \frac{V_d - (V_g - V_{fb})}{1 + \dfrac{e_i (L_o + X_d)}{E_s T_{ox}}} \tag{32}$$

where $L_o$ is channel length and $X_d$ is diffusion depth.

The effects of DFTL increase by the amount drain voltage exceeds gate voltage and is more pronounced at low gate voltage as channel length is shortened. Thinning down gate insulator thickness proportionately reduces the effect.

A method of experimentally measuring the effects of DFTL is to plot sub-threshold behaviour of the device. See Figures 6A and 6B. DFTL accounts for the left voltage translation of the rising curve, $Log_{10}I_{ch}$, increasing drain voltage $V_d$.

High Saturation Current Fermi-FET

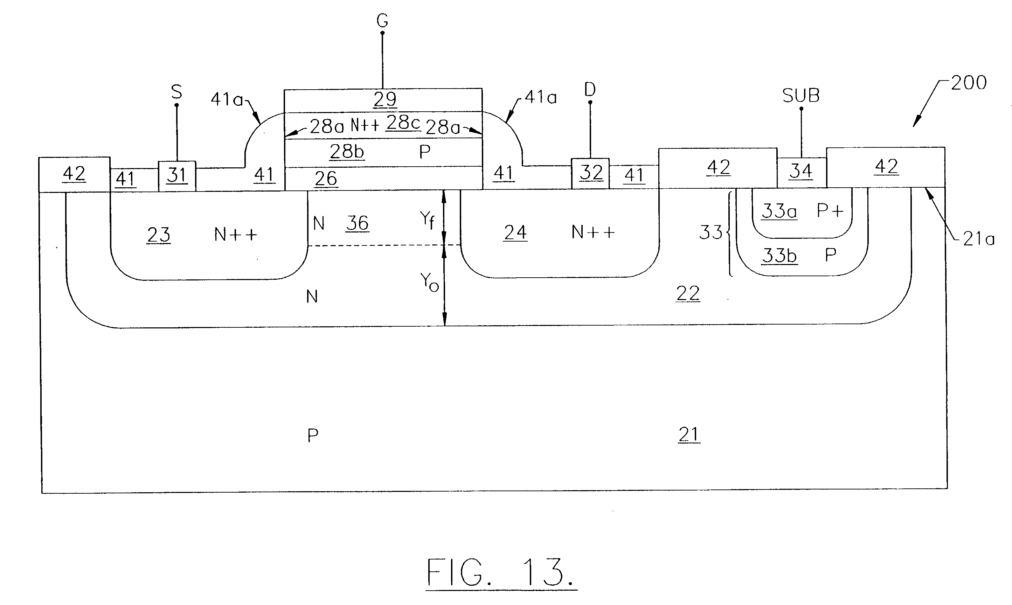

In order to more adequately explain the present invention reference will now be made to another high saturation current Fermi-FET which is illustrated Figure 13. The high saturation current Fermi-FET **200** is similar to Fermi-FET **20** of Figure 1 except that source tub regions **37** and drain tub regions **38** are not illustrated. However, it will be understood by those having skill in the art that these regions may be used as described previously. Also, gate electrode layer 28 includes a first layer **28b** of first conductivity type, here P type and a second layer **28c** of second conductivity type, here N + + type according to US-A-5 371396 entitled *Field Effect Transistor Having Polycrystalline Silicon Gate Junction* to inventors Vinal and Dennen, and assigned to the assignee of the present invention, the disclosure of which is hereby incorporated herein by reference. However, it will be understood by those having skill in the art that a single layer gate **28** may also be used.

The second conductivity doping (here N++) of the source region **23** adjacent channel **36** is maintained at a minimum which is sufficiently high to maximize the saturation current of the field effect transistor. Preferably, the doping of the source region **23** and the drain region **24** facing channel **36** is maintained at this minimum doping, and most preferably the doping of the entire source and drain regions **23** and **24** respectively are maintained at this minimum doping. Of course, greater doping levels may be used, but will do little to enhance the saturation current of the transistor.

The concentration in the channel region **36** may be greater than or less than that of the tub region **22,** and is less than that of the source and drain regions **23** and **24.** The ends of the channel region **36** preferably abut the source and drain diffusions **23** and **24,** or the source and drain tubs if present. The source and drain regions are at least as deep as the channel **36** and preferably less than the depth of the tub **22.**

The substrate region **21** is the same conductivity type as the doped polycrystalline silicon gate **28b** adjacent the gate insulator **26.** The substrate **21** has a doping concentration which is higher than, and preferably at least four times higher than, the tub **22** doping concentration.

It will now be shown that the drain saturation current of the Fermi-FET transistor **200** is controlled by the diffusion doping concentration of the source **23** and drain **24** adjacent the channel **36.** The highest drain saturation current is reached, for a given doping concentration, when no perpendicular electric field is allowed to cross the channel **36.** Thus, for a given channel length, the diffusion concentration has a minimum value beyond which drain saturation current ceases to increase.

Accordingly, it is not necessary to fabricate very short channel Tub-FETs to achieve high drive current. For example, if a Tub-FET with 0.8 micron channel length is optimized for maximum drive current, the fabrication of devices with a shorter channel does little to increase drive current. Drain saturation currents of 16 amperes per centimeter and 9 amperes per centimeter for N and P channel devices, respectively, can be achieved from Tub-FET device designs using power supply voltages of magnitude value between 0 and 5 volts. To achieve these current levels, gate insulator layer **26** thickness of 100Å Silicon Nitride or 50Å Silicon Dioxide or other gate insulating materials with equivalent gate capacitance effects, is required.

Gate capacitance of T-FETs depends on mobile channel charge $Q_{ch}$ per unit gate voltage (Vg-Vt). Gate capacitance is therefore proportional to accumulation efficiency. It has been demonstrated according to the invention that high accumulation efficiency can occur if excess charge can be stored in the source and/or drain diffusion injection area facing the channel. Thus,

$$\phi_x = \frac{KT}{q} \ln\!\left(\frac{N_{do}}{N_{ch}}\right) \tag{33}$$

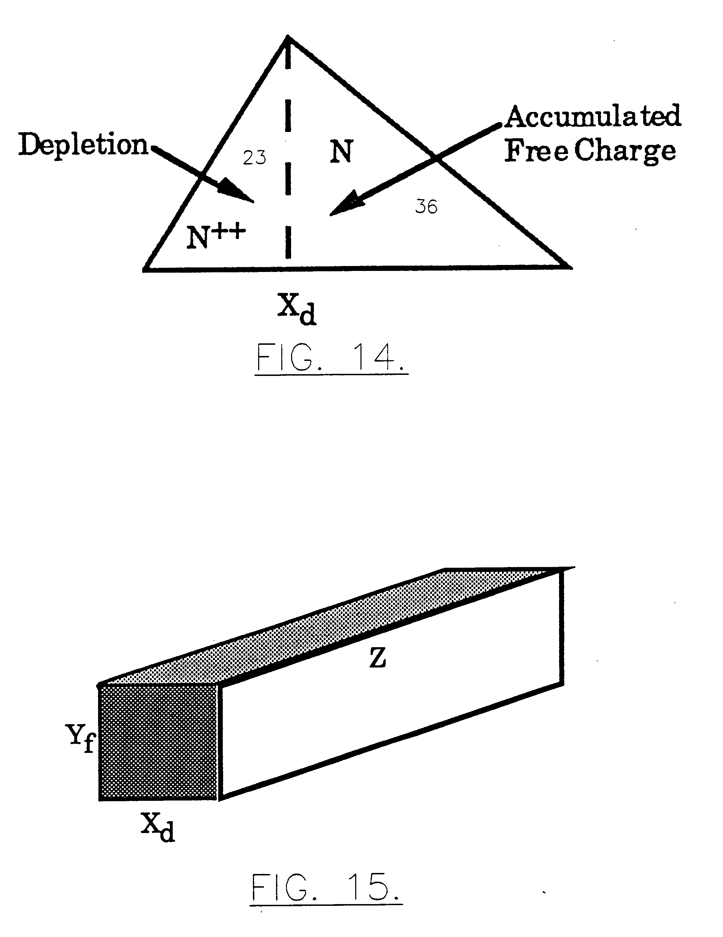

Where $\phi_x$ is the flat band potential between the source/drain diffusions and the channel, $KT/q = 26$ mV at room temperature, $N_{do}$ is the source doping concentration and preferably also the drain doping concentration, facing channel **36,** and $N_{ch}$ is the doping concentration of channel **36.** This is graphically illustrated in Figure 14.

The minimum depth $X_d$ of the diffusion depletion region is approximated below. The accumulation free charge is identical in value, and opposite in sign, to the total charge in the diffusion depletion region facing the channel:

$$X_d=\sqrt{\frac{2e_s\frac{KT}{q}\ln\left(\frac{N_{do}}{N_{ch}}\right)}{qN_{do}}} \tag{34}$$

Where $e_s$ is the permittivity of the substrate and q is $1.6 \times 10^{-19}$ coulombs.

Figure 15 illustrates an equivalent volume of excess carriers available within the reservoir volume that is free to be accumulated into the channel region. In Figure 15, $Y_f$ is the depth of channel **36** and Z is the width of channel **36.** The following discussion ignores free charge. This component of free charge is discussed subsequently.

The maximum reservoir of free accumulatable charge $Q_r$, is:

$$Q_r=qN_{do}X_dY_fZ \tag{35}$$

Substituting Equation (34) for $X_d$ one obtains

$$Q_r=Y_fZ\sqrt{2e_s\phi_xqN_{do}} \tag{36}$$

Where $\phi_x$ is given by Equation (33).

Equation (36) defines the available excess charge for injection. When maximum gate voltage $V_{gmax}$ is applied, above the threshold value, this total available charge must be capable of filling up the channel. When both the source and drain regions are at ground potential, each accumulation reservoir must be capable of filling up half of the channel. As free charge flows into the channel, carriers diffuse across the N++/$N_{ch}$ junction to replace them. The effective channel volume $V_{ch}$ that is filled per diffusion is:

$$V_{ch}=\frac{Z\delta L_o}{2} \tag{37}$$

Therefore the charge transferred to the channel is:

$$Q_{ch}=\frac{q}{2}N_{chex}Z\delta L_o \tag{38}$$

where

$N_{chex}$ = Channel excess carrier concentration
$\delta$ = flow depth of excess carriers.
$L_o$ = Channel length
$Z$ = channel width

It can be shown that channel charge is also related to gate capacitance and gate drive voltage (Vg-Vt). The following equality exists:

$$C_g^*ZL_o(V_g-V_t)=qN_{chex}\delta ZL_o \tag{39}$$

Therefore

$$qN_{chex}\delta=C_g^*(V_g-V_t)=Q_{ch}^* \tag{40}$$

where $Q_{ch}^*$ is the charge per unit volume.

A basic expression for channel saturation current $I_{sat}$ can be written as follows:

$$I_{sat}=C_g^*(V_g-V_t)ZV_L \tag{41}$$

where $V_L$ is the lateral velocity.

The conditions that control lateral velocity $V_L$ are discussed below. Substituting Equation (40) into Equation (38), an important expression that defines accumulated channel charge due to the source diffusion is found:

$$Q_{ch}=\frac{C_g^*}{2}ZL_o(V_g-V_t) \tag{42}$$

Equating Equation (36) to the available channel charge in Equation (42):

$$Y_fZ\sqrt{2e_s\phi_xqN_{do}}=\frac{C_g^*}{2}ZL_o(V_g-V_t) \tag{43}$$

Equation (43) can be solved for actual gate capacitance $C_g^*$ in terms of the diffusion impurity concentration $N_{do}$ and the depth $Y_f$ of the channel region:

$$C_g^*=\frac{2Y_f\sqrt{2e_s\phi_xqN_{do}}}{L_o(V_{gmax}-V_t)}F/cm^2 \tag{44}$$

where:

$Y_f =$      Depth of the Fermi channel adjacent the source and drain diffusions

$N_{do} =$      Average diffusion impurity concentration in depth from the substrate-insulator interface **21a** to the bottom of the Fermi channel.

$L_o =$      Channel length

$e_s =$      Permittivity of substrate

$\phi_x =$      Given by Equation (33)

$V_{gmax} =$      Maximum gate voltage anticipated

$V_t =$      Threshold voltage

Gate capacitance has a maximum value as determined by independent analysis and is given below:

$$C_{gmax}^*=\frac{1}{\dfrac{T_{ox}}{e_i}+\dfrac{\delta}{2e_s}}=\frac{2e_ie_s}{2e_sT_{ox}+\delta e_i} \tag{45}$$

The ratio of Equation (44) to Equation (45) provides an expression for gate capacitance factor $G_f$:

$$G_f=\frac{Y_f(2e_sT_{ox}+\delta e_i)\sqrt{2e_s\phi_xqN_{do}}}{e_se_iL_o(V_{gmax}-V_t)} \tag{46}$$

According to Equation (41), maximum saturation current occurs for a given lateral velocity, when gate capacitance factor $G_f = 1.0$.

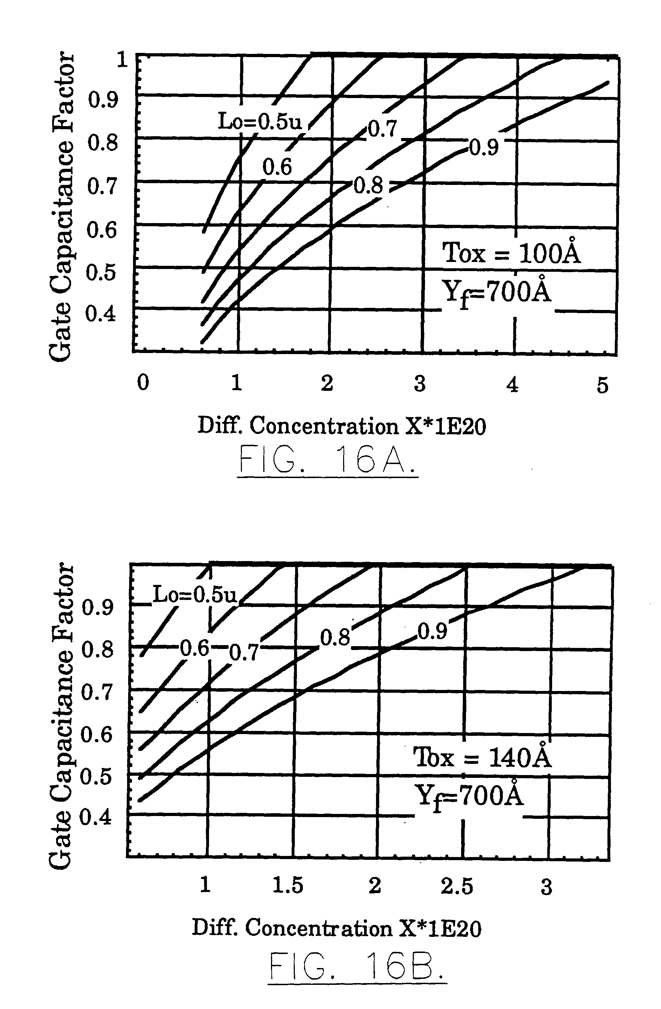

Figures 16A and 16B graphically illustrate Equation (46) as a function of source/drain diffusion concentration $N_{do}$ for different channel lengths $L_o$, given $Y_f \approx 600$Å, $V_{gmax} = 5$V, $V_t = 0.8$V, flow depth $\delta = 120$Å, and $T_{ox} = 100$Å for

Figure 16A and 140Å for Figure 16B. Figures 16A and 16B reveal that there is a critical concentration $N_{do}$ that is required to achieve maximum saturation current and this value is different for different channel lengths $L_o$. This maximum occurs when gate capacitance factor $G_f = 1.0$. this maximum depends primarily on channel length $L_o$ and insulator thickness $T_{ox}$. The following expression defines this criticality.

$$N_{do_{min}} = \frac{1}{2e_s\phi_x q}\left[\frac{e_s e_i L_o (V_{g_{max}} - V_t)}{Y_f(2e_s T_{ox} + \delta e_i)}\right]^2 \qquad (47)$$

When designing Fermi Tub-FETs, Equation (47) should be applied to the longest channel $L_o$ possible. Under these circumstances, Tub-FETs with shorter channel length will have essentially the same drain saturation current for the same gate voltage. Very little is to be gained in terms of drive current by making short channel devices. Fermi Tub-FETs designed with 0.8 micron channel length or less have much higher drive current for a given gate voltage than MOS or MOS buried channel device designs at any channel length.

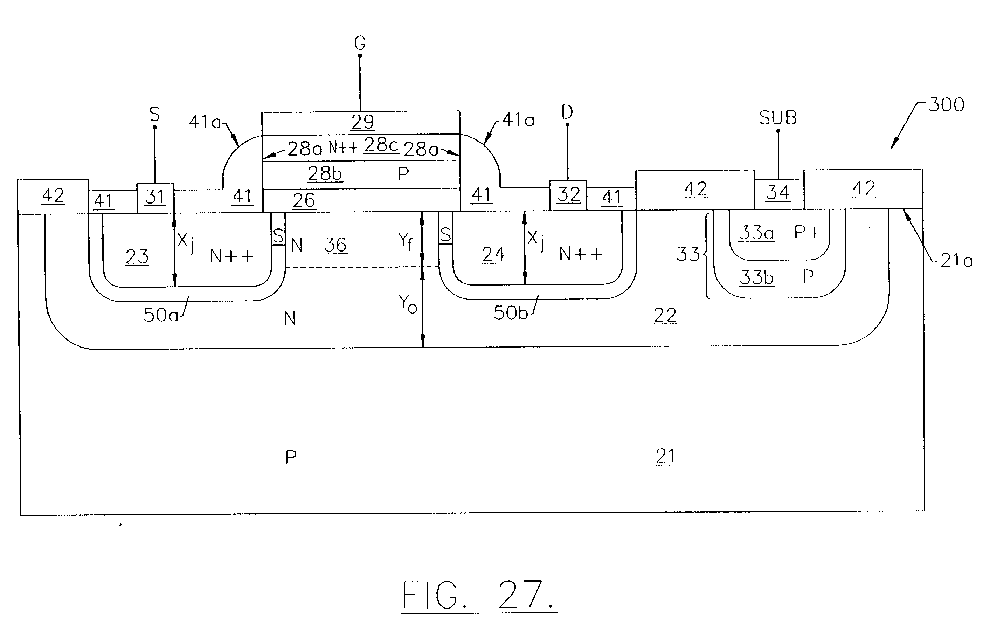

In order to more adequately explain the present invention reference will now be made to yet another high saturation current Fermi-FET which is illustrated in Figure 27. The high saturation current Fermi-FET **300** of Figure 27 is similar to Fermi-FET **200** of Figure 13 except that source doping gradient region **50a,** and preferably drain doping gradient region **50b,** are added between the source region **23** and the channel **36** and between the drain region **24** and the channel **36,** respectively. The source doping gradient region **50a,** and preferably the drain doping gradient region **50b,** are doped at a doping gradient which decreases from the relatively high source/drain doping concentration adjacent the source and drain regions to the relatively low doping concentration of channel **36** adjacent channel **36.**

It has been found that the source doping gradient region **50a,** and the drain doping region **50b,** preferably have a thickness S of at least 300A in order to support high saturation current in the Tub-FET **300.** Also preferably, as shown in Figure 27, the gate insulating region **26** and the gate electrode **28,** overlap the source and drain doping gradient regions **50a** and **50b.** As also shown in Figure 27, source doping gradient region **50a** and drain doping gradient region **50b** preferably surround source **23** and drain **24,** respectively.

The theoretical reasons as to why high saturation currents are provided when the source and drain gradient regions **50a** and **50b** respectively, exceed 300A in thickness will now be described. It will also be shown that when used with a source and drain gradient region, a minimum source and drain doping level is as already described in Equation (47) with a substitution of the source and drain depth $X_j$ rather than the Fermi channel depth $Y_f$, when the source and drain are deeper than the Fermi channel; i.e. when $X_j$ is greater than $Y_f$.

It has already been shown that high accumulation efficiency occurs with proper access to free charge stored in the diffusion gradient facing the Fermi-Tub channel region **36** between source and drain diffusions **23** and **24** respectively. At threshold, the Fermi-Tub region **22** may be completely depleted from the bottom to the substrate surface **21a** facing the gate insulator as a result of the P-N junction between the Fermi-Tub **22** and substrate **21.** Depleting the Fermi-Tub in this manner, eliminates any junction electric field from crossing the surface channel region **36** during majority carrier conduction.

The source/drain diffusion concentration $N_{do}$ and gradient depth S required to provide an adequate reservoir of charge at the edge of the diffusion in the depletion environment will now be determined. Given maximum gate voltage above threshold, an adequate charge reservoir will fill half the channel volume of length $L_o$ with sufficient majority carriers to achieve the limiting gate capacitance value $C_g^*$, where $C_g^*$ is defined as:

$$C_g^* = \frac{1}{\dfrac{T_{ox}}{e_i} + \dfrac{\delta}{2e_s}}$$

Where;

  $T_{ox}$ = gate insulator **26** thickness
  $\delta$ = carrier flow depth
  $e_s$ = substrate **21** permittivity
  $e_i$ = insulator **26** permittivity

Referring to Figure 27, when the gate electrode **29** is at threshold or below, the substrate-Tub junction completely depletes the Fermi-Tub region up to the gate insulator **26** and a portion of the perimeter of the doping gradient regions **50a, 50b** facing the Fermi-Tub. The diffusion impurity concentration $N_{do}$ and gradient thickness S must be sufficient to prevent the entire diffusion gradient thickness S from being consumed during depletion. The following analysis develops a fundamental expression that defines the requirements for diffusion design to achieve maximum drain saturation current from the Fermi FET for a given maximum gate voltage.

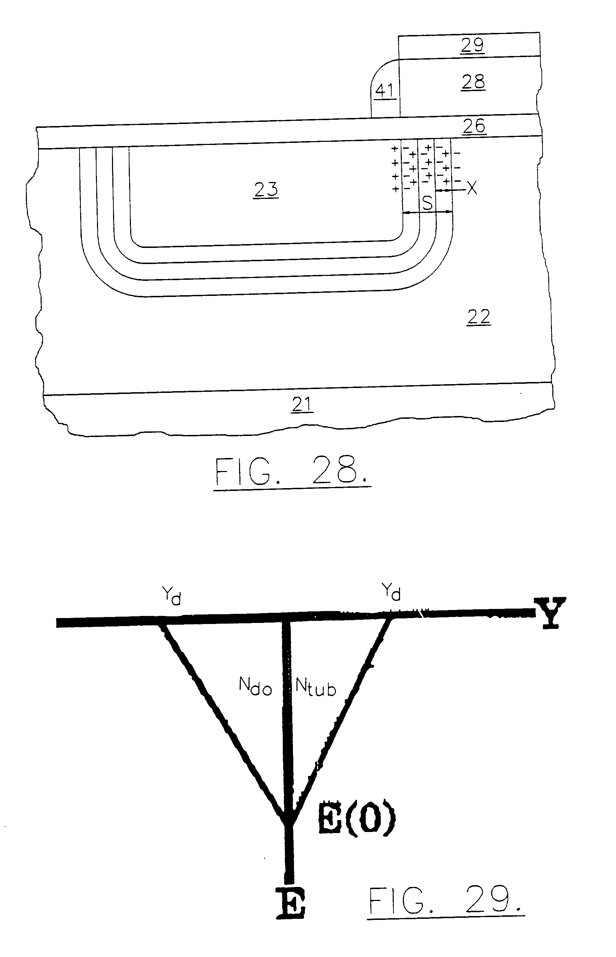

Figure 28 illustrates a diffusion perimeter whose concentration decreases discretely in steps from higher to lower concentration. This discrete model is useful in obtaining an expression for the diffusion design. Figure 28 illustrates that a dipole charge configuration occurs at each step. Bound positive charge is due to depletion in the diffusion region, and that free negative charge is lightly bound to the step junction. Charge neutrality must be observed at each step junction. The gate **28** overlaps the doping gradient regions **50a, 50b** as shown in the Figure 28.

As a result of the Tub-substrate junction, the depletion penetration distance into the doping gradient distance S is defined as X in the Figure 28. When depletion occurs, penetration distance X must be less than distance S. All free charge in distance X is unavailable for accumulation due to carrier diffusion across the substrate junction that is required to satisfy charge neutrality requirements there. Free charge is available in interval S-X to be accumulated within the surface channel when gate voltage is above threshold.

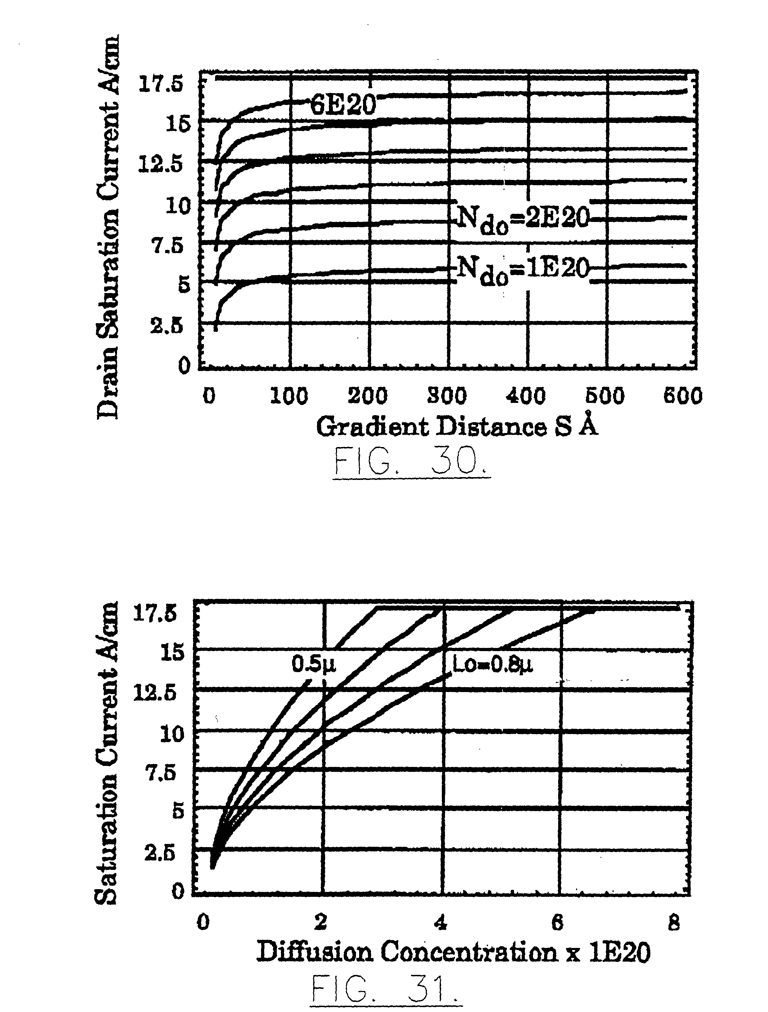

The total undepleted reservoir of distributed charge can be calculated from an abrupt junction between the Tub and diffusion is shown in Figure 29

$$Qtotal = qN_{do}X_jZY_d \tag{48}$$

Where;

$X_j$ = depth of the source/drain diffusion **23/24**
$Y_d$ = depletion depth in the diffusion
Z = channel width
$N_{do}$ = maximum source/drain diffusion **23/24** concentration

The total potential developed across the $N_{do}$-$N_{tub}$ junction is:

$$\phi_j = \frac{1}{2}(2Y_d)E(0) = \frac{KT}{q}\ln\left(\frac{N_{do}}{N_{ch}}\right) \tag{49}$$

Where;

$$E(O) = qN_{do}Y_{do}/e_s \tag{50}$$

Free charge is assumed to occupy the same depth $Y_d$. Combining Equations (49) and (50) produces:

$$\phi_j = \frac{qN_{do}}{e_s}Y_{do}^2 = \frac{KT}{q}\ln\left(\frac{N_{do}}{N_{ch}}\right) \tag{51}$$

Solving for $Y_{do}$:

$$Y_{do} = \sqrt{\frac{e_s\frac{KT}{q}\ln\left(\frac{N_{do}}{N_{ch}}\right)}{qN_{do}}} \tag{52}$$

Thus, the maximum available reservoir charge $Q_r$ is:

$$Q_R = X_j Z \sqrt{e_s q N_{do} \frac{KT}{q} \ln\left(\frac{N_{do}}{N_{ch}}\right)} \qquad (53)$$

This total charge is distributed along thickness S of the doping gradient region. Therefore free charge density $N_{fc} = Y_{do} N_{do}/S$ exists along the doping gradient region thickness S. When the doping gradient is depleted by distance X, Figure 28, as a result of depletion within the Tub from the Tub-substrate P-N junction, the reservoir of free charge $Q_r$ left available to fill half of the Fermi channel is:

$$Q_r = q Z X_j \int_X^S N_{FC} dx \qquad (54)$$

Where; $\int_o^S N_{FC} dX = Y_{do} N_{do}$.

Based on the definition of free charge density within the doping gradient, free charge $Q_r$ is:

$$Q_r = q N_{do} Z X_j Y_{do} \frac{(S-X)}{S} \qquad (55)$$

Substituting Equation (52) into Equation (55) a fundamental expression for the reservoir of free charge available to fill half the Fermi-channel may be found. Note that when drain and source voltage are both zero, the free charge in each doping gradient region of depth $X_j$ fills half the channel volume when gate voltage is above threshold. One should not depend on free charge at the bottom of the diffusion to fill the channel because of transit time considerations.

$$Q_r = \frac{Z(S-X)}{S} X_1 \sqrt{q N_{do} e_s \frac{KT}{q} \ln\left(\frac{N_{do}}{N_{tub}}\right)} \qquad (56)$$

Equating the reservoir of free charge $Q_r$ to that required to fill half of the channel $L_o/2$ given (Vg-Vt) at the maximum value, yields:

$$\frac{Z(S-X)}{S} X_1 \sqrt{q N_{do} e_s \frac{KT}{q} \ln\left(\frac{N_{do}}{N_{tub}}\right)} = C_g^* (V_{gmax} - V_t) \frac{L_o}{2} Z \qquad (57)$$

Solving Equation (57) for gate capacitance per square cm $C_g^*$, a fundamental expression that defines gate capacitance is obtained:

$$C_g^* = \frac{2(S-X) X_j}{S(V_{gmax} - V_t) L_o} \sqrt{q N_{do} e_s \frac{KT}{q} \ln\left(\frac{N_{do}}{N_{tub}}\right)} \qquad (58)$$

Next, penetration distance X into the doping gradient region thickness S as a result of depletion by the Tub-substrate P-N Junction will be determined. During the depletion process, charge must be conserved:

$$q\int_o^x N_d(x)dx = \sqrt{2e_s\phi_j qN_a\frac{N_{do}}{N_{do}+N_a}} \tag{59}$$

For purposes of this analysis, the doping gradient region is assumed to be linear in X i.e.:

$$N_d(x) = \frac{N_{do}-N_{tub}}{S}X + N_{tub} \tag{60}$$

and

$$\phi_j = \frac{KT}{q}\ln\left(\frac{N_{do}N_a}{N_i^2}\right) \tag{61}$$

Substitution of Equation (60) into Equation (59) produces:

$$q\int_o^x\left(\frac{N_{do}-N_{tub}}{S}x+N_{tub}\right)dx = \sqrt{2e_s\phi_j qN_a\frac{N_{do}}{N_{do}+N_a}} \tag{62}$$

The solution yields a quadratic in x:
The solution for Equation (63) is:

$$\frac{N_{do}-N_{tub}}{2SN_{tub}}x^2 + x - \sqrt{\frac{2e_s\phi_j N_a}{qN_{tub}^2}\left(\frac{N_{do}}{N_{do}+N_a}\right)} = 0 \tag{63}$$

$$x = \frac{SN_{tub}}{N_{do}-N_{tub}}\left[\sqrt{1+\frac{2(N_{do}-N_{tub})}{SN_{tub}}\sqrt{\frac{2e_s\phi_j N_a}{qN_{tub}^2}\left(\frac{N_{do}}{N_{do}+N_a}\right)}}-1\right] \tag{64}$$

Thus, Equation (64) is the solution for depletion penetration depth X into the doping gradient region. Note that X is a factor in Equation (58). Equation (64) is used in combination with Equation (58) to determine gate capacitance $C_g^*$, and therefore defines drain saturation current for the maximum anticipated gate voltage $V_{gmax}$. The proper source drain design is realized for a given channel length $L_o$ when Equation (58) reaches maximum gate capacitance $C_{gmax}^*$.

It may be seen from this analysis that gate capacitance $C_g^*$ and drain saturation current $I_{sat}$ are very low if inadequate channel charge is available for a given gate voltage $V_g$ above threshold voltage $V_t$. This follows since $Q_{ch}^* = C_g^*(V_g-V_t)$ and $I_{sat} = C_g^*(V_g-V_t)V_L Z$.

Figure 30 illustrates saturation current for an 0.8 micron N-Channel Fermi-FET with 50Å silicon dioxide or 100Å silicon nitride gate insulator thickness plotted as a function of doping gradient region thickness S in Ångstrom units. Source/drain doping concentration $N_{do}$ is the running parameter with 1500Å source/drain depth in all cases. It is significant to note that saturation current is virtually independent of gradient distance S greater than 300Å, irrespective of the concentration $N_{do}$ of the diffusion. It is also shown that saturation current increases as diffusion concentration increases.

Figure 31 illustrates saturation current for the same structure plotted as a function of source/drain doping concentration given doping gradient region thickness S=300Å or greater. Channel length $L_o$ is running parameter in Figure 31. It is shown that saturation current reaches a maximum value of about 17 A/cm given a gate voltage of 5 volts and a threshold voltage of 0.8 volts. Source/drain doping concentration above a critical value does not increase saturation current since the maximum value for gate capacitance $C_g^*$ has been achieved. Thin gate insulators place the highest demands on source/drain doping concentration to achieve maximum saturation current consistent with the chosen insulator thickness. Shortening the channel length of Fermi-FET devices relaxes the source/drain doping concentration requirements for the same maximum current. There is no other significant reason to shorten the channel length of a Fermi-FET.

Equation (58) is identical to Equation (47) with the exception that diffusion depth $X_j$ takes the place of Fermi depth $Y_f$ and (S-X)/S = 0.95 if S>300Å. See Equation (32). Therefore, the minimum diffusion concentration required to reach maximum current is identical to Equation (47) with $X_j$ substituted for $Y_f$. Diffusion depth $X_j$ may be used in place of Fermi depth $Y_f$ for all cases where $X_j>Y_f$.

## Fermi-FET with Reduced Threshold Voltage

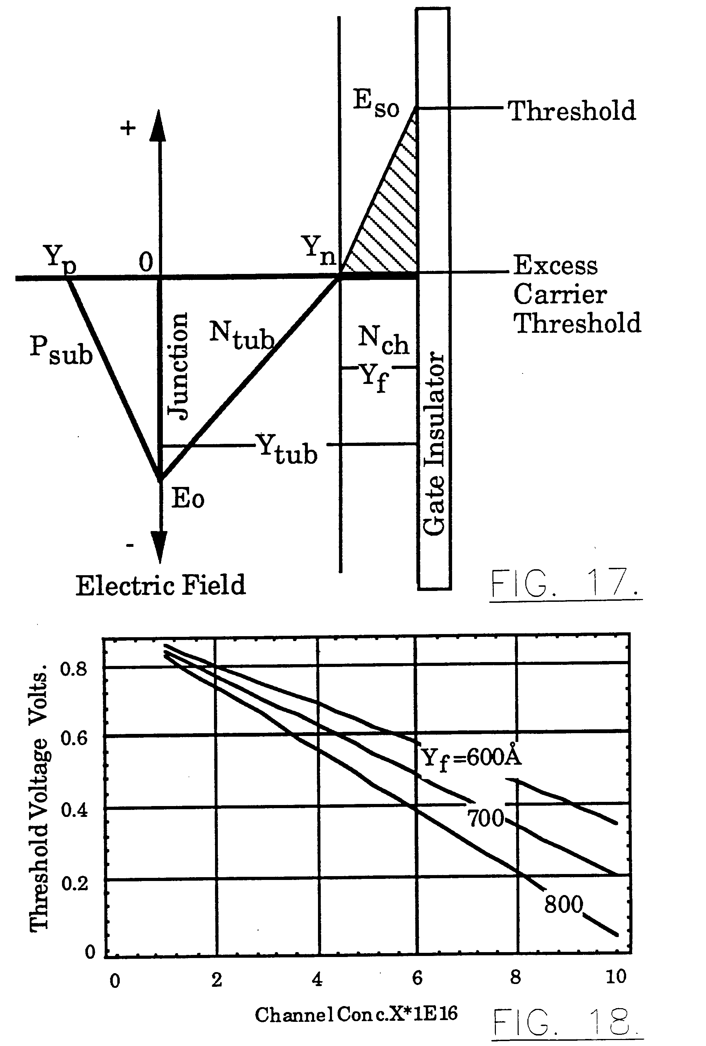

Referring again to Figure 13, channel **36** of Fermi-FET **200** has depth $Y_f$, typically about 600Å-700Å, and a doping concentration $N_{ch}$ per cubic centimeter. Figure 17 illustrates the perpendicular electric field diagram for the structure of Figure 13. The Tub depth $Y_{tub}$ is defined by the following equation:

$$Y_{tub}=Y_o+Y_f \tag{65}$$

where;

$$Y_o=\sqrt{\frac{2e_s\phi_j N_{sub}}{qN_{tub}(N_{sub}+N_{tub}}} \tag{66}$$

; and

$$\phi_j=\frac{KT}{q}\ln\left(\frac{N_{tub}N_{sub}}{N_i^2}\right) \tag{67}$$

where:

$N_{sub}$ = Substrate impurity concentration
$N_{tub}$ = Tub impurity concentration
$N_i$ = Intrinsic carrier concentration
$e_s$ = Permittivity of substrate material
$KT/q$ = 26 millivolts at room temperature

The depth $Y_p$ of the depletion region in the substrate **21** is expressed as:

$$Y_p=Y_n N_{tub}/N_{sub}. \tag{68}$$

Referring to Figure 17, at threshold, the channel region $Y_f$ is depleted when gate voltage $V_g=V_t$. At excess carrier threshold, $V_g>V_t$, the channel is charge neutral and the perpendicular electric field from the substrate-Tub junction remains zero across the channel region independent of the density of excess conduction carriers accumulated there as gate voltage increases above the excess carrier threshold $V_{tec}$. The expression that defines excess carrier threshold $V_{tec}$ is:

$$V_{tec} = \frac{KT}{q} \ln\left( \frac{N_{pol} N_{tub}}{N_i^2} \right) \qquad (69)$$

Where, $N_{pol}$ is the doping concentration in the polysilicon gate **28b** at the polysilicon gate - insulator interface.

Threshold voltage $V_t$ is defined as follows:

$$V_t = V_{tec} - V_{comp} \qquad (70)$$

where compensation voltage $V_{comp}$ is the sum of the surface potential loss $\phi_s$, the shaded triangle Figure 17, and a potential developed across the gate insulator $V_{ox}$:

$$\phi_s = \frac{qN_{ch}}{2e_s} Y_f^2 \qquad (71)$$

; and

$$V_{ox} = \frac{qN_{ch}}{e_i} Y_f T_{ox} \qquad (72)$$

Thus, the final expression for threshold voltage can be written as:

$$V_t = \frac{KT}{q} \ln\left( \frac{N_{pol} N_{tub}}{N_i^2} \right) - qN_{ch} Y_f \left( \frac{Y_f}{2e_s} + \frac{T_{ox}}{e_i} \right) \qquad (73)$$

Equation (73) shows that threshold voltage can be modified from the basic term $V_{tec}$, Equation (69), by the depth $Y_f$ of the channel and channel impurity concentration $N_{ch}$. Insulator thickness has a secondary effect. Note the basic threshold voltage term $V_{tec}$ can be controlled by the doping concentration $N_{POL}$ in the polycrystalline silicon gate. Thus:

$$\Delta V_t = qN_{ch} Y_f \left( \frac{Y_f}{2e_s} + \frac{T_{ox}}{e_i} \right) \qquad (73a)$$

Where:

$\Delta V_t$ = the change in threshold voltage from twice the Fermi potential

It is appropriate to confine the channel depth $Y_f$ to a fixed value, approximately 600Å, independent of the implanted impurity concentration $N_{ch}$. It has been shown in the previous section that channel depth $Y_f$ is also one factor that determines drain saturation current. Fixing the value of channel depth $Y_f$ allows independent control of saturation current and threshold voltage. In order to achieve very high drive currents, the doping concentration $N_{ch}$ in the Fermi-channel $Y_f$, should be less than 5E16/cm$^3$. Otherwise carrier mobility rapidly decreases below the value required to support high drive current at 5V.

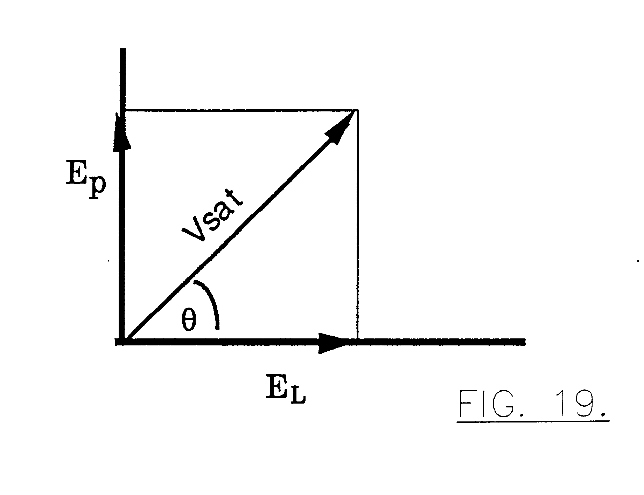

Figure 18 is a plot of Equation (73) for $T_{ox}$ = 100Å, $N_{pol}$ = 2E19, and $N_{tub}$=2E16. The abscissa is channel concentration. The ordinate is threshold voltage. The three running parameters are channel depth, 600Å, 700Å, and 800Å. From Equation (73), threshold voltage is independent of substrate concentration $N_{sub}$. However, the depth of the Tub does depend on substrate concentration as per Equation (66), and threshold, twice the Fermi potential of the substrate, is set when the product $N_{Tub} \cdot N_{Poly}$ equal $N_{sub}^2$.

Thus, as illustrated in Figure 18, threshold voltage can be lowered by increasing the doping concentration in the channel, or conversely, increased by lowering channel concentration. Lowering threshold voltage may be desirable if operation is contemplated at 3.3 Volts or less. Sub-threshold threshold differs from threshold voltage by twice the Fermi potential of the channel, 2 KT/q [ln($N_{ch}/N_i$)]. This is the voltage difference between points A and B of Figure 11.

Leakage current is very sensitive to threshold voltage. A typical sub-threshold slope is 90mV per decade. For minimum sub-threshold leakage current, sub-threshold threshold should occur when gate voltage is zero or slightly positive. Sub micron channel length FET devices suffer in the sub-threshold region (zero gate volt region). The voltage difference between sub-threshold threshold and threshold conditions is typically 790mV. If a short channel device requires a 400mV threshold voltage, for example, the zero gate voltage leakage will be about 5 decades above 1E-13 A/micron or about 1E-8 A/micron in value. This leakage current is too high to be acceptable for VLSI technology.

Accordingly, the threshold voltage of a Fermi-FET may be lowered, while still maintaining zero static electric field perpendicular to the substrate surface at the depth of the Fermi channel, by choosing a channel and tub depth which provides zero perpendicular static electric field and by providing a channel doping concentration which is greater than that specified in Equation (73). It will be understood by those having skill in the art that channel doping concentration cannot be increased indefinitely. In particular, at channel concentrations above about $5 \times 10^{16}$, carrier mobility begins to drop and the saturation current of the device begins to drop. However, channel doping concentration may be increased from that doping concentration which produces a threshold voltage which is twice the Fermi potential up to about a concentration of $5 \times 10^{16}$, to lower the threshold voltage of the Fermi-FET device when this is deemed necessary or desirable.

It will also be understood by those having skill in the art that for a given Fermi channel depth, such as 600Å, the threshold voltage and the saturation current may be adjusted independently. Saturation current may be adjusted by increasing the doping concentration of the source and drain diffusions adjacent the channel as described in the previous section. Threshold voltage may be adjusted independently by increasing the doping concentration of the channel. Thus, independent control is provided.

### Comparison of MOSFET and Fermi-FET

In any prior art FET device, with the exception of the Fermi-FET technology, there is a perpendicular field in addition to the lateral field that traverses the channel. The lateral electric field $E_1$ is due to drain to source potential directed along the channel between the source and drain. The perpendicular field in MOS devices originates from immobile charge developed in the depleted substrate region below the gate insulator when gate voltage reaches the threshold value. This perpendicular electric field crosses the inverted minority carrier MOS channel region and is a consequence of creating the inversion layer.

The Fermi-FET technology transports majority carriers in a Fermi-channel whose doping type is the same as the Fermi-Tub and the source and drain regions. Fermi-FET design precludes any perpendicular electric field from crossing the channel during excess majority carrier flow between the source and drain, other than that produced by the majority carriers themselves.

This section describes a closed form expression for FET drain saturation current that includes the influence of both lateral and intrinsic perpendicular electric fields. It will be demonstrated that large values of drain saturation current, greater than 7A/cm for N-channel devices and 4A/cm for P-channel devices, while maintaining low leakage current of about 1E-13 A/micron or less, can only be achieved by Fermi-FET designs that eliminate the perpendicular electric field component. A Fermi-FET conducts by accumulation and is shut off by inversion. A MOSFET conducts by inversion and is shut off by accumulation. The difference in potential between inversion and accumulation is twice the Fermi potential of the channel region in both cases.

It has been shown in Equation (41) that saturation current of any FET device can be described by the following fundamental equation:

$$I_{sat} = C_g^* (V_g - V_t) V_L ZCOS\theta \tag{74}$$

Where;

$C_g^* =$ Gate capacitance/cm$^2$ due to mobile charge
$V_g =$ Gate voltage
$V_t =$ Threshold voltage
$V_L =$ Lateral Velocity

$Z =$      Channel width

$\theta =$      Angle between the vector field and lateral direction of carrier flow.

Equation (74) does not explicitly reveal the effects of channel length $L_o$. Equation (74) was derived with the benefit of a first principle notion that charge is the product of capacitance and Voltage i.e. Q=CV, and that current is dQ/dt.

There are three fundamental parameters in Equation (74), other than gate voltage $V_g$ and threshold voltage $V_t$, that determine the magnitude of current flow. These parameters are gate capacitance $C_g^*$, lateral velocity $V_L$ and angle $\theta$. The lateral velocity term accounts for the roles of carrier mobility $U_x$, channel length $L_o$, saturation velocity $V_{sat}$ and gate voltage $V_g$ in determining the transconductance character of drain saturation current. The perpendicular electric field regulates angle $\theta$. The gate capacitance term $C_g^*$ applies only to mobile charge and accounts for the effects of insulator thickness and carrier flow depth that control the maximum amount of charge that can flow in the channel per unit gate voltage.

In MOSFETs, there is a substantial immobile charge below the gate when gate voltage reaches threshold. This charge resides in the depleted substrate region below the gate and is necessary to create the minority carrier inversion layer. There is a gate capacitance $C_{go}^*=Q_{im}/V_t$. associated with this immobile charge $Q_{im}$. There is also a gate capacitance factor $C_{gmax}^*$ that accounts for mobile charge flowing in the channel:

$$C_{gmax}^* = \frac{1}{\dfrac{T_{ox}}{e_i}+\dfrac{\delta}{2e_s}} = \frac{2e_s e_i}{2e_s T_{ox}+\delta e_i} \tag{75}$$

where;

     $T_{ox}$ = Depth of the gate insulator

     $\delta$ = Mobile carrier flow depth

     $e_i$ = Permittivity of the gate insulator

     $e_s$ = Permittivity of the semiconductor

For a given gate voltage above threshold, the total charge supported by the MOS gate is:

$$Q=[C_{go}^* \ V_t+(C_{gmax}^*) \ (V_g-V_t)]A \tag{76}$$

Where $C_{go}^* \approx e_i/(2Tox)$, and

Mobile charge is the second term of Equation (76).

Total gate capacitance for the Fermi-FET is only $C_{gmax}^*$ when gate voltage is above threshold. Only mobile charge is in the channel region. The rate of change of gate capacitance for the MOS device is positive for gate voltage rising from ground to threshold voltage while negative for the Fermi-FET. This property of the Fermi-FET provides for excellent noise rejection in high speed digital systems.

A closed form expression for lateral mobility that includes the influence of the perpendicular electric field $E_p$ will now be derived. The expression is based upon the realization that saturation velocity is a vector quantity. This fundamental realization suggests that drift velocity can only reach the thermal saturation value in the vector field direction. Since there cannot be a net perpendicular component of velocity in the FET channel, other than hot electrons, the effects of the perpendicular field produce a dampening effect on the lateral component of velocity. The damping factor is $Cos\theta$ where $\theta$ is the angle between the vector field direction and the channel flow direction. Lateral velocity, that gives rise to drain current in FET devices, is thus $V_1 Cos\theta$ where $\theta$ is the angle between the vector field and the lateral field component. This is illustrated by Figure 19.

Lateral mobile dependence on lateral field effects is known. Equation (77a) defines lateral mobility of excess electrons and Equation (77b) defines lateral mobility for holes.

$$\mu_{ln}=\frac{\mu_{no}}{\sqrt{1+\left(\dfrac{E_l}{E_c}\right)^2}} \tag{77a}$$

$$\mu_{lp} = \frac{\mu_{po}}{1+\dfrac{E_l}{E_c}} \tag{77b}$$

Lateral velocity is the product of lateral field $E_l$ and lateral mobility $\mu_l$. $E_l$ is the lateral drain field, at the source end of the channel in an excess carrier environment, due to pinch-off voltage, and $E_c$ is the critical lateral field where for example, hole mobility is half its low field value. Thus,

$$E_c = \frac{V_{sat}}{\mu_o} \tag{78}$$

Where

$\mu_o$ is the low field mobility of the doped semiconductor; and
$V_{sat}$ is thermal saturation velocity at temperature T.

Equation (78) is true in the vector direction as well as the lateral direction.

Equations (77a) and (77b) must be modified to reflect true lateral mobility in the channel by including the effects of the perpendicular field crossing the channel. The lateral component of mobility and velocity is simply the value in the vector direction multiplied by $\cos\theta$. Using the following definitions:

$$Cos\theta = \frac{1}{\sqrt{1+Tan^2\theta}} \tag{79}$$

and

$$Tan\theta = E_p/E_l, \tag{80}$$

$Cos\theta$ has the following solution in terms of the perpendicular and horizontal electric field components in the channel region:

$$Cos(\theta) = \frac{1}{\sqrt{1+\left(\dfrac{E_p}{E_H}\right)^2}} \tag{81}$$

Using Equation (78) we can modify Equations (77a) and (77b) to reflect true lateral mobility in the channel:

$$\mu_{Ln} = \frac{\mu_{no}}{\sqrt{1+\left(\dfrac{E_p}{E_H}\right)^2}\sqrt{1+\left(\dfrac{E_l}{E_c}\right)^2}} \tag{82}$$

$$\mu_{Lp} = \frac{\mu_{po}}{\left(1+\dfrac{E_l}{E_c}\right)\sqrt{1+\left(\dfrac{E_p}{E_H}\right)^2}} \tag{83}$$

Since lateral velocity is the product of lateral field and lateral mobility, general expressions for lateral velocity for both holes and electrons may be written as follows:

$$V_{Ln} = \frac{\mu_{no}E_l}{\sqrt{\left(1+\frac{E_l}{E_c}\right)^2}\sqrt{1+\left(\frac{E_p}{E_H}\right)^2}} \qquad (84a)$$

$$V_{LP} = \frac{\mu_{po}E_l}{\left(1+\frac{E_l}{E_c}\right)\sqrt{1+\left(\frac{E_p}{E_H}\right)^2}} \qquad (84b)$$

In general, lateral velocity for holes and electrons can be expressed as:

$$V_{Ln} = \frac{\mu_{no}E_l Cos\theta}{\sqrt{1+\left(\frac{E_l}{E_c}\right)^2}} \qquad (84c)$$

$$V_{Lp} = \frac{\mu_{po}E_l Cos\theta}{1+\left(\frac{E_l}{E_c}\right)} \qquad (84d)$$

Where:

$$E_l = \frac{V_g - V_t}{2L_o}$$

is the lateral field due to drain pinch-off;

$$E_p = \sqrt{\frac{4\phi_f q N_{sub}}{e_s}}$$

is the perpendicular field required to support MOS inversion;

$$E_p = \frac{V_t C_i^*}{e_s} \text{ for } N_{sub} = \left(\frac{V_t e_i}{T_{ox}}\right)^2 \frac{1}{4\phi_f e_s q}$$

$$E_{cp} = \frac{V_{satp}}{\mu_{po}};$$

$$E_{cn} = \frac{V_{satn}}{\mu_{no}};$$

$E_h = V_{dd}/L_o$ is the lateral field due to drain voltage;
$N_{sub}$ = Substrate concentration, $N_i$ for Fermi FET;

$$\phi_f = \frac{KT}{q} \ln\left(\frac{N_{sub}}{N_i}\right)$$

Fermi Potential;

$$\theta = Tan^{-1}\left(\frac{E_p}{E_H}\right);$$

$L_o$ = Channel length

$V_{dd}$ = Supply voltage

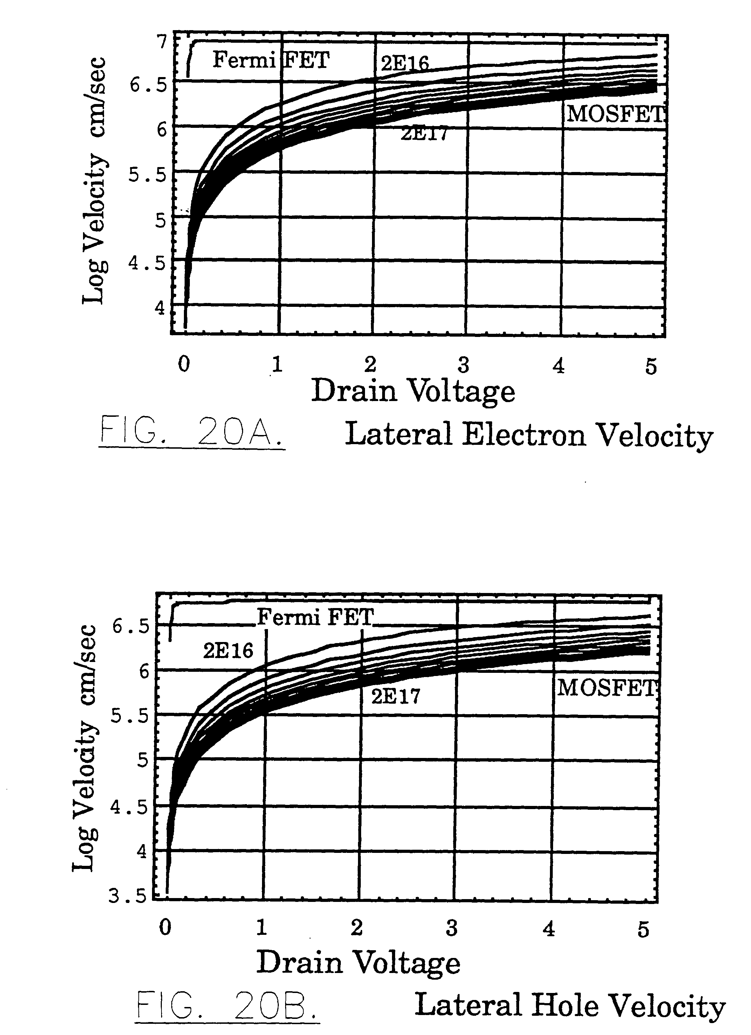

Using Equations (84a) and (84b), Figures 20A and 20B are plots of maximum lateral velocity for electrons and holes, respectively. Velocity in both cases is plotted as a function of drain voltage, (electric field = $V_d/L_o$), and substrate concentration $N_{sub}$ in the range 2E16 to 2E17 for the MOS device and $N_{sub} = N_i$ for the Fermi FET. As shown, that lateral electron velocity reaches almost the saturation value for the Fermi-FET when gate voltage is 5 Volts. All excess carrier flow is below the surface and therefore the perpendicular field produced by the MOS device has nearly the maximum value $E_p$ across the carrier flow depth $\delta$.

In both Figures 20A and 20B, lateral majority carrier velocity in the Tub-FET reaches the maximum value and is the result of no perpendicular electric field across the channel. The other curves correspond to MOS devices with substrate doping concentrations in the range of 2E16 to 2E17 that produce perpendicular electric field at threshold and above. For the minority carrier MOS structure, the perpendicular field is needed to create the inversion mechanism. Angle $\theta$ is affected by drain voltage, not pinch-off voltage. It is for this reason that MOS device drain saturation current is less than half the Tub-FET value.

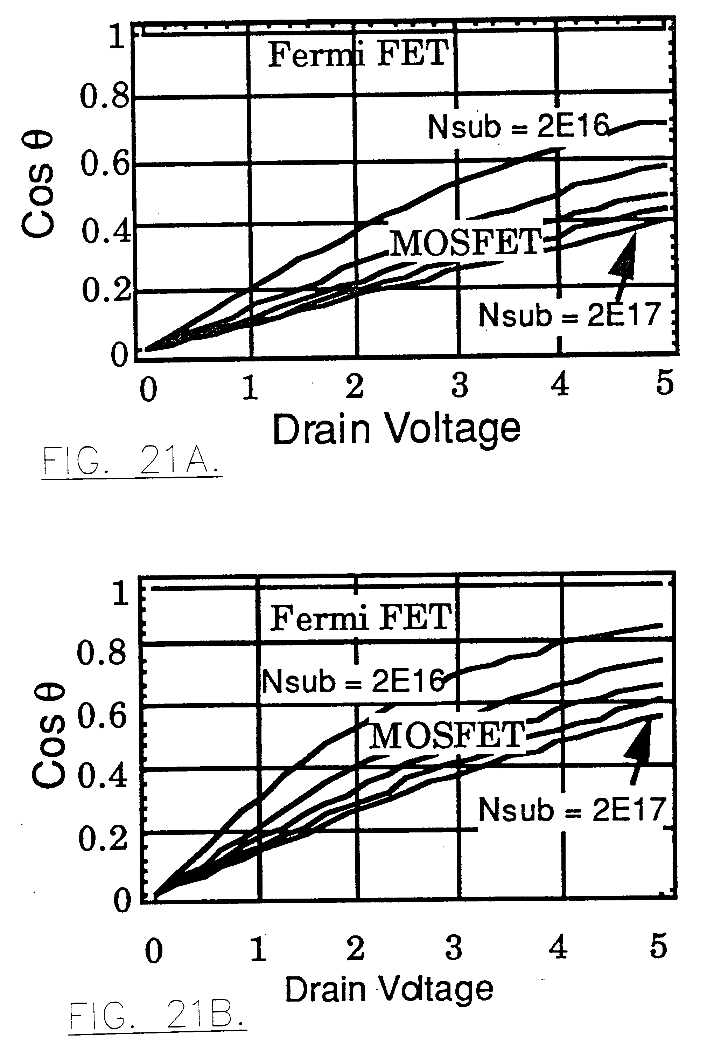

Figures 21A and 21B illustrate the factor $Cos\theta$ for the conditions given above. Channel length $L_o$ is 0.8 micron for Figure 21A and is 0.5 micron for Figure 21B. In both cases $Cos\theta$ has a maximum value of 1.0 only for the Fermi FET. Since drain saturation current $I_{sat}=C_g^*(V_g-V_t)V_lZ\ Cos\theta$, the Fermi FET realizes the maximum drive current capabilities.

For MOS devices, there is a relationship between perpendicular field $E_p$ and threshold voltage $V_t$. Both quantities involve substrate doping concentration. This relationship will now be derived so that drain saturation current for the MOS device can be compared with the Fermi-FET value.

The sum of potential taken along a contour from the center of the gate electrode to the substrate contact of an N-channel MOS device is given below:

$$V_g = V_{ox} + \phi_s - \frac{KT}{q} \ln\left(\frac{N_{sub}N_{poly}}{N_i^2}\right) - DFTL \qquad (85)$$

where:

$\phi_s$      is the rise in potential in the perpendicular direction across the substrate region below the gate;

$N_{sub}$ =      substrate concentration;

$N_{poly}$=      doping concentration in the polygate;

DFTL =      potential drop across the gate insulator at the source end of the channel due to the perpendicular component of the drain field;

$V_{ox}$ =      potential developed across the gate insulator due to a perpendicular electric field.

If a P-type polycrystalline silicon gate is used, the solution for a P-channel device is identical to Equation (85), except for polarity of terms. Using the divergence theorem and Poisson's equation, expressions for $V_{ox}$ and $\phi_s$ are given below:

$$V_{ox}=\frac{e_s}{e_i}E_sT_{ox}\pm\left(qT_{ox}\frac{N_{tc}}{C_i}\right) \tag{86a}$$

where $E_s$, is the perpendicular surface electric field in the substrate below the insulator.

$$E_s=\frac{qN_{ch}\delta}{e_s}+\frac{qN_{sub}Y_i}{e_s} \tag{86b}$$

and $N_{tc}$ is the volume density of trapped charge in the gate insulator. The positive sign in Equation (86a) applies to trapped electrons. Substitution gives:

$$V_{ox}=\frac{T_{ox}}{e_i}[qN_{ch}\delta+qN_{sub}Y_i\pm q_{Ntc}T_{ox}] \tag{87}$$

where

$C_i$ = insulator capacitance $e_i/T_{ox}$.
$\delta$ = carrier flow depth
$Y_i$ = Substrate depletion depth under the gate

The factors $qN_{ch}\delta$, $qN_{sub}Y_i$ and $qN_{tc}T_{ox}$ can be written in terms of charge density as follows.

$qN_{ch}\delta = Q_{ch}^*$, Channel charge density
$qN_{sub}Y_i=Q_{sub}^*$, Substrate depletion charge density
$qN_{tc}T_{ox}=Q_{tc}^*$, Density of trapped charge in gate insulator.

Substituting these expressions into Equation (87) and collecting terms yields the following expression for oxide potential drop $V_{ox}$:

$$V_{ox}=\frac{T_{ox}}{e_i}[Q_{ch}^*+Q_{sub}^*\pm Q_{tc}^*] \tag{88}$$

Surface potential $\phi_s$ has the following expression:

$$\phi_s=Q_{ch}^*\frac{\delta}{2e_s}+Q_{sub}^*\frac{Y_i}{2e_s}. \tag{89}$$

Based on the above definitions for $V_{ox}$ and $\phi$, the expression for gate voltage, Equation (85) can be expanded:

$$V_s=Q_{ch}^*\left[\frac{T_{ox}}{e_s}+\frac{\delta}{2e_s}\right]+Q_{sub}^*\left[\frac{T_{ox}}{e_i}+\frac{Y_i}{2e_s}\right]+Q_{tc}^*\frac{T_{ox}}{e_i}$$

$$-\frac{KT}{q}\ln\left(\frac{N_{sub}N_{poly}}{N_i^2}\right)-DFTL \tag{90}$$

The first voltage term in Equation (90) is due to mobile charge. The second and third terms are due to immobile charge in the substrate and trapped charge in the gate insulator respectively. The final terms are flat-band voltage and a voltage developed across the insulator due to a perpendicular component of the drain field. This effect is called DFTL, Drain Field Threshold Lowering.

From Equation (90) threshold voltage is:

$$V_t = Q^*_{sub}\left[\frac{T_{ox}}{e_i} + \frac{Y_i}{2e_s}\right] \pm Q^*_{tc}\frac{T_{ox}}{e_i} - \frac{KT}{q}\ln\left(\frac{N_{poly}N_{sub}}{N^*_i}\right) - DFTL \qquad (91)$$

When hard inversion occurs, the depth of the depletion region below the insulator is:

$$Y_i = \sqrt{\frac{4\phi_f e_s}{qN_{sub}}} \qquad (92)$$

Using Equation (92) and the definition for charge density, the following expression defines threshold voltage:

$$V_t = \frac{1}{C_i}\sqrt{4\phi_f e_s qN_{sub}} + 2\phi_f \pm \frac{qN_{tc}T^2_{ox}}{e_i}$$

$$-\frac{KT}{q}\ln\left(\frac{N_{sub}N_{poly}}{N^2_i}\right) - DFTL \qquad (93)$$

Since $2\phi_f = KT/q \ln(N_{sub}/N_i)^2$ and $DFTL = V_d e_s T_{ox}/2L_o e_i)$, substitution yields:

$$V_t = \frac{1}{C_i}\left[\sqrt{4\phi_f e_s qN_{sub}} \pm qN_{tc}\cdot T_{ox} - \frac{V_d e_s}{\alpha L_o}\right] - \frac{KT}{q}\ln\left(\frac{N_{poly}}{N_{sub}}\right) \qquad (94)$$

The trapped oxide charge term in Equation (94) will now be discussed. If trapped charge is negative, the positive sign applies. If trapped charge is positive, the negative sign applies. The contribution to threshold voltage due to trapped charge depends on the square of the gate insulator thickness, $T_{ox}^2$.

$$V_{tc} = \pm\frac{qN_{tc}T^2_{ox}}{e_i} \qquad (95)$$

The volume and area density of trapped charge that is required to alter threshold voltage by 100mv given Tox-100Å is

$$N_{tc} = \frac{0.1e_i}{qT^2_{ox}} = 2.15E17/cm^3 \text{ or } 3.6E11/cm^2$$

It is clear from Equation (95) that substantial trapped charge is required before threshold voltage can be significantly altered. From this analysis of threshold voltage and its dependence on trapped charge, it is possible to deduce the actual mechanism responsible for the so called "hot electron" problem with MOS devices. The perpendicular electric field at the insulator-substrate interface produced by the depleted substrate region in MOS devices greatly influences the probability of electron trapping in the gate insulator, thereby producing "hot electrons".

Returning to the determination of threshold voltage for a MOSFET, the expression for threshold voltage, Equation (94) is modified by extracting the log term and defining a net threshold voltage $V_{tnet}=V_t+KT/q\ln(N_{poly}/N_{sub})$. Thus, Equation (94) reduces to:

$$V_{tnet}=\frac{1}{C_i}\left[\sqrt{4\Phi_f e_s qN_{sub}}\pm qN_{tc}T_{ox}-\frac{V_d e_s}{\alpha L_o}\right]\qquad(96)$$

In order to find a fundamental expression for the perpendicular field Ep, Equation (96) is solved for substrate concentration $N_{sub}$. $E_p$ at the source end of the channel is given as follows in terms of substrate doping concentration $N_{sub}$:

$$E_p=\sqrt{\frac{4\phi_f qN_{sub}}{e_s}}-\frac{V_d}{\alpha L_o}\qquad(97)$$

Thus solving Equation (96) for $N_{sub}$:

$$N_{sub}=\frac{\left(V_t C_i\mp qN_{tc}T_{ox}+\frac{V_d e_s}{\alpha L_o}\right)^2}{4\phi_f e_s q}\qquad(98)$$

Substituting Equation (98) into Equation (97) we obtain the expression for the perpendicular electric field $E_p$ for the MOS device:

$$E_p=\frac{V_t C_i}{e_s}\mp\frac{qN_{tc}T_{ox}}{e_s}\approx\frac{V_t C_i}{e_s}\qquad(99)$$

It can be seen that the trapped charge expression appears in the perpendicular field equation and that the drain field threshold term does not. The negative sign corresponds to electron trapping. Thus, electron trapping lowers the perpendicular MOS electric field. In other words, trapped charge can influence drain saturation current by influencing $Cos\theta$. The perpendicular field in a typical MOS device required to achieve inversion is in the order of 1E5 Volts/cm, large enough to support charge trapping in the insulator. The trapped charge can easily modify this value by 10%.

Equation (99) must be used in determining MOS drain saturation current. The value for threshold voltage must not be less than twice the Fermi potential of the channel region, otherwise leakage current will increase one decade for each threshold increment of 80mV below $2\Phi_f$.

Equation (99) implies an appropriate value for substrate concentration. It can be shown that Equation (99) can be used without fear of violating MOS punchthrough conditions for all channel lengths down to 0.15 micron.

In summary, Equation (99) is very revealing. In its simplest form, the intensity of the MOS perpendicular field varies directly with threshold voltage and inversely with gate insulator thickness. MOS scaling theory would suggest holding the ratio $V_t/T_{ox}$ constant. However, this condition fails because sub-threshold leakage current will increase one decade for each increment of 80mV of threshold voltage below twice the Fermi potential. Saturation current is predicted by Equation (99) to increase by lowering threshold voltage $V_t$. However leakage current will dramatically increase.

Figure 22A is a cross-section of a typical N-channel MOS device with "lightly doped" diffusions, LDD. Light doping for MOS devices is in the order of 1E19 impurity ions/cm$^3$.

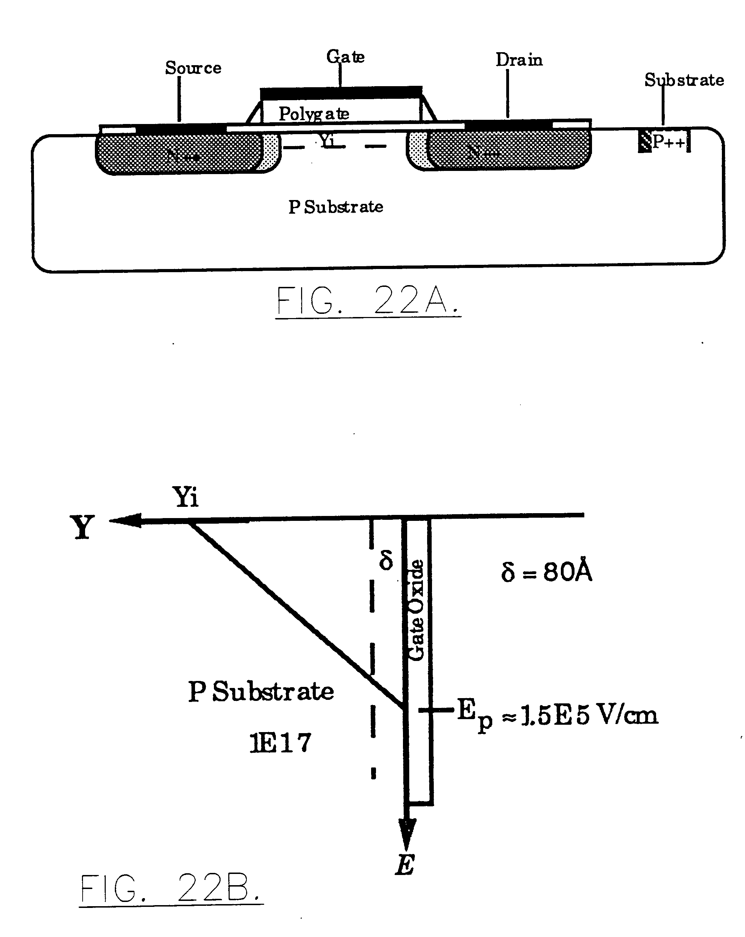

The perpendicular electric field diagram for this MOS device at threshold is shown in Figure 22B. $Y_i$ defines the depth of the depleted region below the MOS gate at the threshold. Also shown is a flow depth $\delta$ below the insulator-substrate junction, called the inversion depth. Excess injected carriers flowing within this depth experience a substantial perpendicular electric field component with the consequence of lowering lateral carrier velocity.

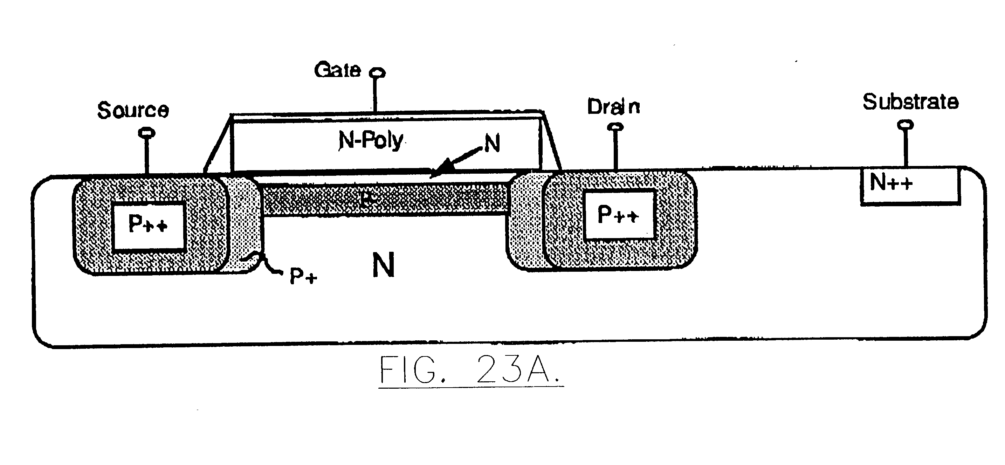

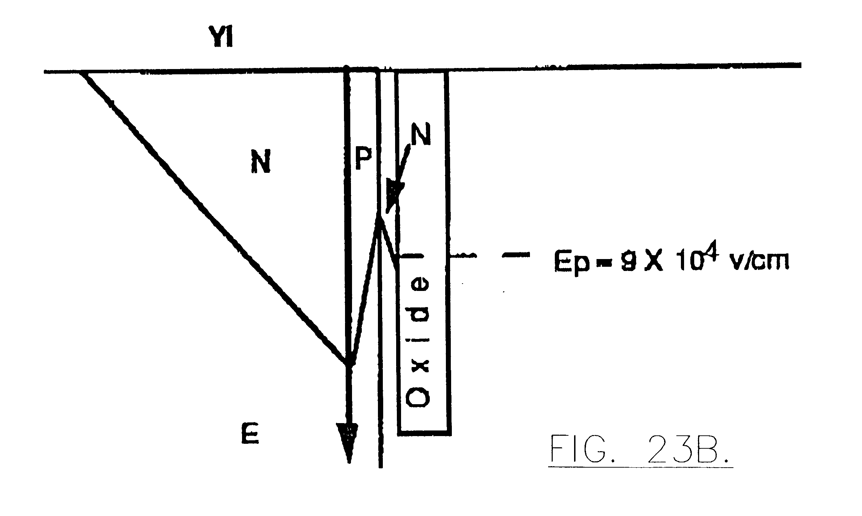

Figure 23A is a cross-section of a typical P type "buried channel" MOS device with lightly doped diffusions. The perpendicular electric field diagram shown in Figure 23B for a typical buried channel deice is drawn for threshold conditions. The depth of the depleted substrate region below the gate insulator corresponds to gate voltage at threshold. The buried channel modifies threshold voltage by lowering the perpendicular field crossing the insulator.

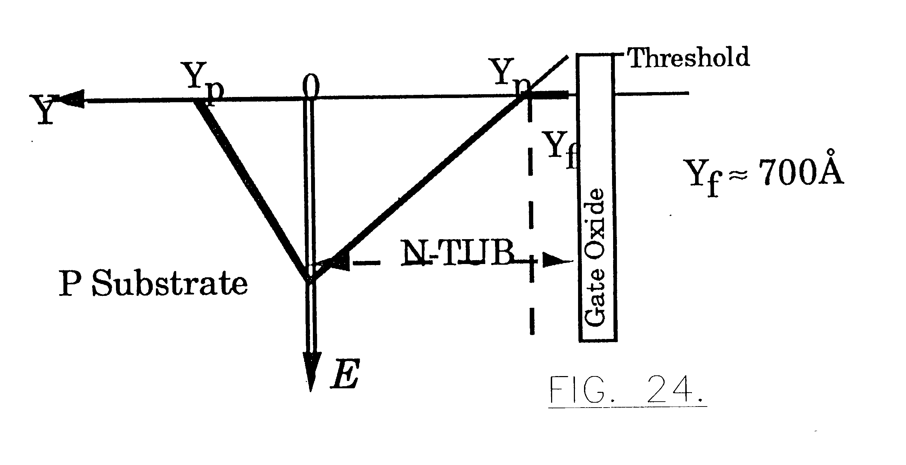

Figure 24 illustrates a perpendicular electric field diagram for the Fermi-FET of Figure 13. For all gate voltages above threshold no perpendicular electric field is allowed to traverse the entire depth of the Fermi channel, labeled $Y_f$ in Figure 24. Consequently, accumulated excess majority carriers flowing in this region have maximum lateral mobility.

Furthermore, excess carrier threshold voltage is independent of gate insulator thickness. This fact is due to the absence of any static perpendicular field near threshold. Therefore, Fermi-FET drive current capabilities can be chosen by oxide thickness and diffusion concentration without consideration or modification of other structural design considerations.

Fermi Tub-FET saturation current for an N-channel device is:

$$I_{satn} = \frac{C_g^* Z (V_g - V_t)^2 \mu_{no}}{2L_o \sqrt{1 + \left(\frac{(V_g - V_t)\mu_{no}}{2L_o V_{satn}}\right)^2}} \qquad (100a)$$

For a P-channel device:

$$I_{satP} = \frac{C_g^* (V_g - V_t)^2 \mu_{po}}{2L_o\left[1 + \frac{\mu_{po}}{V_{satp}} \frac{(V_g - V_t)}{2L_o}\right]} \qquad (100b)$$

For all of the above equations, the following definitions apply:

$$C_g^* = \frac{1}{\frac{T_{ox}}{e_i} + \frac{\delta}{2e_s}}$$

, maximum gate capacitance, F/cm$^2$

$\delta =$ Flow depth of excess injected carriers
$T_{ox} =$ Gate insulator thickness
$e_s =$ Permittivity of silicon
$e_i =$ Permittivity of the gate insulator
$V_{sat} =$ Thermal saturation velocity
$V_t =$ Threshold voltage
$L_o =$ Channel length
$Z =$ Channel width
$\mu_{xo} =$ Low field mobility of species x
$N_{sub} =$ Substrate doping concentration

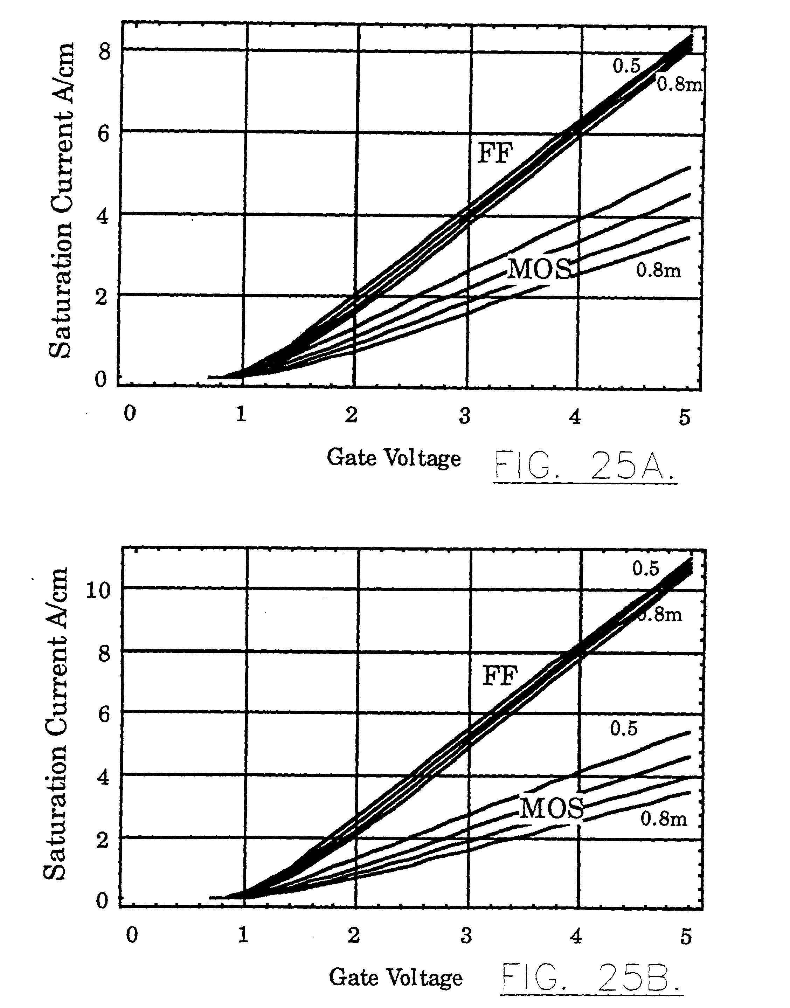

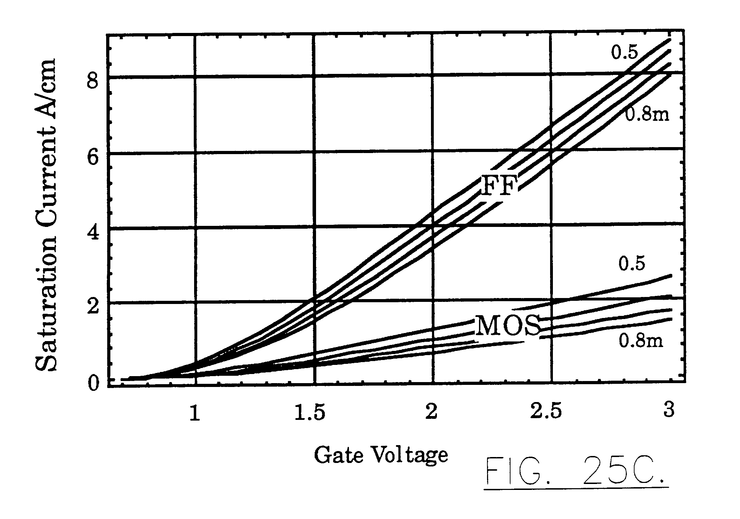

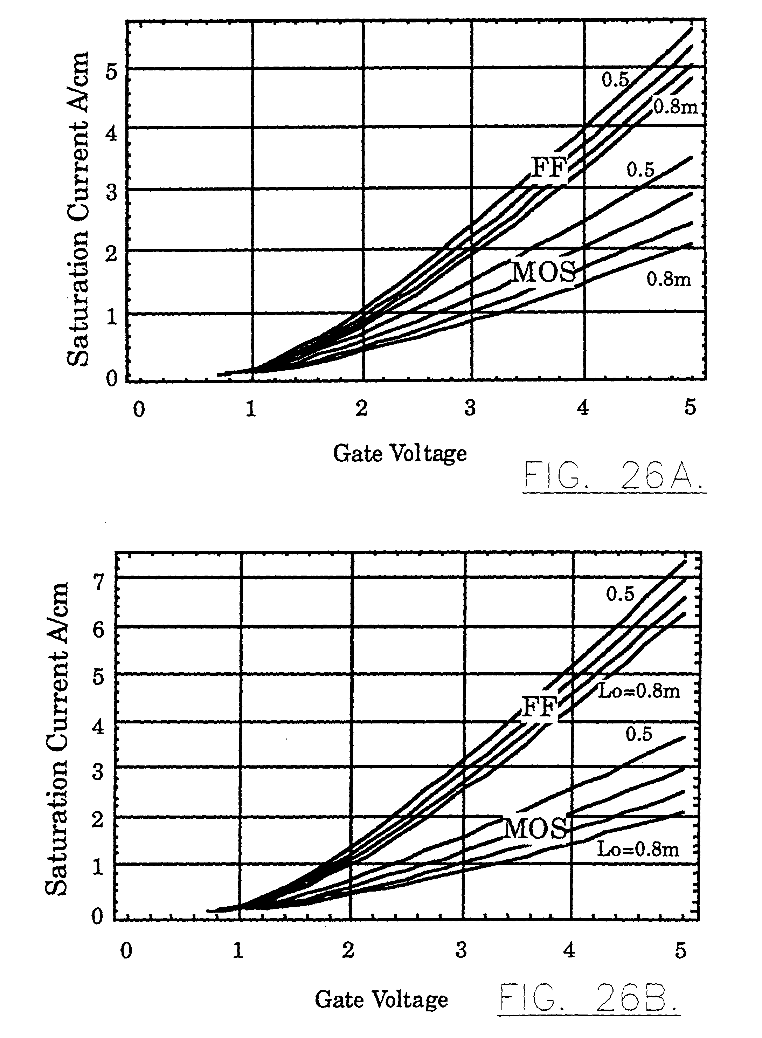

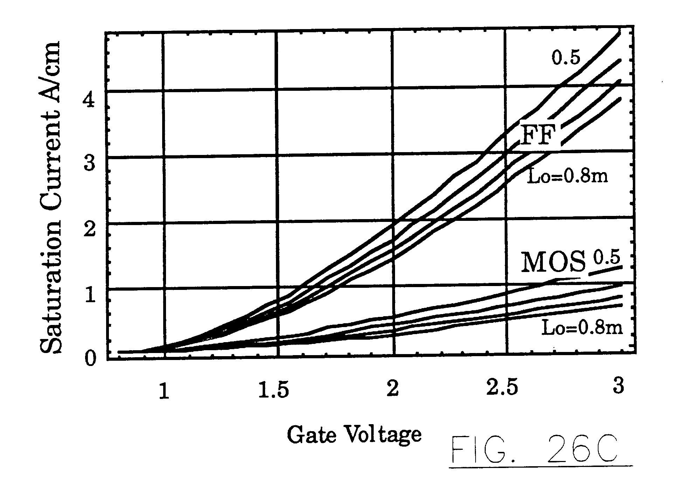

Figures 25A-25C compare N-MOS and N-Fermi-FET drain saturation current as a function of gate voltage $V_g$ and channel length $L_o$ as a running parameter. Figures 26A-26C are for P-channel technology. In all plots, threshold voltage is twice the Fermi potential or about 0.8V. This threshold voltage guarantees minimum leakage current i.e. less than 1E-13 Amps per micron when gate voltage is at ground potential. Gate insulator thickness is 140Å of SiO$_2$ in Figures 25A and 26A, 100Å in Figures 25B and 26B and 50Å in Figures 25C and 26C. In Figures 25C and 26C, drain supply voltage is 3 Volts rather than 5 Volts as is in the other figures. It is clear from the figures that only the Fermi FET can produce saturation currents in excess of 7 A/cm for N-channel devices and 4A/cm or greater for P-channel devices. These large currents are attributed to no perpendicular field crossing the flow channel; i.e. *Cos*θ approaches a unity value.

## Bounded Tub Fermi-FET

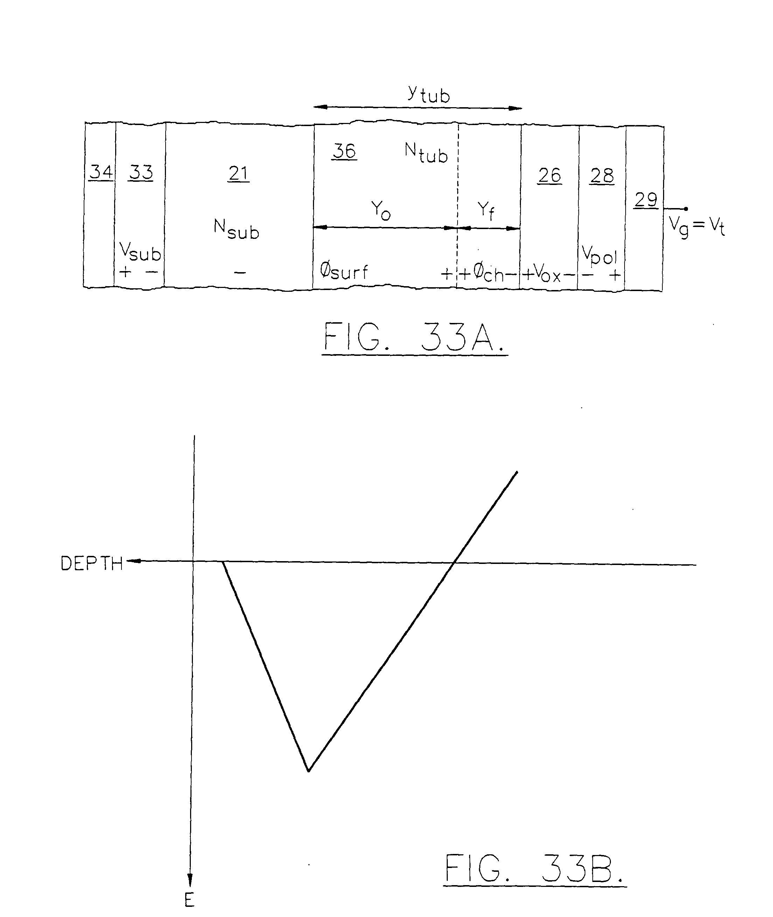

Referring now to Figures 33A and 33B, a cross-sectional view of a portion of the Fermi-FET **20** of Figure 1 and a corresponding electric field diagram are shown. Like numbers refer to like elements of Figure 1. It will be understood that Figure 33A does not illustrate source and drain regions **23** and **24** respectively. It will also be understood by those having skill in the art that the bounded Fermi-FET may not include source and drain injector regions **37, 38,** or sidewall spacer **41**.

The Fermi-Tub depth and doping concentration are bounded to achieve optimum high drive and low leakage current Fermi-FET performance. These boundary conditions are typically more critical for P-channel than N-channel devices, because hole mobility is lower than N-channel devices and therefore P-channel saturation current is not completely independent of mobility. However, the bounded-tub is preferably used in both N-channel and P-channel devices.

For a given Fermi-tub and effective substrate doping concentration, deep Fermi-tub design leads to high drain leakage current. For shallow Fermi-tub depth, leakage current is quite low, 1E-15 A/cm. However,saturation current is about 15% below nominal. If Fermi-tub depth is too shallow, the Fermi-Channel is eliminated, leading to a steady state vertical electric field in the tub region close to the insulator-tub interface. This vertical electric field component significantly lowers majority carrier mobility with the consequence of lowering channel saturation current. As heretofore described, one of the basic criterion for Fermi-FETs is that no steady state vertical electric field should exist at the insulator-tub interface for any gate voltage at or above threshold, other than the electric field component produced by excess carriers themselves.

Figure 33B illustrates an appropriate electric field diagram below the gate contact of the device of Figure 33A corresponding to proper N-channel Fermi-FET behavior when gate voltage is at threshold. Starting at the gate electrode, the contour potential along a line perpendicular to the Fermi-channel is given below from the gate to the substrate contact:

$$V_t = V_{pol} - V_{ox} - \phi_{ch} + \phi_{surf} - V_{sub} \tag{101}$$

Where;

$$V_{pol} = \frac{KT}{q} \ln\left(\frac{N^{\wedge} N_{pol}}{N_i^2}\right) \tag{102a}$$

$$V_{ox} = q\frac{N_{tub}}{e_i}T_{ox}Y_f \tag{102b}$$

$$\phi_{ch} = \frac{qN_{tub}}{2e_s}Y_f^2 \tag{102c}$$

$$\phi_{surf} = \frac{KT}{q}\ln\left(\frac{N_{sub}N_{tub}}{N_i^2}\right) \tag{102d}$$

$$V_{sub} = \frac{KT}{q} \ln\left(\frac{N^{\wedge} N_{sub}}{N_i^2}\right) \tag{102e}$$

Expanding Equation (101) in view of Equations (102a) through (102e) and simplifying produces:

$$V_t = \frac{KT}{q} \ln\left(\frac{N_{pol}}{N_{sub}}\right) + \frac{KT}{q} \ln\left(\frac{N_{tub}N_{sub}}{N_i^2}\right) - qN_{tub}Y_f\left[\frac{T_{ox}}{e_i} + \frac{Y_f}{2e_s}\right]$$

$$(103)$$

As already described:

$$C_g^* = \frac{1}{\dfrac{T_{ox}}{e_i} + \dfrac{Y_f}{2e_s}}$$

Therefore Equation (103) becomes

$$V_t = \frac{KT}{q} \ln\left(\frac{N_{pol}}{N_{sub}}\right) + \frac{KT}{q} \ln\left(\frac{N_{tub}N_{sub}}{N_i^2}\right) - \frac{qN_{tub}Y_f}{C_g^*} \quad (104)$$

The last term in Equation (104) is typically 50mV and will be ignored in subsequent analysis: Simplifying Equation (104) in view of the above, the following expression for threshold voltage is obtained:

$$V_t = \frac{KT}{q} \ln\left(\frac{N_{tub}N_{pol}}{N_i^2}\right) \quad (105)$$

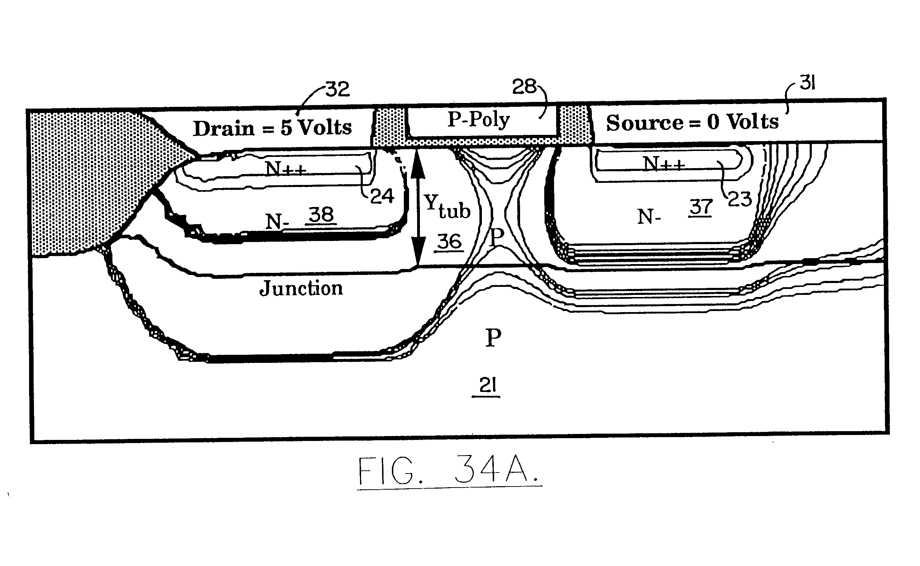

As gate voltage is lowered below threshold to ground potential (N-Channel device) an inversion condition is created in the Fermi-tub region between the drain and source diffusions. Simulations indicate that this inversion mechanism creates a unique injection barrier between source and drain that extends down from the gate interface to the tub-substrate junction. This injection barrier has a specific shape and is located close to the source. Figure 34A is a simulation of a completely closed inversion region acting as an injection barrier, with 5 Volts on the drain **32** and zero Volts on the gate **28** and source **31**, and Fermi-FETs with a channel length of 0.8μm. Minimum inversion concentration lines illustrated are 1E12 per cubic cm.

The equation that describes this closed inversion injection barrier condition is given below:

$$V_t = \frac{q}{e_s} \int_0^{Y_{tub}} \int_0^{Y} N_{inv}\, dy\, dy = \frac{qN_{tub}}{2e_s} Y_{Tub_{max}}^2 \quad (106)$$

Therefore:

$$Y_{tub_{max}} = \sqrt{\frac{2e_s V_t}{qN_{tub}}} \quad (107)$$

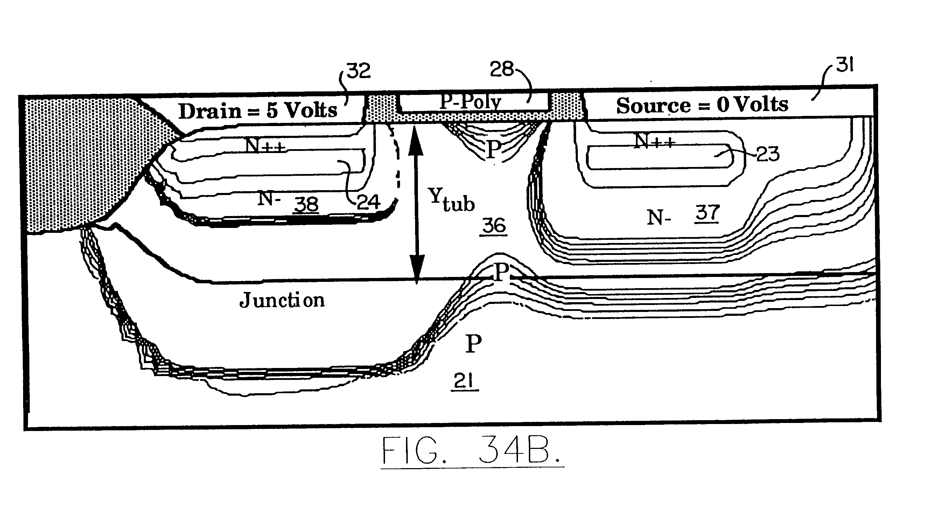

Equation (107) defines the maximum depth for the Fermi-tub. Deeper tub depths will not allow the inversion injection barrier to close at zero volts on the gate. See Figure 34B. Consequently, increased drain leakage current will be the result.

Minimum Fermi-tub depth is defined as $Y_o$, the tub depth that permits complete depletion of the tub by the substrate-tub junction at threshold conditions specified by Equation (105).

$$Y_{tub_{min}} = \sqrt{\frac{2e_s\phi_s N_{sub}}{qN_{tub}(N_{tub}+N_{sub})}} \qquad (108)$$

Fermi-tub depths that are shallower than the minimum value of Equation (108) will result in a steady state vertical electric field near the insulator-tub surface that will cause a substantial reduction in majority carrier mobility. The end result is to lower saturation current and increase pinch-off voltage. Leakage current however will be in the order of 1E-15 A/cm.

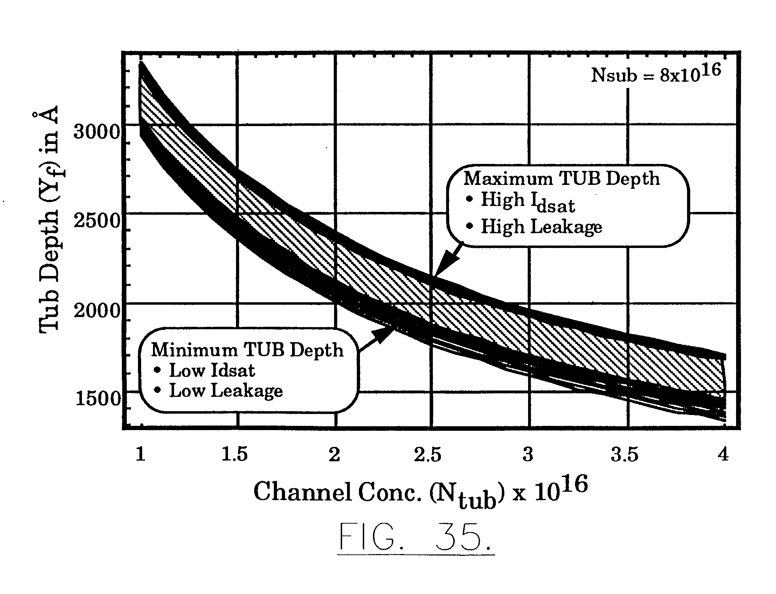

Figure 35 graphically illustrates the highperformance maximum and minimum values of Fermi-tub depth as a function of tub doping concentration, $N_{tub}$. Figure 35 is based on Equations (107) and (108). The running parameter for maximum tub depth is polysilicon gate **28** doping concentration $N_{pol}$ within the range of 5E18 to 2E19. The running parameter for minimum tub depth is substrate concentration $N_{sub}$ in the range of 5E16 to 1E17. The minimum tub depth depends on substrate doping concentration $N_{sub}$ while the maximum tub depth depends on polysilicon gate doping concentration.

High performance Fermi-tub depth design lies within the bounded range between the maximum and minimum values to achieve maximum saturation and minimum leakage current. It is also desired to operate 0.8µm devices at light tub doping concentration, for example about 1.5E16, in order to maximize carrier mobility. Tub concentration near 2.5E16 is better suited for Fermi-FETs with channel length's of 0.5µm.

An expression for Fermi-channel depth $Y_f$ within the bounded range is defined as $Y_{tub}-Y_o$:

$$Y_f = \sqrt{\frac{2e_s}{qN_{tub}}}\left[\sqrt{V_t} - \sqrt{\frac{\phi_s N_{sub}}{N_{tub}+N_{sub}}}\right] \qquad (109)$$

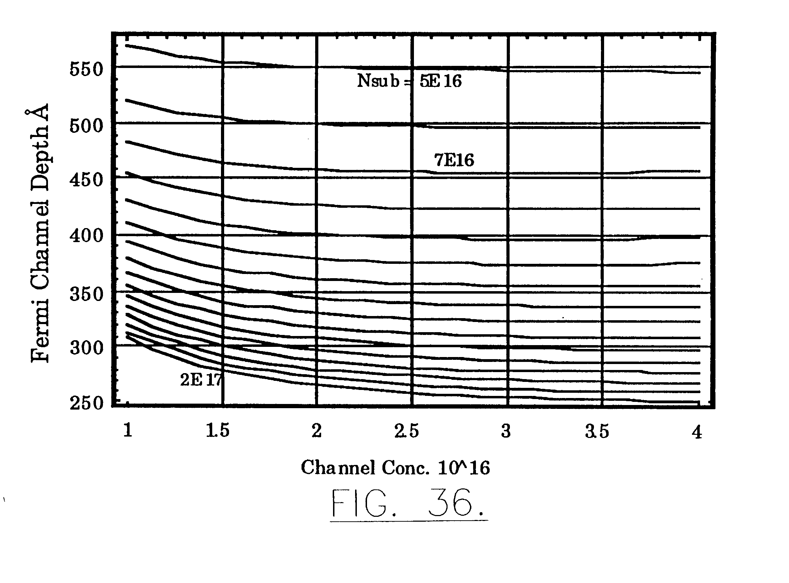

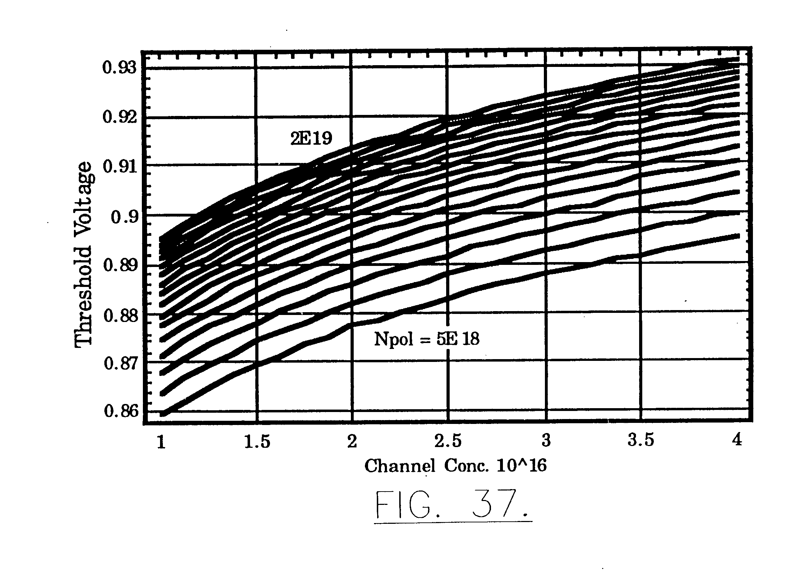

A plot of Fermi-channel depth $Y_f$ is illustrated in Figure 36. This plot shows Fermi channel depth $Y_f$ in Ångstroms as a function of Fermi-tub doping concentration $N_{tub}$ along the abscissa and substrate concentration $N_{sub}$ as the running parameter. Surface potential $\phi_s$ is given by Equation (102d). A Fermi-channel depth of about 350Å is desired. Figure 37 graphically illustrates threshold voltage as a function of tub doping concentration with poly concentration $N_{pol}$ in the range 5E18 to 2E19 as a running parameter. Very stable threshold voltage is achieved by the high performance Fermi-FET.

Although the preceding description is based on N-channel devices, the same equations apply to P-channel devices. All concentrations may be the same. However, doping types are changed from N to P and P to N.

**Claims**

1. A Fermi threshold field effect transistor which operates in the enhancement mode, comprising:-

   a semiconductor substrate (21) of first conductivity type;
   spaced apart source and drain regions (23,24) of a second conductivity type in said substrate at a surface (21a) thereof;
   a source injector region (37, 37a) of said second conductivity type adjacent said source region and facing said drain region;
   a gate insulating layer (26) on the substrate at said substrate surface (21a) between the spaced apart source and drain regions;
   source, drain and gate electrodes (31,32,28) contacting the source and drain regions and the gate insulating layer, respectively; and
   a channel (36) of said second conductivity type at said substrate surface between the source and drain regions for allowing carriers of said second conductivity type to flow from said source region to said drain region, said channel having a first predetermined depth ($Y_f$) from said substrate surface selected to produce zero static electric field perpendicular to said substrate surface at said first predetermined depth upon application of the threshold voltage of the field effect transistor to the gate electrode; **characterised by**
   a tub region (22) of second conductivity type in said substrate at said substrate surface (21a) and containing the source and drain regions (23,24) and the channel (36);

said tub region (22) being doped at a relatively low doping concentration, said source region (23) being doped at a relatively higher doping concentration and said source. injector region (37,37a) being doped at an intermediate doping concentration between that of said tub region and said source region; and

said tub region (22) extending a second predetermined depth ($Y_0$) from said channel and at least the sum of said first and second predetermined depths being such as to allow the carriers of said second conductivity type to flow front the source region (23) to the drain region (24) in the channel without creating an inversion layer in the tub region, upon application of voltage to the gate electrode (28) beyond the threshold voltage of the field effect transistor.

2. The field effect transistor of claim 1 including a gate sidewall spacer (41) on the substrate surface (21a) and extending from adjacent the source injector region (37,37a) to adjacent the gate electrode (28).

3. The field effect transistor of claim 2 wherein the gate sidewall spacer (41) comprises an insulator having permittivity which is greater than the permittivity of the gate insulating layer (26).

4. The field effect transistor of claim 3 wherein the gate insulating layer (26) comprises silicon dioxide and the gate sidewall spacer (41) comprises silicon nitride.

5. The field effect transistor of claim 2, 3 or 4, wherein the gate electrode (28) includes a polysilicon gate electrode layer of said first conductivity type on the gate insulating layer (26) opposite the substrate surface (21a), said polysilicon gate electrode layer including a polysilicon sidewall (28a), and wherein the gate sidewall spacer (41) extends from adjacent the source injector region (37,37a) to adjacent said polysilicon sidewall.

6. The field effect transistor of claim 2, 3, 4 or 5, wherein the source injector region (37,37a) extends to the substrate surface (21a), the gate insulating layer (26) extends onto the source injector region at said substrate surface, and the gate sidewall spacer (41) also extends onto the source injector region at said substrate surface.

7. The field effect transistor of any preceding claim including a bottom leakage controlling region (51) of said first conductivity-type disposed between the source and drain regions (23,24), and extending into the substrate from a depth which is less than the sum of said first and second predetermined depths to a depth which is greater.

8. The field effect transistor of claim 7 wherein the substrate (21) is doped said first conductivity type at a relatively low doping concentration and wherein the bottom leakage control region (51) is doped said first conductivity type at relatively high doping concentration.

9. The field effect transistor of any preceding claim including a substrate contact region (33) of said first conductivity type in the tub region (22) at the substrate surface (21a).

10. The field effect transistor of any preceding claim wherein the source region (23) extends into the substrate (21) a third predetermined depth from the substrate surface (21a) and wherein the source injector region (37,37a) extends into the substrate a fourth predetermined depth which is between said third predetermined depth and the sum of said first and second predetermined depths.

11. The field effect transistor of claim 10 wherein the source injector region (37,37a) extends into the substrate to a fourth predetermined depth equal to the sum of said first and second said predetermined depths.

12. The field effect transistor of any preceding claim 1 to 4 including a substrate contact (33) for electrically contacting the substrate (21) and wherein said gate electrode (28) includes a polysilicon layer (28b) of said first conductivity type and a conductive electrode (29) on said polysilicon layer opposite said gate insulating layer (26), at least the sum of said first and second predetermined depths being further selected to produce a voltage at said substrate surface (21a), adjacent said gate insulating layer (26), which is equal and opposite to the sum of the voltage between said substrate contact (33) and said substrate and between said polysilicon layer and said gate electrode.

13. The field effect transistor of any preceding claim wherein the gate insulating layer (26) is of predetermined thickness, and wherein at least the sum of said first and second predetermined depths is further selected to produce a threshold voltage for the transistor which is independent of said predetermined thickness, and current for the transistor which increases inversely to said predetermined thickness.

**EP 0 686 308 B1**

14. The field effect transistor of any preceding claim wherein the substrate (21) is doped at a first doping concentration $N_{sub}$, has permittivity $e_s$, and a Fermi-potential $\varnothing_f$ at temperature T degrees Kelvin,

the tub region (22) is doped at a second doping concentration $N_{tub}$ which is a factor $\alpha$ times $N_{sub}$; and wherein the sum of said first and second predetermined depths is greater than $(2e_s\varnothing_s N_{sub}/qN_{tub}(N_{tub}+N_{sub}))$ ½ and is less than $(2e_s V_t/qN_{tub})$½, where q is $1.6 \times 10^{-19}$ coulombs, $V_t$ is the threshold voltage of said field effect transistor, and $\varnothing_s$ is $2\varnothing_f+(KT/q)1n_\alpha$, and K is $1.38 \times 10^{-23}$ Joules/°Kelvin.

**Patentansprüche**

1. Fermi-Schwellenspannungs-Feldeffekttransistor, der im Anreicherungsbetrieb arbeitet, mit:

einem Halbleiter-Substrat (21) eines ersten Leitfähigkeitstyps;
mit Abstand voneinander angeordneten Source- und Drain-Bereichen (23, 24) eines zweiten Leitfähigkeitstyps in dem Substrat an einer (21a) seiner Oberflächen;
einem Source-Injektor-Bereich (37, 37a) des zweiten Leitfähigkeitstyps nahe dem Source-Bereich und dem Drain-Bereich zugewandt;
einer Gate-Isolierschicht (26) auf dem Substrat an der besagten Substratoberfläche (21a) zwischen den mit Abstand voneinander angeordneten Source- und Drain-Bereichen;
Source-, Drain- und Gate-Elektroden (31, 32, 28), die den Source-Bereich, den Drain-Bereich bzw. die Gate-Isolierschicht berühren; und
einem Kanal (36) des zweiten Leitfähigkeitstyps an der Substratoberfläche zwischen dem Source- und dem Drain-Bereich,
wobei der Kanal Ladungsträgern des zweiten Leitfähigkeitstyps ermöglicht, vom Source-Bereich zum Drain-Bereich zu fließen, und eine erste vorgegebene Tiefe ($Y_f$) von der Substratoberfläche aus aufweist, die ausgewählt ist, ein statisches elektrisches Null-Feld senkrecht zur Substratoberfläche an der ersten vorgegebenen Tiefe beim Anlegen der Schwellenspannung des Feldeffekttransistors an die Gate-Elektrode zu erzeugen;
**gekennzeichnet durch**
einen trogförmigen Bereich (22) des zweiten Leitfähigkeitstyps in dem Substrat an der besagten Substratoberfläche (21a), der den Source- und den Drain-Bereich (23, 24) und den Kanal (36) enthält;
wobei der trogförmige Bereich (22) mit einer relativ niedrigen Dotierungskonzentration dotiert ist, der Source-Bereich (23) mit einer relativ hohen Dotierungskonzentration dotiert ist und der Source-Injektor-Bereich (37, 37a) mit einer Zwischen-Dotierungskonzentration zwischen der des trogförmigen Bereichs und der des Source-Bereichs dotiert ist; und
wobei der trogförmige Bereich (22) sich um eine zweite vorgegebene Tiefe ($Y_0$) von dem Kanal aus erstreckt und wenigstens die Summe der ersten und der zweiten vorgegebenen Tiefe so ist, daß den Ladungsträgern des zweiten Leitfähigkeitstyps ermöglicht ist, von dem Source-Bereich (23) zum Drain-Bereich (24) in dem Kanal zu fließen, ohne eine Inversionsschicht in dem trogförmigen Bereich zu erzeugen, beim Anlegen einer Spannung an die Gate-Elektrode (28) über die Schwellenspannung des Feldeffekttransistors hinaus.

2. Feldeffekttransistor nach Anspruch 1,
mit einem Gate-Seitenwandabstandshalter (41) auf der Substratoberfläche (21a), der sich von der Nähe des Source-Injektor-Bereichs (37, 37a) aus bis in die Nähe der Gate-Elektrode (28) erstreckt.

3. Feldeffekttransistor nach Anspruch 2,
bei dem der Gate-Seitenwandabstandshalter (41) einen Isolator mit einer Permittivität aufweist, die größer ist als die Permittivität der Gate-Isolierschicht (26).

4. Feldeffekttransistor nach Anspruch 3,
bei dem die Gate-Isolierschicht (26) Siliziumdioxid und der Gate-Seitenwandabstandshalter (41) Siliziumnitrid aufweist.

5. Feldeffekttransistor nach Anspruch 2, 3 oder 4,
bei dem die Gate-Elektrode (28) eine Polysilizium-Gate-Elektrodenschicht des ersten Leitfähigkeitstyps auf der Gate-Isolierschicht (26), auf deren der Substratoberfläche (21a) entgegengesetzten Seite, aufweist, wobei die Polysilizium-Gate-Elektrodenschicht eine Polysilizium-Seitenwand (28a) aufweist, und bei dem der Gate-Seitenwandabstandshalter (41) sich von der Nähe des Source-Injektor-Bereiches (37, 37a) aus bis in die Nähe der Polysilizium-Seitenwand erstreckt.

6. Feldeffekttransistor nach Anspruch 2, 3, 4 oder 5,
bei dem der Source-Injektor-Bereich (37, 37a) sich zur Substratoberfläche (21a) erstreckt, die Gate-Isolierschicht (26) sich auf dem Source-Injektor-Bereich an der Substratoberfläche erstreckt und der Gate-Seitenwandabstandshalter (41) sich auch auf dem Source-Injektor-Bereich an der Substratoberfläche erstreckt.

7. Feldeffekttransistor nach einem der vorhergehenden Ansprüche, mit einem unteren Leck-Kontrollbereich (51) des ersten Leitfähigkeitstyps, wobei der untere Leck-Kontrollbereich zwischen dem Source- und dem Drain-Bereich (23, 24) angeordnet ist und sich in das Substrat hinein von einer Tiefe aus, die geringer ist als die Summe der ersten und der zweiten vorgegebenen Tiefe, bis zu einer Tiefe erstreckt, die größer ist.

8. Feldeffekttransistor nach Anspruch 7,
bei dem das Substrat (21) für den ersten Leitfähigkeitstyp mit einer relativ niedrigen Dotierungskonzentration dotiert ist und bei dem der untere Leck-Kontrollbereich (51) für den ersten Leitfähigkeitstyp mit einer relativ hohen Dotierungskonzentration dotiert ist.

9. Feldeffekttransistor nach einem der vorhergehenden Ansprüche, mit einem Substrat-Kontaktbereich (33) des ersten Leitfähigkeitstyps in dem trogförmigen Bereich (22) an der Substratoberfläche (21a).

10. Feldeffekttransistor nach einem der vorhergehenden Ansprüche, bei dem der Source-Bereich (23) sich in das Substrat (21) hinein bis zu einer dritten vorgegebenen Tiefe von der Substratoberfläche (21a) aus erstreckt, und bei dem der Source-Injektor-Bereich (37, 37a) sich in das Substrat hinein bis zu einer vierten vorgegebenen Tiefe erstreckt, die zwischen der dritten vorgegebenen Tiefe und der Summe der ersten und der zweiten vorgegebenen Tiefe liegt.

11. Feldeffekttransistor nach Anspruch 10, bei dem der Source-Injektor-Bereich (37, 37a) sich in das Substrat hinein bis zu einer vierten vorgegebenen Tiefe erstreckt, die gleich der Summe der ersten und der zweiten vorgegebenen Tiefe ist.

12. Feldeffekttransistor nach einem der vorhergehenden Ansprüche 1 bis 4, mit einem Substrat-Kontakt (33) zum elektrischen Kontaktieren des Substrats (21), und bei dem die Gate-Elektrode (28) eine Polysiliziumschicht (28b) des ersten Leitfähigkeitstyps und eine zweite leitende Elektrode (29) auf der Polysiliziumschicht auf deren der Gate-Isolierschicht (26) entgegengesetzten Seite aufweist, wobei wenigstens die Summe der ersten und der zweiten vorgegebenen Tiefe ferner ausgewählt ist, um eine Spannung an der Substratoberfläche (21a), nahe der Gate-Isolierschicht (26), zu erzeugen, die gleich und entgegengesetzt ist zu der Summe der Spannung zwischen dem Substrat-Kontakt (33) und dem Substrat sowie zwischen der Polysiliziumschicht und der Gate-Elektrode.

13. Feldeffekttransistor nach einem der vorhergehenden Ansprüche, bei dem die Gate-Isolierschicht (26) eine vorgegebene Dicke aufweist, und bei dem wenigstens die Summe der ersten und der zweiten vorgegebenen Tiefe ferner ausgewählt ist, um eine Schwellenspannung für den Transistor zu erzeugen, die unabhängig von der vorgegebenen Dicke ist, und Strom für den Transistor zu erzeugen, der invers zur vorgegebenen Dicke ansteigt.

14. Feldeffekttransistor nach einem der vorhergehenden Ansprüche, bei dem das Substrat (21) mit einer ersten Dotierungskonzentration $N_{sub}$ dotiert ist, eine Permittivität $e_s$ und ein Fermi-Potential $\varnothing_f$ bei einer Tempertur T in Grad Kelvin aufweist, der trogförmige Bereich (22) mit einer zweiten Dotierungskonzentration $N_{tub}$ dotiert ist, die einen Faktor $\alpha$ mal $N_{sub}$ ist; und
bei dem die Summe der ersten und der zweiten vorgegebenen Tiefe größer ist als $(2e_s\varnothing_sN_{sub}/qN_{tub}(N_{tub}+N_{sub}))^{1/2}$ und kleiner ist als $(2e_sV_t/qN_{tub})^{1/2}$, wobei q $1{,}6\times10^{-19}$ Coulomb ist, $V_t$ die Schwellenspannung des Feldeffekttran-sistors ist und $\varnothing_s$ $2\varnothing_f+(KT/q)1n\alpha$ ist und K $1{,}38\times10^{-23}$ Joules/°Kelvin ist.

**Revendications**

1. Transistor à effet de champ à seuil de Fermi, qui fonctionne en mode d'enrichissement, et comprenant :

   un substrat semi-conducteur (21) d'un premier type de conductivité ;
   une région de source et une région de drain (23, 24), à distance l'une de l'autre, d'un deuxième type de conductivité dans ledit substrat sur une surface (21a) de ce dernier ;

une région d'injection dans la source (37, 37a) dudit deuxième type de conductivité, immédiatement voisine de ladite région de source et en regard de ladite région de drain ;

une couche d'isolation de grille (26) se trouvant sur le substrat, sur ladite surface (21a) du substrat, entre la région de source et la région de drain à distance l'une de l'autre ;

des électrodes de source, de drain et de grille (31, 32, 28) en contact respectivement avec les régions de source et de drain et la couche d'isolation de grille ; et

un canal (36) dudit deuxième type de conductivité sur ladite surface de substrat entre la région de source et la région de drain pour permettre à des porteurs dudit deuxième type de conductivité de s'écouler de ladite région de source à ladite région de drain, ledit canal ayant une première profondeur prédéterminée ($Y_f$) à partir de ladite surface de substrat, sélectionnée pour produire un champ électrostatique nul perpendiculairement à ladite surface de substrat, au niveau de ladite première profondeur prédéterminée, après application de la tension de seuil du transistor à effet de champ à l'électrode de grille ; **caractérisé par**

une région de caisson d'isolement (22), du deuxième type de conductivité dans ledit substrat au niveau de ladite surface de substrat (21a) et contenant les régions de source et de drain (23, 24) et le canal (36) ;

ladite région de caisson (22) étant dopée à un niveau de dopage relativement faible, ladite région de source (23) étant dopée à un niveau de dopage relativement plus élevé, et ladite région d'injection dans la source (37, 37a) étant dopée à un niveau de dopage intermédiaire entre celui de ladite région de caisson et celui de ladite région de source,

ladite région de caisson (22) s'étendant sur une deuxième profondeur prédéterminée ($Y_0$) à partir dudit canal, et au moins la somme de ladite première et de ladite deuxième profondeurs prédéterminées étant telle qu'elle permet aux porteurs dudit deuxième type de conductivité de s'écouler de la région de source (23) à la région de drain (24) dans le canal sans créer de couche d'inversion dans la région de caisson, après application d'une tension à l'électrode de grille (28) au-delà de la tension de seuil du transistor à effet de champ.

2. Transistor à effet de champ selon la revendication 1, qui comprend un écarteur (41) de paroi latérale de grille sur la surface de substrat (21a) et s'étendant d'un point situé au voisinage immédiat de la région d'injection dans la source (37, 37a) à un point situé au voisinage immédiat de l'électrode de grille (28).

3. Transistor à effet de champ selon la revendication 3, dans lequel l'écarteur (41) de paroi latérale de grille comprend un isolateur ayant une permittivité qui est supérieure à la permittivité de la couche d'isolation de grille (26).

4. Transistor à effet de champ selon la revendication 4, dans lequel la couche d'isolation de grille (26) comprend du dioxyde de silicium et l'écarteur (41) de paroi latérale de grille comprend du nitrure de silicium.

5. Transistor à effet de champ selon la revendication 3, 4 ou 5, dans lequel l'électrode de grille (28) comprend une couche formant électrode de grille en polysilicium dudit premier type de conductivité sur la couche d'isolation de grille (26) opposée à la surface de substrat (21a), ladite couche formant électrode de grille en polysilicium comprenant une paroi latérale en polysilicium (28a), et où l'écarteur (41) de paroi latérale de grille s'étend d'un point situé au voisinage immédiat de la région d'injection dans la source (37, 37a) à un point situé au voisinage immédiat de ladite paroi latérale en polysilicium.

6. Transistor à effet de champ selon la revendication 3, 4, 5 ou 6, dans lequel la région d'injection dans la source (37, 37a) s'étend vers la surface de substrat (21a), la couche d'isolation de grille (26) s'étend sur la région d'injection dans la source sur ladite surface de substrat, et l'écarteur (41) de paroi latérale de grille s'étend lui aussi sur la région d'injection dans la source au niveau de la surface de substrat.

7. Transistor à effet de champ selon l'une quelconque des revendications précédentes, qui comprend une région (51) régulatrice de fuite de fond dudit premier type de conductivité, disposé entre les régions de source et de drain (23, 24) et s'étendant dans le substrat à partir d'une profondeur qui est inférieure à la somme de ladite première et de ladite deuxième profondeurs déterminées, jusqu'à une profondeur qui est plus grande.

8. Transistor à effet de champ selon la revendication 8, dans lequel le substrat (21) est dopé selon ledit premier type de conductivité à un niveau de dopage relativement faible, et où la région (51) régulatrice de fuite de fond est dopée selon ledit premier type de conductivité à un niveau de dopage relativement élevé.

9. Transistor à effet de champ selon l'une quelconque des revendications précédentes, qui comprend une région (33) de contact avec le substrat dudit premier type de conductivité dans la région de caisson (22) au niveau de la surface de substrat (21a).

**10.** Transistor à effet de champ selon l'une quelconque des revendications précédentes, dans lequel la région de source (23) s'étend dans le substrat (21) sur une troisième profondeur prédéterminée à partir de la surface de substrat (21a), et où la région d'injection dans la source (37, 37a) s'étend dans le substrat sur une quatrième profondeur prédéterminée qui est comprise entre ladite troisième profondeur prédéterminée et la somme desdites première et deuxième profondeurs prédéterminées.

**11.** Transistor à effet de champ selon la revendication 11, dans lequel la région d'injection dans la source (37, 37a) s'étend dans le substrat sur une quatrième profondeur prédéterminée, égale à la somme desdites première et deuxième profondeurs prédéterminées.

**12.** Transistor à effet de champ selon l'une quelconque des revendications 1 à 5, qui comprend un contact de substrat (33) pour assurer un contact électrique avec le substrat (21), et où ladite électrode de grille (28) comprend une couche de polysilicium (28b) dudit premier type de conductivité et une électrode conductrice (29) sur ladite couche de polysilicium opposée à ladite couche d'isolation de grille (26), au moins la somme desdites première et deuxième profondeurs prédéterminées étant en outre sélectionnée pour produire une tension au niveau de ladite surface de substrat (21a), immédiatement voisine de la couche d'isolation de grille (26), qui est égale et opposée à la somme de la tension entre ledit contact de substrat (33) et ledit substrat, et entre ladite couche de polysilicium et ladite électrode de grille.

**13.** Transistor à effet de champ selon l'une quelconque des revendications précédentes, dans lequel la couche d'isolation de grille (26) a une épaisseur prédéterminée, et où au moins la somme desdites première et deuxième profondeurs prédéterminées est en outre sélectionnée pour produire une tension de seuil pour le transistor, qui est indépendante de ladite épaisseur prédéterminée, et un courant pour le transistor, qui augmente inversement à ladite épaisseur prédéterminée.

**14.** Transistor à effet de champ selon l'une quelconque des revendications précédentes, dans lequel le substrat (21) est dopé selon un premier niveau de dopage $N_{sub}$, a une permittivité $e_s$ et un potentiel de Fermi $\phi_f$ à la température T degrés Kelvin,

la région de caisson (22) est dopée selon un deuxième niveau de dopage $N_{tub}$, qui est égal à $\alpha$ fois $N_{sub}$ ; et où la somme desdites première et deuxième profondeurs prédéterminées est supérieure à $(2e_s\phi_s N_{sub}/qN_{tub}(N_{tub}+N_{sub}))1/2$ et est inférieure à $(2e_s V_t/qN_{tub})1/2$, où q vaut $1,6.10^{-19}$ coulombs, $V_t$ est la tension de seuil dudit transistor à effet de champ, et $\phi_s$ est égal à $2\phi_s+(KT/q)\ln\alpha$, et K vaut $1,38.10^{-23}$ Joules/° Kelvin.

FIG. 1.

FIG. 2A.

FIG. 2B.

EP 0 686 308 B1

FIG. 2C.

REGION

EP 0 686 308 B1

FIG. 3.

FIG. 4A.

FIG. 4B.

FIG. 4C.

FIG. 5A.

FIG. 5B.

FIG. 5C.

FIG. 6A.

FIG. 6B.

FIG. 7.

FIG. 8A.

FIG. 8B.

G

S

29

28    P

28a

31        41        26

41

23    N++        39        21a        36

37a

37        N+

N        22

P        21

FIG. 8C.

FIG. 9A.

FIG. 9B.

FIG. 10B.

FIG. 10A.

FIG. 10D.

FIG. 10C.

FIG. 11.

FIG. 12A.

FIG. 12B.

FIG. 13.

FIG. 14.

FIG. 15.

FIG. 16A.

FIG. 16B.

FIG. 17.

FIG. 18.

FIG. 19.

FIG. 20A.    Lateral Electron Velocity

FIG. 20B.    Lateral Hole Velocity

FIG. 21A.

FIG. 21B.

FIG. 22A.

FIG. 22B.

FIG. 23A.

EP 0 686 308 B1

YI

N

P

N

Oxide

E

$Ep = 9 \times 10^4$ v/cm

FIG. 23B.

EP 0 686 308 B1

FIG. 24.

$Y_f \approx 700\text{Å}$

EP 0 686 308 B1

FIG. 25A.

FIG. 25B.

FIG. 25C.

FIG. 26A.

FIG. 26B.

FIG. 26C

FIG. 27.

FIG. 28.

FIG. 29.

FIG. 30.

FIG. 31.

**Gradient Distance S**

FIG. 32.

FIG. 33A.

FIG. 33B.

FIG. 34A.

EP 0 686 308 B1

FIG. 34B.

EP 0 686 308 B1

FIG. 35.

EP 0 686 308 B1

Channel Conc. 10^16

FIG. 36.

EP 0 686 308 B1

FIG. 37.